# EUROPEAN PATENT APPLICATION

(11) **EP 3 135 726 A1**
(43) Date of publication of application: **01.03.2017**
(21) Application number: 15783297.3
(22) Date of filing: 15.04.2015
(51) Int. Cl.: C08L 65/00, C08G 61/12, C08K 5/45, C08K 5/54, H01L 29/786, H01L 51/05, H01L 51/30

(54) **COMPOSITION AND POLYMER COMPOUND, AND ORGANIC SEMICONDUCTOR ELEMENT CONTAINING SAID COMPOSITION AND SAID POLYMER COMPOUND**

(30) Priority: 21.04.2014 JP 2014087097; 20.08.2014 JP 2014167234
(71) Applicant: Sumitomo Chemical Company, Limited, Tokyo 104-8260 (JP)
(72) Inventor: KANESAKA, Sho, Tsukuba-shi Ibaraki 300-3294 (JP); YOSHIDA, Hidekazu, Osaka-shi Osaka 554-8558 (JP); KASHIKI, Tomoya, Tsukuba-shi Ibaraki 300-3294 (JP); OKACHI, Takayuki, Tsukuba-shi Ibaraki 300-3294 (JP)
(74) Representative: Newman, Alastair James Morley
(86) International application number: PCT/JP2015/061554
(87) International publication number: WO 2015/163206

(57) **Abstract**

A composition comprising a polymer compound containing a structural unit represented by the formula (1) and a compound represented by the formula (2): 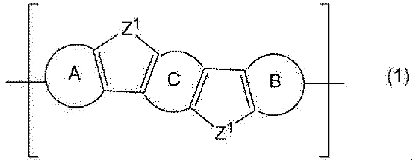 [wherein
Ring A and Ring B each independently represent a heterocyclic ring, and this heterocyclic ring may have a substituent.
Ring C represents an aromatic hydrocarbon ring or a heterocyclic ring, and these rings may have a substituent.
Z¹ represents a group represented by the formula (Z-1), a group represented by the formula (Z-2), a group represented by the formula (Z-3), a group represented by the formula (Z-4) or a group represented by the formula (Z-5). A plurality of Z¹ may be mutually the same or different.] 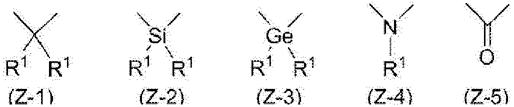 [wherein R¹ represents an alkyl group, a cycloalkyl group, an alkoxy group, a cycloalkoxy group, an alkylthio group, a cycloalkylthio group, an aryl group or a monovalent heterocyclic ring group, and these groups may have a substituent. When there are a plurality of R¹, they may be the same or different.] 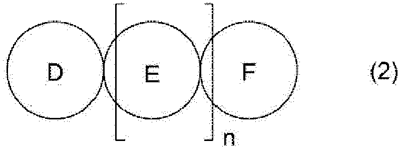 [wherein
n represents an integer of 1 or more.
Ring D and Ring F each independently represent a benzene ring, a 5-membered heterocyclic ring or a 6-membered heterocyclic ring, and these rings may have a substituent.
Ring E represents a benzene ring, a cyclopentadiene ring, a 5-membered heterocyclic ring or a 6-membered heterocyclic ring, and these rings may have a substituent. When there are a plurality of Rings E, they may be the same or different.
Here, Ring D and Ring E are mutually condensed to form a condensed ring, Ring E and Ring F are mutually condensed to form a condensed ring, and when there are a plurality of Rings E, adjacent Rings E are mutually condensed to form a condensed ring.].

## Description

### Technical Field

The present invention relates to a composition and a polymer compound, and an organic semiconductor device comprising the composition or the polymer compound.

### Background Art

Organic film transistors using an organic semiconductor material are under active study and development, since the organic film transistors can be produced at lower temperature and additionally, reduction in weight of the device and decrease in production cost thereof are expected, as compared with conventional transistors using an inorganic semiconductor material.

Electric field effect mobility, a measure indicating the performance of an organic film transistor, depends largely on the electric field effect mobility of an organic semiconductor material contained in an active layer. Therefore, various organic semiconductor materials are investigated as the material used in an active layer of an organic transistor.

For example, Non-patent document 1 suggests a polymer compound composed of a structural unit (A) represented by the following formula and a structural unit (B) represented by the following formula, as the organic semiconductor material used in an organic film transistor.

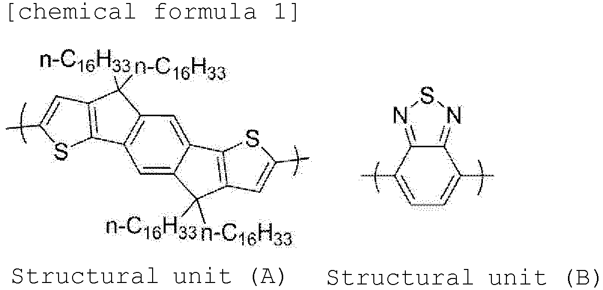

### Prior Art Document

### Non-Patent Document

Non-patent document 1: J. Am. Chem. Soc., 2010, 132, 11437-11439

### Summary of the Invention

However, the electric field effect mobility of an organic film transistor using the above-described polymer compound in an active layer is not necessarily sufficient.

The present invention has an object of providing a composition and a polymer compound which are useful for production of an organic film transistor excellent in electric field effect mobility. Further, the present invention has an object of providing an organic semiconductor device comprising the composition or the polymer compound.

The present invention provides a composition and a polymer compound described below and an organic semiconductor device comprising the composition or the polymer compound.
[1] A composition comprising a polymer compound containing a structural unit represented by the formula (1) and a compound represented by the formula (2): 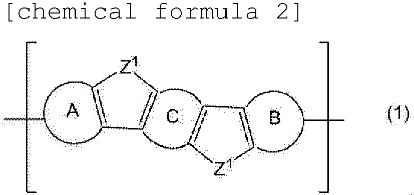 [wherein
   Ring A and Ring B each independently represent a heterocyclic ring, and this heterocyclic ring may have a substituent.
   Ring C represents an aromatic hydrocarbon ring or a heterocyclic ring, and these rings may have a substituent.
   Z¹ represents a group represented by the formula (Z-1), a group represented by the formula (Z-2), a group represented by the formula (Z-3), a group represented by the formula (Z-4) or a group represented by the formula (Z-5). A plurality of Z¹ may be mutually the same or different.] 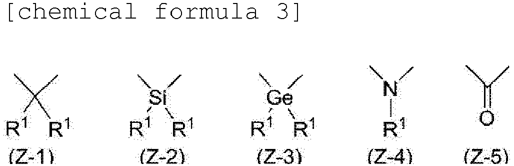
   [wherein R¹ represents an alkyl group, a cycloalkyl group, an alkoxy group, a cycloalkoxy group, an alkylthio group, a cycloalkylthio group, an aryl group or a monovalent heterocyclic ring group, and these groups may have a substituent. When there are a plurality of R¹, they may be the same or different.] 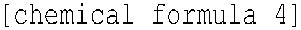 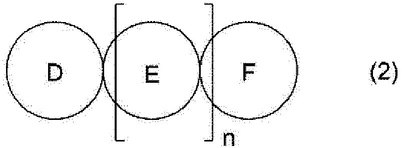 [wherein
   n represents an integer of 1 or more.
   Ring D and Ring F each independently represent a benzene ring, a 5-membered heterocyclic ring or a 6-membered heterocyclic ring, and these rings may have a substituent.
   Ring E represents a benzene ring, a cyclopentadiene ring, a 5-membered heterocyclic ring or a 6-membered heterocyclic ring, and these rings may have a substituent. When there are a plurality of Rings E, they may be the same or different.
   Here, Ring D and Ring E are mutually condensed to form a condensed ring, Ring E and Ring F are mutually condensed to form a condensed ring, and when there are a plurality of Rings E, adjacent Rings E are mutually condensed to form a condensed ring.].
[2] The composition according to [1], wherein the structural unit represented by the formula (1) is a structural unit represented by the formula (1-1), a structural unit represented by the formula (1-2) or a structural unit represented by the formula (1-3): 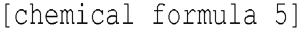 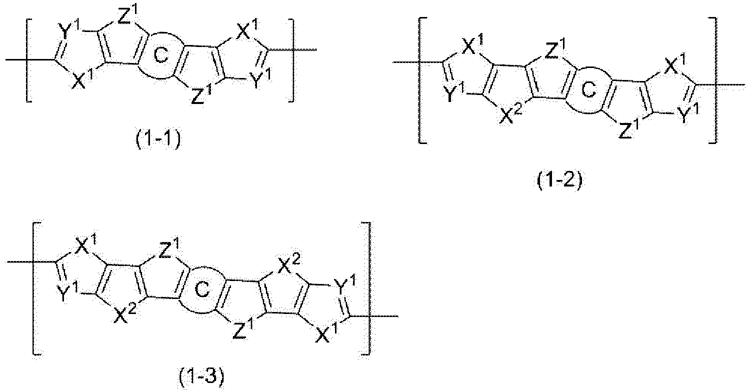 [wherein
   Ring C and Z¹ represent the same meaning as described above.
   X¹ and X² each independently represent an oxygen atom, a sulfur atom or a selenium atom. A plurality of X¹ may be mutually the same or different. When there are a plurality of X², they may be the same or different.
   Y¹ represents a nitrogen atom or a group represented by -CR²=. R² represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent. A plurality of Y¹ may be mutually the same or different.].
[3] The composition according to [1] or [2], wherein Ring C is a benzene ring which may have a substituent or a naphthalene ring which may have a substituent.
[4] The composition according to [2] or [3], wherein X¹ and X² are a sulfur atom.
[5] The composition according to any one of [2] to [4], wherein Y¹ is a group represented by -CH=.
[6] The composition according to any one of [1] to [5], wherein Z¹ is a group represented by the formula (Z-1).
[7] The composition according to any one of [1] to [6], further comprising a structural unit represented by the formula (3) (different from the structural unit represented by the formula (1)). 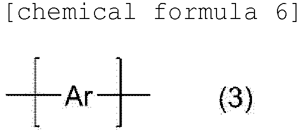 [wherein Ar represents an arylene group or a divalent heterocyclic ring group, and these groups may have a substituent.].
[8] The composition according to any one of [1] to [7], wherein the compound represented by the formula (2) is a compound represented by the formula (2-1), a compound represented by the formula (2-2), a compound represented by the formula (2-3), a compound represented by the formula (2-4), a compound represented by the formula (2-5), a compound represented by the formula (2-6), a compound represented by the formula (2-7), a compound represented by the formula (2-8), a compound represented by the formula (2-9), a compound represented by the formula (2-10), a compound represented by the formula (2-11), a compound represented by the formula (2-12), a compound represented by the formula (2-13) or a compound represented by the formula (2-14): 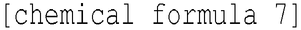 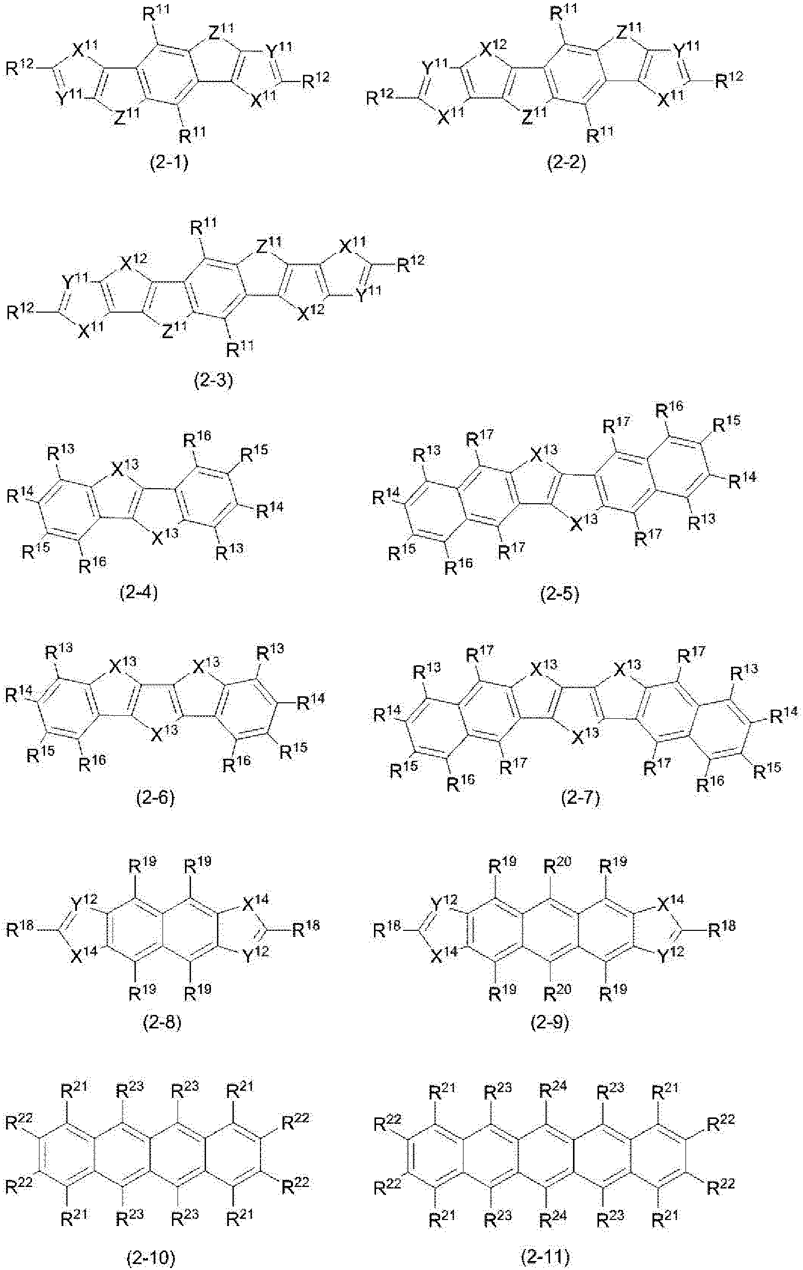 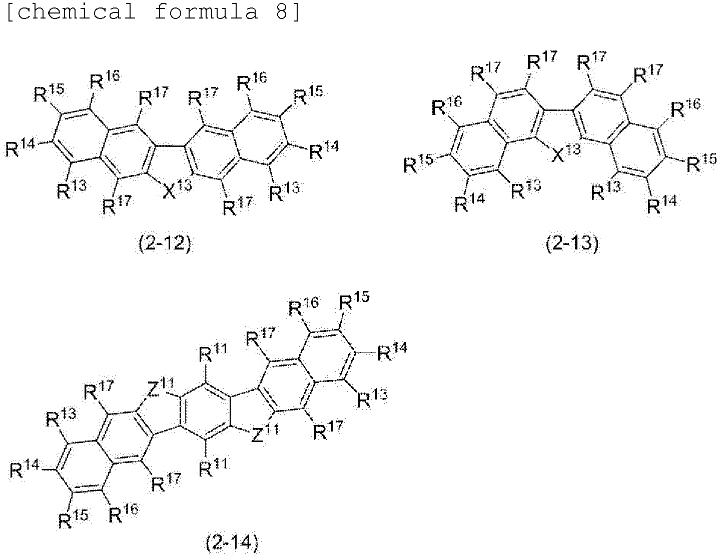 [wherein
   Z¹¹ represents a group represented by the formula (Z-1'), a group represented by the formula (Z-2'), a group represented by the formula (Z-3'), a group represented by the formula (Z-4') or a group represented by the formula (Z-5'). A plurality of Z¹¹ may be mutually the same or different.
   X¹¹, X¹², X¹³ and X¹⁴ each independently represent an oxygen atom, a sulfur atom or a selenium atom. A plurality of X¹¹, X¹³ and X¹⁴ each may be mutually the same or different. When there are a plurality of X¹², they may be the same or different.
   Y¹¹ and Y¹² each independently represent a nitrogen atom or a group represented by -CR²'=. R²' represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent. A plurality of Y¹¹ and Y¹² each may be mutually the same or different.
   R¹¹, R¹², R¹³, R¹⁴, R¹⁵, R¹⁶, R¹⁷, R¹⁸, R¹⁹, R²⁰, R²¹, R²², R²³ and R²⁴ each independently represent a hydrogen atom, an alkyl group, a cycloalkyl group, an alkoxy group, a cycloalkoxy group, an alkylthio group, a cycloalkylthio group, an aryl group, an alkynyl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group, the alkynyl group and the monovalent heterocyclic ring group each may have a substituent. A plurality of R¹¹, R¹², R¹³, R¹⁴, R¹⁵, R¹⁶, R¹⁷, R¹⁸, R¹⁹, R²⁰, R²¹, R²², R²³ and R²⁴ each may be mutually the same or different.] 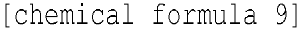 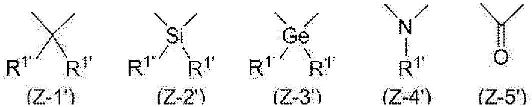
   [wherein R¹' represents an alkyl group, a cycloalkyl group, an alkoxy group, a cycloalkoxy group, an alkylthio group, a cycloalkylthio group, an aryl group or a monovalent heterocyclic ring group, and these groups may have a substituent. When there are a plurality of R¹', they may be the same or different.].
[9] The composition according to [8], wherein the compound represented by the formula (2) is a compound represented by the formula (2-4), a compound represented by the formula (2-5), a compound represented by the formula (2-6) or a compound represented by the formula (2-7).
[10] The composition according to [8] or [9], wherein X¹¹, X¹², X¹³ and X¹⁴ are a sulfur atom.
[11] The composition according to any one of [8] to [10], wherein Y¹¹ and Y¹² are a group represented by -CH=.
[12] The composition according to any one of [8] to [11], wherein Z¹¹ is a group represented by the formula (Z-1').
[13] The composition according to any one of [1] to [12], wherein the content of the compound represented by the formula (2) is 5 to 50 parts by mass with respect to 100 parts by mass of the sum of the polymer compound containing a structural unit represented by the formula (1) and the compound represented by the formula (2).
[14] A polymer compound comprising a structural unit represented by the formula (4) and having a polystyrene-equivalent weight-average molecular weight of 3.0×10⁴ or more: 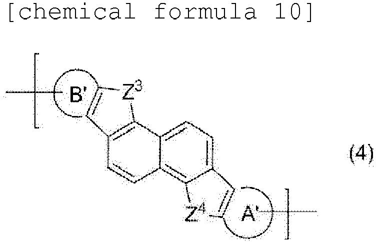 [wherein
   Ring A' and Ring B' each independently represent a heterocyclic ring, and the heterocyclic ring may have a substituent.
   Z³ and Z⁴ each independently represent a group represented by the formula (Z-1"), a group represented by the formula (Z-2"), a group represented by the formula (Z-3"), a group represented by the formula (Z-4") or a group represented by the formula (Z-5").] 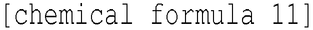 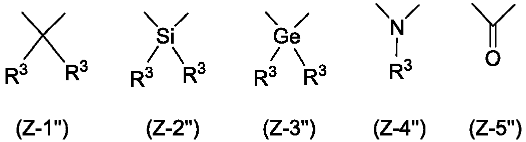
   [wherein R³ represents an alkyl group which may have a substituent. When there are a plurality of R³, they may be the same or different.].
[15] The polymer compound according to [14], wherein the structural unit represented by the formula (4) is a structural unit represented by the formula (5): 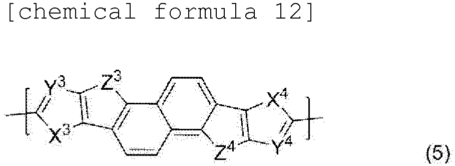 [wherein
   Z³ and Z⁴ represent the same meaning as described above.
   X³ and X⁴ each independently represent an oxygen atom, a sulfur atom or a selenium atom.
   Y³ represents a nitrogen atom or a group represented by -CR⁵=. Y⁴ represents a nitrogen atom or a group represented by -CR⁶=. R⁵ and R⁶ each independently represent a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent.].
[16] The polymer compound according to [15], wherein X³ and X⁴ are a sulfur atom.
[17] The polymer compound according to [15] or [16], wherein Y³ and Y⁴ are a group represented by -CH=.
[18] The polymer compound according to any one of [14] to [17], wherein Z³ and Z⁴ are a group represented by the formula (Z-1").
[19] The polymer compound according to any one of [14] to [18], further comprising a structural unit represented by the formula (6) (different from the structural unit represented by the formula (4)): 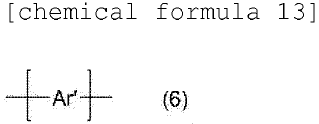 [wherein
   Ar' represents an arylene group or a divalent heterocyclic ring group, and these groups may have a substituent.].
[20] The polymer compound according to [19], wherein the polymer compound is an alternating copolymer composed of a structural unit represented by the formula (4) and a structural unit represented by the formula (6).
[21] An organic semiconductor device having a first electrode and a second electrode and having an active layer between the first electrode and the second electrode, wherein the active layer contains the composition according to any one of [1] to [13] or the polymer compound according to any one of [14] to [20].
[22] The organic semiconductor device according to [21], wherein the organic semiconductor device is any one of an organic film transistor, a photoelectric conversion device, an organic electroluminescent device, an organic electric field effect transistor sensor and an organic conductivity modulation type sensor.
[23] The organic semiconductor device according to [22], wherein the organic semiconductor device is an organic film transistor.

### Brief Explanation of Drawings

Fig. 1 is a schematic cross-sectional view of an organic film transistor according to a first embodiment.
Fig. 2 is a schematic cross-sectional view of an organic film transistor according to a second embodiment.
Fig. 3 is a schematic cross-sectional view of an organic film transistor according to a third embodiment.
Fig. 4 is a schematic cross-sectional view of an organic film transistor according to a fourth embodiment.
Fig. 5 is a schematic cross-sectional view of an organic film transistor according to a fifth embodiment.
Fig. 6 is a schematic cross-sectional view of an organic film transistor according to a sixth embodiment.
Fig. 7 is a schematic cross-sectional view of an organic film transistor according to a seventh embodiment.

### Modes for Carrying Out the Invention

Suitable embodiments of the present invention will be illustrated in detail below, if necessary referring to drawings. In explanation of drawings, the same elements are denoted by the same reference numerals, and duplicated explanations are omitted.

### <Composition>

The composition of the present invention comprises a polymer compound containing a structural unit represented by the formula (1) and a compound represented by the formula (2).

### <Polymer compound contained in composition>

### (First structural unit)

The polymer compound contained in the composition of the present invention is a polymer compound containing a structural unit represented by the formula (1) (hereinafter, referred to as "first structural unit" in some cases). The first structural units may be contained each singly or in combination of two or more in the polymer compound. The polymer compound contained in the composition of the present invention is preferably a conjugated polymer compound.

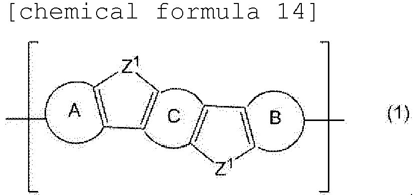

In the formula (1), Ring A and Ring B each independently represent a heterocyclic ring, and this heterocyclic ring may have a substituent. The heterocyclic ring has a number of carbon atoms of preferably 2 to 30, more preferably 2 to 14, further preferably 3 to 10. Here, the above-described number of carbon atoms does not include the number of carbon atoms of a substituent.

The heterocyclic ring includes, for example, a furan ring, a thiophene ring, a selenophene ring, a pyrrole ring, an oxazole ring, a thiazole ring, an imidazole ring, a pyridine ring, a benzofuran ring, a benzothiophene ring, a thienothiophene ring and a 2,1,3-benzothiadiazole ring.

The substituent which the heterocyclic ring may have includes, for example, an alkyl group, a cycloalkyl group, an alkoxy group, a cycloalkoxy group, an alkylthio group, a cycloalkylthio group, an aryl group, a monovalent heterocyclic ring group, a halogen atom, a silyl group, an amino group, an alkenyl group, a cycloalkenyl group, an alkynyl group, a cycloalkynyl group, a hydroxyl group, a nitro group, a cyano group, a carboxyl group, an alkylcarbonyl group, a cycloalkylcarbonyl group, an alkoxycarbonyl group and a cycloalkoxycarbonyl group.

The alkyl group as the substituent which the heterocyclic ring may have may be any of a linear alkyl group or a branched alkyl group. The number of carbon atoms of the alkyl group is usually 1 to 30 (in the case of a branched alkyl group, usually 3 to 30), and preferably 1 to 20 (in the case of a branched alkyl group, 3 to 20). The number of carbon atoms of the cycloalkyl group as the substituent which the heterocyclic ring may have is usually 3 to 30, preferably 3 to 20. Here, the above-described number of carbon atoms does not include the number of carbon atoms of a substituent.

The alkyl group includes, for example, linear alkyl groups such as a methyl group, an ethyl group, a n-propyl group, a n-butyl group, a n-hexyl group, a n-octyl group, a n-dodecyl group, a n-hexadecyl group and the like, and branched alkyl groups such as an isopropyl group, an isobutyl group, a sec-butyl group, a tert-butyl group, a 2-ethylhexyl group, a 3,7-dimethyloctyl group and the like. The cycloalkyl group includes, for example, a cyclopentyl group and a cyclohexyl group.

The alkyl group may have a substituent, and the substituent includes, for example, a cycloalkyl group, an alkoxy group, a cycloalkoxy group, an aryl group and a halogen atom. The cycloalkyl group may have a substituent, and the substituent includes, for example, an alkyl group, a cycloalkyl group, an alkoxy group, a cycloalkoxy group, an aryl group and a halogen atom. The alkyl group having a substituent includes, for example, a methoxyethyl group, a benzyl group, a trifluoromethyl group and a perfluorohexyl group.

The alkoxy group as the substituent which the heterocyclic ring may have may be any of a linear alkoxy group or a branched alkoxy group. The number of carbon atoms of the alkoxy group is usually 1 to 30 (in the case of a branched alkoxy group, usually 3 to 30), and preferably 1 to 20 (in the case of a branched alkoxy group, 3 to 20). The number of carbon atoms of the cycloalkoxy group as the substituent which the heterocyclic ring may have is usually 3 to 30, preferably 3 to 20. Here, the above-described number of carbon atoms does not include the number of carbon atoms of a substituent.

The alkoxy group includes, for example, linear alkoxy groups such as a methoxy group, an ethoxy group, a n-propyloxy group, a n-butyloxy group, a n-hexyloxy group, a n-octyloxy group, a n-dodecyloxy group, a n-hexadecyloxy group and the like, and branched alkoxy groups such as an isopropyloxy group, an isobutyloxy group, a sec-butyloxy group, a tert-butyloxy group, a 2-ethylhexyloxy group, a 3,7-dimethyloctyloxy group and the like. The cycloalkoxy group includes, for example, a cyclopentyloxy group and a cyclohexyloxy group.

The alkoxy group may have a substituent, and the substituent includes, for example, a cycloalkyl group, an alkoxy group, a cycloalkoxy group, an aryl group and a halogen atom. The cycloalkoxy group may have a substituent, and the substituent includes, for example, an alkyl group, a cycloalkyl group, an alkoxy group, a cycloalkoxy group, an aryl group and a halogen atom.

The alkylthio group as the substituent which the heterocyclic ring may have may be any of a linear alkylthio group or a branched alkylthio group. The number of carbon atoms of the alkylthio group is usually 1 to 30 (in the case of a branched alkylthio group, usually 3 to 30), and preferably 1 to 20 (in the case of a branched alkylthio group, 3 to 20). The number of carbon atoms of the cycloalkylthio group as the substituent which the heterocyclic ring may have is usually 3 to 30, preferably 3 to 20. Here, the above-described number of carbon atoms does not include the number of carbon atoms of a substituent.

The alkylthio group includes, for example, linear alkylthio groups such as a methylthio group, an ethylthio group, a n-propylthio group, a n-butylthio group, a n-hexylthio group, a n-octylthio group, a n-dodecylthio group, a n-hexadecylthio group and the like, and branched alkylthio groups such as an isopropylthio group, an isobutylthio group, a sec-butylthio group, a tert-butylthio group, a 2-ethylhexylthio group, a 3,7-dimethyloctylthio group and the like. The cycloalkylthio group includes, for example, a cyclopentylthio group and a cyclohexylthio group.

The alkylthio group may have a substituent, and the substituent includes, for example, a cycloalkyl group, an alkoxy group, a cycloalkoxy group, an aryl group and a halogen atom. The cycloalkylthio group may have a substituent, and the substituent includes, for example, an alkyl group, a cycloalkyl group, an alkoxy group, a cycloalkoxy group, an aryl group and a halogen atom.

The aryl group as the substituent which the heterocyclic ring may have is an atomic group remaining after removing from an aromatic hydrocarbon which may have a substituent one hydrogen atom linking directly to a carbon atom constituting the ring, and includes a group having a condensed ring, and a group obtained by directly bonding two or more moieties selected from the group consisting of an independent benzene ring and condensed rings. The number of carbon atoms of the aryl group is usually 6 to 30, preferably 6 to 20. Here, the above-described number of carbon atoms does not include the number of carbon atoms of a substituent.

The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group and a 4-phenylphenyl group.

The aryl group may have a substituent, and the substituent includes, for example, an alkyl group, a cycloalkyl group, an alkoxy group, a cycloalkoxy group, an alkylthio group, a cycloalkylthio group, a monovalent heterocyclic ring group and a halogen atom. The aryl group having a substituent includes, for example, a 4-hexadecylphenyl group, a 3,5-dimethoxyphenyl group and a pentafluorophenyl group. When the aryl group has a substituent, the substituent is preferably an alkyl group or a cycloalkyl group.

The monovalent heterocyclic ring group as the substituent which the heterocyclic ring may have is an atomic group remaining after removing from a heterocyclic compound which may have a substituent one hydrogen atom linking directly to a carbon atom or a hetero atom constituting the ring, and includes a group having a condensed ring, and a group obtained by directly bonding two or more moieties selected from the group consisting of independent heterocyclic rings and condensed rings. The number of carbon atoms of the monovalent heterocyclic ring group is usually 2 to 30, preferably 3 to 20. Here, the above-described number of carbon atoms does not include the number of carbon atoms of a substituent.

The monovalent heterocyclic ring group includes, for example, a 2-furyl group, a 3-furyl group, a 2-thienyl group, a 3-thienyl group, a 2-pyrrolyl group, a 3-pyrrolyl group, a 2-oxazolyl group, a 2-thiazolyl group, a 2-imidazolyl group, a 2-pyridyl group, a 3-pyridyl group, a 4-pyridyl group, a 2-benzofuryl group, a 2-benzothienyl group, a 2-thienothienyl group and a 4-(2,1,3-benzothiadiazolyl) group.

The monovalent heterocyclic ring group may have a substituent, and the substituent includes, for example, an alkyl group, a cycloalkyl group, an alkoxy group, a cycloalkoxy group, an alkylthio group, a cycloalkylthio group, an aryl group and a halogen atom. The monovalent heterocyclic ring group having a substituent includes, for example, a 5-octyl-2-thienyl group and a 5-phenyl-2-furyl group. When the monovalent heterocyclic ring group has a substituent, the substituent is preferably an alkyl group or a cycloalkyl group.

The halogen atom as the substituent which the heterocyclic ring may have includes, for example, a fluorine atom, a chlorine atom, a bromine atom and an iodine atom.

The silyl group as the substituent which the heterocyclic ring may have may have a substituent. The substituent which the silyl group may have includes, for example, an alkyl group, a cycloalkyl group and an aryl group. The silyl group having a substituent includes, for example, a trimethylsilyl group, a triethylsilyl group, a triisopropylsilyl group, a tert-butyldimethylsilyl group, a phenylsilyl group and a triphenylsilyl group.

The amino group as the substituent which the heterocyclic ring may have may have a substituent. The substituent which the amino group may have includes, for example, an alkyl group, a cycloalkyl group and an aryl group. The amino group having a substituent includes, for example, a dimethylamino group, a diethylamino group, a diisopropylamino group and a

### diphenylamino group.

The alkenyl group as the substituent which the heterocyclic ring may have may be any of a linear alkenyl group or a branched alkenyl group. The number of carbon atoms of the alkenyl group is usually 2 to 30 (in the case of a branched alkenyl group, usually 3 to 30), and preferably 2 to 20 (in the case of a branched alkenyl group, 3 to 20). The number of carbon atoms of the cycloalkenyl group as the substituent which the heterocyclic ring may have is usually 3 to 30, preferably 3 to 20. Here, the above-described number of carbon atoms does not include the number of carbon atoms of a substituent.

The alkenyl group includes, for example, a vinyl group, a 1-propenyl group, a 2-propenyl group, a 1-hexenyl group, a 1-dodecenyl group, a 1-hexadecenyl group and a 1-cyclohexenyl group.

The alkenyl group may have a substituent, and the substituent includes, for example, an aryl group, a halogen atom and a silyl group. The cycloalkenyl group may have a substituent, and the substituent includes, for example, an aryl group, a halogen atom and a silyl group.

The alkynyl group as the substituent which the heterocyclic ring may have may be any of a linear alkynyl group or a branched alkynyl group. The number of carbon atoms of the alkynyl group is usually 2 to 30 (in the case of a branched alkynyl group, usually 4 to 30), and preferably 2 to 20 (in the case of a branched alkynyl group, 4 to 20). The number of carbon atoms of the cycloalkynyl group as the substituent which the heterocyclic ring may have is usually 6 to 30, preferably 6 to 20. Here, the above-described number of carbon atoms does not include the number of carbon atoms of a substituent.

The alkynyl group includes, for example, an ethynyl group, a 1-propynyl group, a 1-hexynyl group, a 1-dodecynyl group and a 1-hexadecynyl group.

The alkynyl group may have a substituent, and the substituent includes, for example, an aryl group, a halogen atom and a silyl group. The cycloalkynyl group may have a substituent, and the substituent includes an aryl group, a halogen atom and a silyl group.

The silyl group may have a substituent. The substituent which the silyl group may have includes, for example, an alkyl group, a cycloalkyl group and an aryl group. The silyl group having a substituent includes, for example, silyl groups having 3 to 18 carbon atoms such as a trimethylsilyl group, a triethylsilyl group, a triisopropylsilyl group, a tert-butyldimethylsilyl group, a phenylsilyl group, a triphenylsilyl group and the like.

The alkylcarbonyl group as the substituent which the heterocyclic ring may have includes, for example, groups obtained by bonding of the above-described alkyl group and a carbonyl group. The cycloalkylcarbonyl group as the substituent which the heterocyclic ring may have includes, for example, groups obtained by bonding of the above-described cycloalkyl group and a carbonyl group.

The alkylcarbonyl group includes, for example, linear alkylcarbonyl groups such as an acetyl group, a n-propanoyl group, a n-butanoyl group, a n-hexanoyl group, a n-octanoyl group, a n-dodecanoyl group, a n-hexadecanoyl group and the like, and branched alkylcarbonyl groups such as an isobutanoyl group, a sec-butanoyl group, a tert-butanoyl group, a 2-ethylhexanoyl group and the like. The cycloalkylcarbonyl group includes, for example, a cyclopentylcarbonyl group and a cyclohexylcarbonyl group.

The alkoxycarbonyl group as the substituent which the heterocyclic ring may have includes, for example, groups obtained by bonding of the above-described alkoxy group and a carbonyl group. The cycloalkoxycarbonyl group as the substituent which the heterocyclic ring may have includes, for example, groups obtained by bonding of the above-described cycloalkoxy group and a carbonyl group.

The alkoxycarbonyl group includes, for example, linear alkoxycarbonyl groups such as a methoxycarbonyl group, an ethoxycarbonyl group, a n-propyloxycarbonyl group, a n-butoxycarbonyl group, a n-hexyloxycarbonyl group, a n-octyloxycarbonyl group, a n-dodecyloxycarbonyl group, a n-hexadecyloxycarbonyl group and the like, and branched alkoxycarbonyl groups such as an isopropyloxycarbonyl group, an isobutyloxycarbonyl group, a sec-butyloxycarbonyl group, a tert-butyloxycarbonyl group, a 2-ethylhexyloxycarbonyl group and the like. The cycloalkoxycarbonyl group includes, for example, a cyclopentyloxycarbonyl group and a cyclohexyloxycarbonyl group.

It is preferable that Ring A and Ring B are the same heterocyclic ring, since synthesis of the polymer compound contained in the composition of the present invention is easy.

Ring A and Ring B are preferably constituted of a 5-membered and/or a 6-membered heterocyclic ring, more preferably constituted only of a 5-membered heterocyclic ring, further preferably a 5-membered heterocyclic ring, since an organic film transistor produced by using the composition of the present invention is more excellent in electric field effect mobility.

In the formula (1), Ring C represents an aromatic hydrocarbon ring or a heterocyclic ring, and these rings may have a substituent.

The aromatic hydrocarbon ring represented by Ring C has a number of carbon atoms of preferably 6 to 30, more preferably 6 to 24, further preferably 6 to 18. Here, the above-described number of carbon atoms does not include the number of carbon atoms of a substituent.

The aromatic hydrocarbon ring includes, for example, a benzene ring, a naphthalene ring, an anthracene ring, a pyrene ring and a fluorene ring.

The heterocyclic ring represented by Ring C has a number of carbon atoms of preferably 2 to 30, more preferably 2 to 14, further preferably 3 to 10. Here, the above-described number of carbon atoms does not include the number of carbon atoms of a substituent.

The heterocyclic ring includes, for example, a furan ring, a thiophene ring, a selenophene ring, a pyrrole ring, an oxazole ring, a thiazole ring, an imidazole ring, a pyridine ring, a benzofuran ring, a benzothiophene ring, a thienothiophene ring and a 2,1,3-benzothiadiazole ring.

The substituent which the heterocyclic ring may have includes, for example, an alkyl group, a cycloalkyl group, an alkoxy group, a cycloalkoxy group, an alkylthio group, a cycloalkylthio group, an aryl group, a monovalent heterocyclic ring group, a halogen atom, a silyl group, an amino group, an alkenyl group, a cycloalkenyl group, an alkynyl group, a cycloalkynyl group, a hydroxyl group, a nitro group, a cyano group, a carboxyl group, an alkylcarbonyl group, a cycloalkylcarbonyl group, an alkoxycarbonyl group and a cycloalkoxycarbonyl group.

The substituent which the aromatic hydrocarbon ring and the heterocyclic ring represented by Ring C may have includes, for example, an alkyl group, a cycloalkyl group, an alkoxy group, a cycloalkoxy group, an alkylthio group, a cycloalkylthio group, an aryl group, a monovalent heterocyclic ring group, a halogen atom, a silyl group, an amino group, an alkenyl group, a cycloalkenyl group, an alkynyl group, a cycloalkynyl group, a hydroxyl group, a nitro group, a cyano group, carboxyl group, an alkylcarbonyl group, a cycloalkylcarbonyl group, an alkoxycarbonyl group or a cycloalkoxycarbonyl group, and the definition and specific examples of these substituents are the same as the definition and specific examples of the alkyl group, the cycloalkyl group, the alkoxy group, the cycloalkoxy group, the alkylthio group, the cycloalkylthio group, the aryl group, the monovalent heterocyclic ring group, the halogen atom, the silyl group, the amino group, the alkenyl group, the cycloalkenyl group, the alkynyl group, the cycloalkynyl group, the alkylcarbonyl group, the cycloalkylcarbonyl group, the alkoxycarbonyl group and the cycloalkoxycarbonyl group as the substituent which the heterocyclic ring may have described above.

Ring C is preferably an aromatic hydrocarbon ring, more preferably a benzene ring or a naphthalene ring, since an organic film transistor produced by using the composition of the present invention is more excellent in electric field effect mobility, and these rings may have a substituent.

Ring C preferably has an alkyl group, a cycloalkyl group, an alkoxy group, a cycloalkoxy group, an alkylthio group, a cycloalkylthio group, an amino group or a hydroxyl group, more preferably has an alkyl group, a cycloalkyl group, an alkoxy group or a cycloalkoxy group, further preferably has an alkoxy group or a cycloalkoxy group

In the formula (1), Z¹ represents a group represented by the formula (Z-1), a group represented by the formula (Z-2), a group represented by the formula (Z-3), a group represented by the formula (Z-4) or a group represented by the formula (Z-5). A plurality of Z¹ may be mutually the same or different.

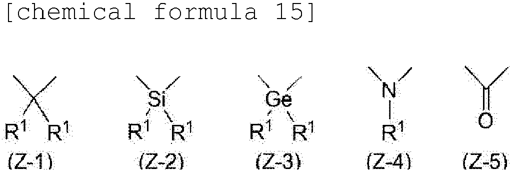

It is preferable that a plurality of Z¹ are the same group, since synthesis of the polymer compound contained in the composition of the present invention is easy

Z¹ is preferably a group represented by the formula (Z-1) or the formula (Z-2), more preferably a group represented by the formula (Z-1), since an organic film transistor produced by using the composition of the present invention is more excellent in electric field effect mobility,

In the formula (Z-1) to the formula (Z-5), R¹ represents an alkyl group, a cycloalkyl group, an alkoxy group, a cycloalkoxy group, an alkylthio group, a cycloalkylthio group, an aryl group or a monovalent heterocyclic ring group, and these groups may have a substituent. When there are a plurality of R¹, they may be the same or different.

The definition and specific examples of the alkyl group, the cycloalkyl group, the alkoxy group, the cycloalkoxy group, the alkylthio group, the cycloalkylthio group, the aryl group and the monovalent heterocyclic ring group are the same as the definition and specific examples of the alkyl group, the cycloalkyl group, the alkoxy group, the cycloalkoxy group, the alkylthio group, the cycloalkylthio group, the aryl group and the monovalent heterocyclic ring group as the substituent which the heterocyclic ring may have described above.

R¹ is preferably an alkyl group, a cycloalkyl group or an aryl group, since an organic film transistor produced by using the composition of the present invention is more excellent in electric field effect mobility.

The structural unit represented by the formula (1) is preferably a structural unit represented by the formula (1-1), a structural unit represented by the formula (1-2) or a structural unit represented by the formula (1-3), more preferably a structural unit represented by the formula (1-1), since an organic film transistor produced by using the composition of the present invention is more excellent in electric field effect mobility.

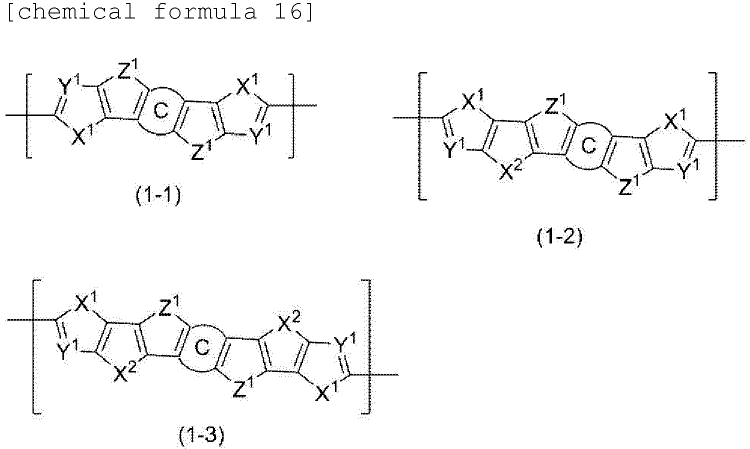

In the formula (1-1) to the formula (1-3), X¹ and X² each independently represent an oxygen atom, a sulfur atom or a selenium atom. A plurality of X¹ may be mutually the same or different. When there are a plurality of X², they may be the same or different.

X¹ and X² are preferably a sulfur atom, since an organic film transistor produced by using the composition of the present invention is more excellent in electric field effect mobility.

In the formula (1-1) to the formula (1-3), Y¹ represents a nitrogen atom or a group represented by -CR² =. R² represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent. A plurality of Y¹ may be mutually the same or different.

The definition and specific examples of the alkyl group, the cycloalkyl group, the alkoxy group, the cycloalkoxy group, the alkylthio group, the cycloalkylthio group, the aryl group and the monovalent heterocyclic ring group are the same as the definition and specific examples of the alkyl group, the cycloalkyl group, the alkoxy group, the cycloalkoxy group, the alkylthio group, the cycloalkylthio group, the aryl group and the monovalent heterocyclic ring group as the substituent which the heterocyclic ring may have described above.

R² is preferably a hydrogen atom, an alkyl group, a cycloalkyl group, an alkoxy group, a cycloalkoxy group or a halogen atom, more preferably a hydrogen atom, an alkyl group, a cycloalkyl group or a halogen atom, since synthesis of the polymer compound contained in the composition of the present invention is easy.

Y¹ is preferably a group represented by -CR² =, more preferably a group represented by -CH=, since synthesis of the polymer compound contained in the composition of the present invention is easy.

The structural unit represented by the formula (1) (may also be a structural unit represented by the formula (1-1) to the formula (1-3)) includes, for example, structural units represented by the formula (1-11-1) to the formula (1-11-10), the formula (1-12-1) to the formula (1-12-10) and the formula (1-13-1) to the formula (1-13-10).

The structural unit represented by the formula (1) is preferably a structural unit represented by the formula (1-11-1), the formula (1-11-2), the formula (1-11-3), the formula (1-12-1), the formula (1-12-3), the formula (1-12-5), the formula (1-13-1), the formula (1-13-3) or the formula (1-13-5), more preferably a structural unit represented by the formula (1-11-1), the formula (1-11-2), the formula (1-11-3), the formula (1-12-1), the formula (1-12-3), the formula (1-13-1) or the formula (1-13-3), further preferably a structural unit represented by the formula (1-11-1), the formula (1-11-2) or the formula (1-11-3), since an organic film transistor produced by using the composition of the present invention is more excellent in electric field effect mobility.

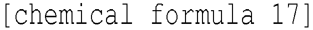

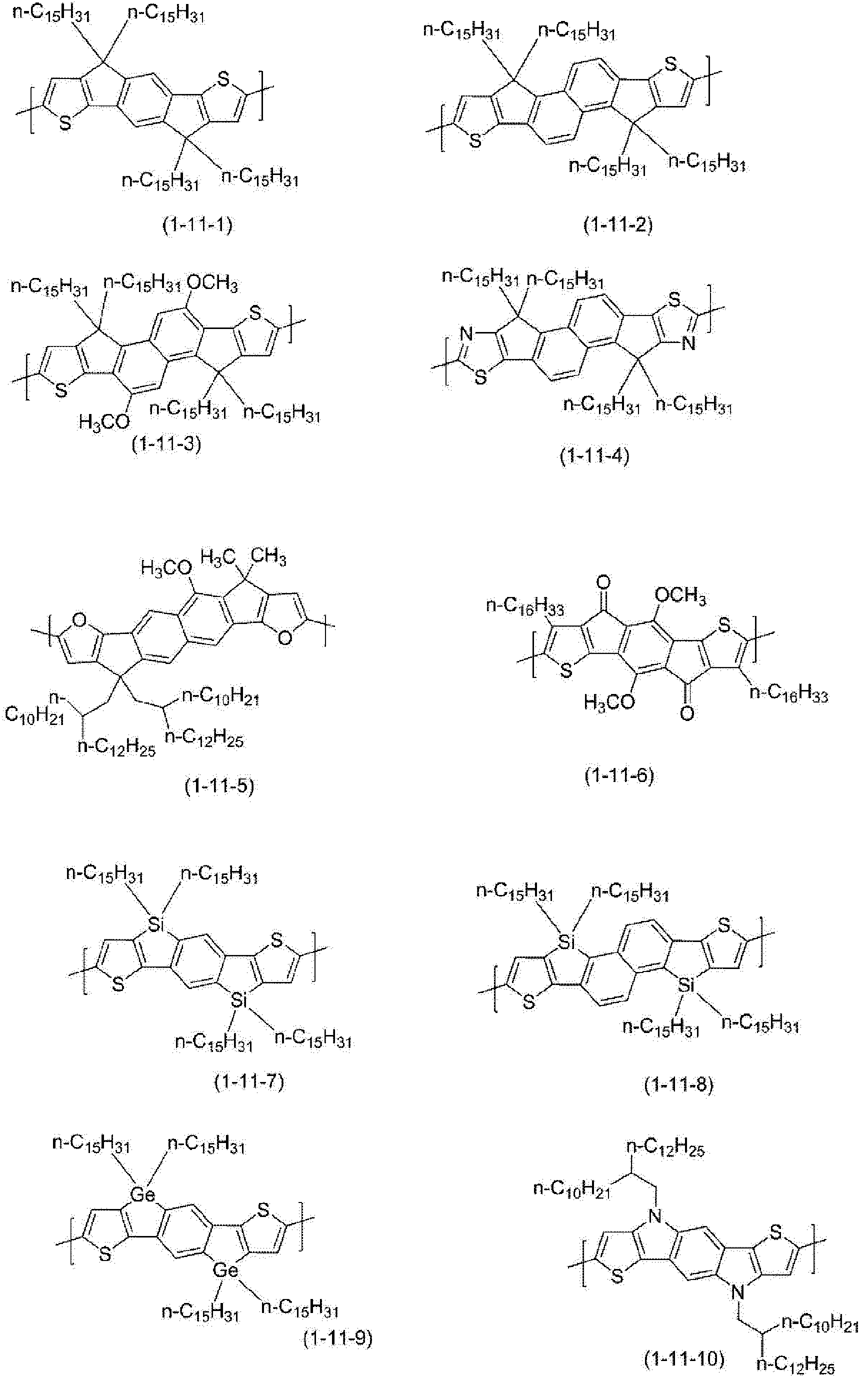

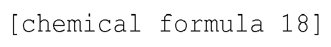

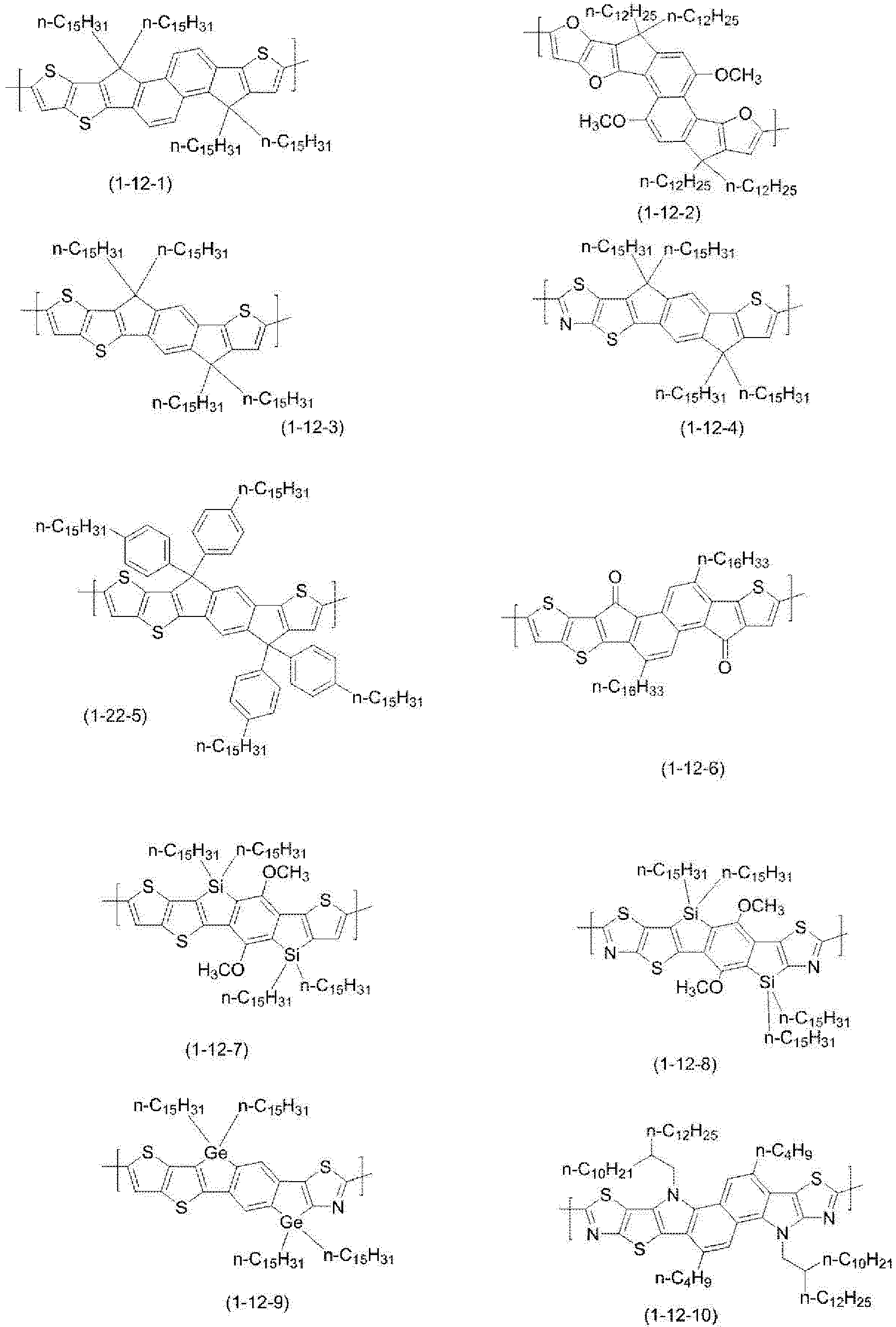

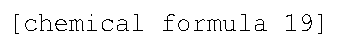

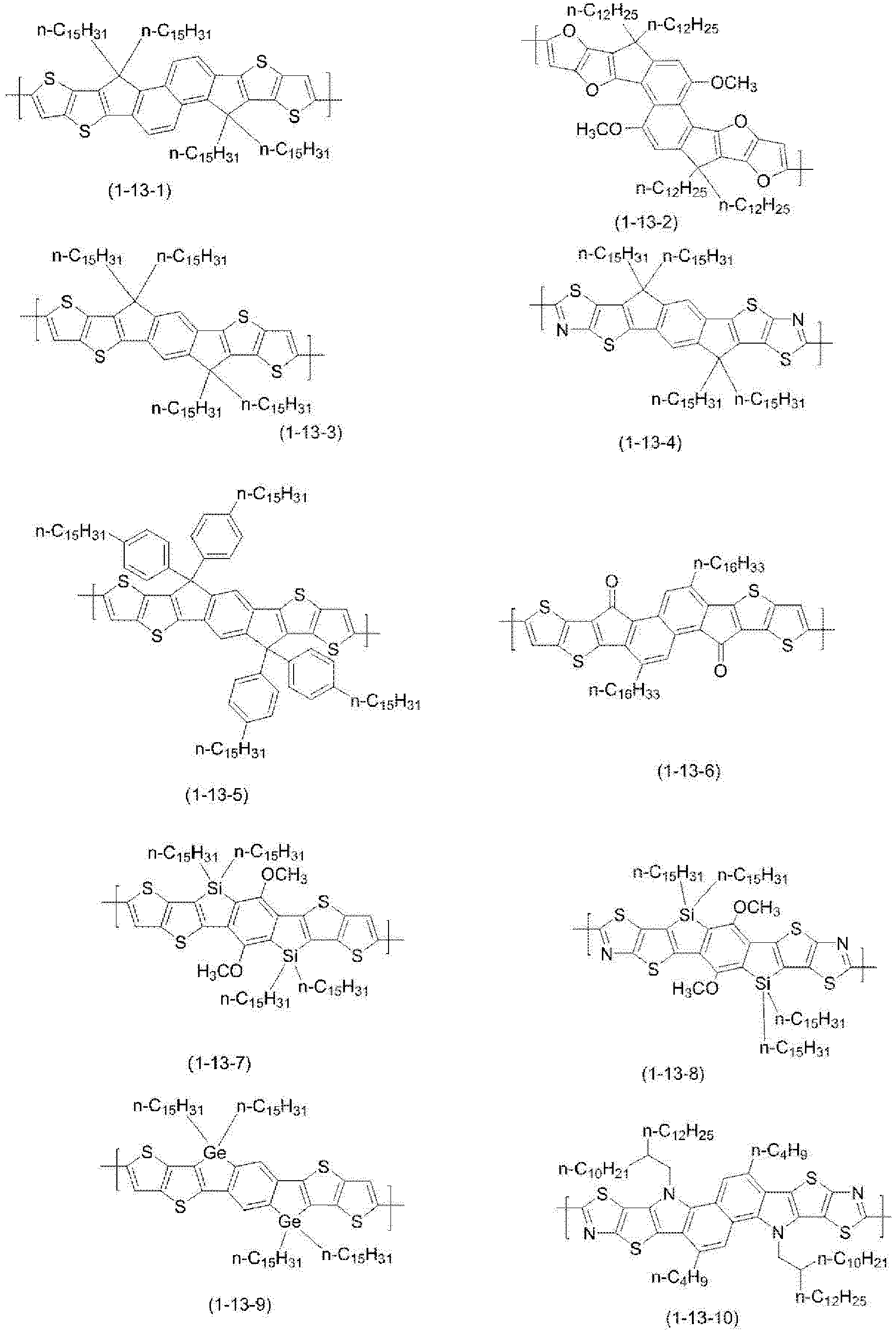

### (Second structural unit)

It is preferable that the polymer compound contained in the composition of the present invention further contains a structural unit represented by the formula (3) (different from the structural unit represented by the above-described formula (1)) (hereinafter, referred to as "second structural unit" in some cases), in addition to the structural unit represented by the formula (1).

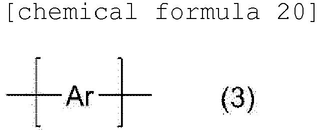

In the formula (3), Ar represents an arylene group or a divalent heterocyclic ring group, and these groups may have a substituent.

When the polymer compound contained in the composition of the present invention contains the second structural unit, it is preferable that a structural unit represented by the formula (1) (may also be a structural unit represented by the formula (1-1) to the formula (1-3)) and a structural unit represented by the formula (3) are conjugated.

In the present specification, conjugated denotes a state in which unsaturated bonds and single bonds range alternately and bonding electrons are present without localization, in the structure of the molecule. Here, the unsaturated bond denotes a double bond or a triple bond.

The arylene group is an atomic group remaining after removing from an aromatic hydrocarbon which may have a substituent two hydrogen atoms linking directly to carbon atoms constituting the ring, and includes a group having a condensed ring, a group obtained by directly bonding two or more moieties selected from the group consisting of an independent benzene ring and condensed rings, and a group obtained by bonding two or more moieties selected from the group consisting of an independent benzene ring and condensed rings via vinylene or the like. The number of carbon atoms of the arylene group is usually 6 to 60, preferably 6 to 20. Here, the above-described number of carbon atoms does not include the number of carbon atoms of a substituent.

The arylene group may have a substituent, and the substituent includes, for example, an alkyl group, a cycloalkyl group, an alkoxy group, a cycloalkoxy group, an alkylthio group, a cycloalkylthio group, a monovalent heterocyclic ring group and a halogen atom. The definition and specific examples of these substituents are the same as the definition and specific examples of the alkyl group, the cycloalkyl group, the alkoxy group, the cycloalkoxy group, the alkylthio group, the cycloalkylthio group, the monovalent heterocyclic ring group and the halogen atom as the substituent which the heterocyclic ring may have described above.

The arylene group includes, for example, arylene groups represented by the following formulae 1 to 12.

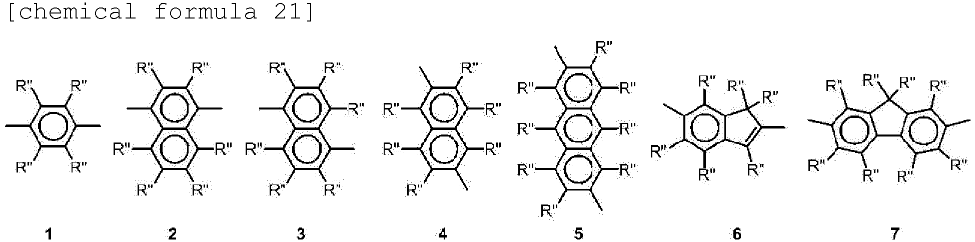

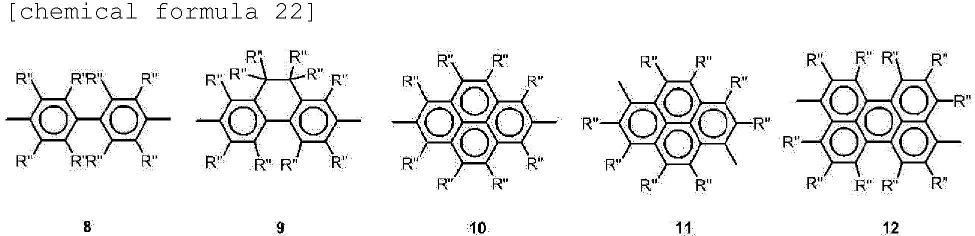

In the formulae 1 to 12, R" represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. A plurality of R" may be the same or different.

The definition and specific examples of the alkyl group, the cycloalkyl group, the alkoxy group, the cycloalkoxy group, the alkylthio group, the cycloalkylthio group, the aryl group, the monovalent heterocyclic ring group and the halogen atom are the same as the definition and specific examples of the alkyl group, the cycloalkyl group, the alkoxy group, the cycloalkoxy group, the alkylthio group, the cycloalkylthio group, the aryl group, the monovalent heterocyclic ring group and the halogen atom as the substituent which the heterocyclic ring may have described above.

The divalent heterocyclic ring group is an atomic group remaining after removing from a heterocyclic compound which may have a substituent two hydrogen atoms linking directly to carbon atoms or hetero atoms constituting the ring, and includes a group having a condensed ring, and a group obtained by directly bonding two or more moieties selected from the group consisting of independent heterocyclic rings and condensed rings. The number of carbon atoms of the divalent heterocyclic ring group is usually 2 to 30, preferably 3 to 20. Here, the above-described number of carbon atoms does not include the number of carbon atoms of a substituent. The divalent heterocyclic ring group is preferably a divalent aromatic heterocyclic ring group.

The divalent heterocyclic ring group may have a substituent, and the substituent includes, for example, an alkyl group, a cycloalkyl group, an alkoxy group, a cycloalkoxy group, an alkylthio group, a cycloalkylthio group, an aryl group and a halogen atom. The definition and specific examples of these substituents are the same as the definition and specific examples of the alkyl group, the cycloalkyl group, the alkoxy group, the cycloalkoxy group, the alkylthio group, the cycloalkylthio group, the aryl group and the halogen atom as the substituent which the heterocyclic ring may have described above.

The divalent heterocyclic ring group includes, for example, divalent heterocyclic ring groups represented by the following formulae 13 to 64.

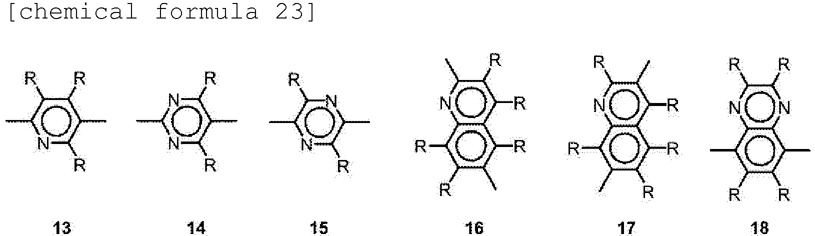

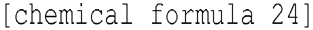

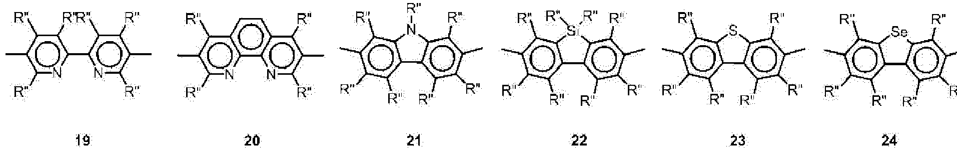

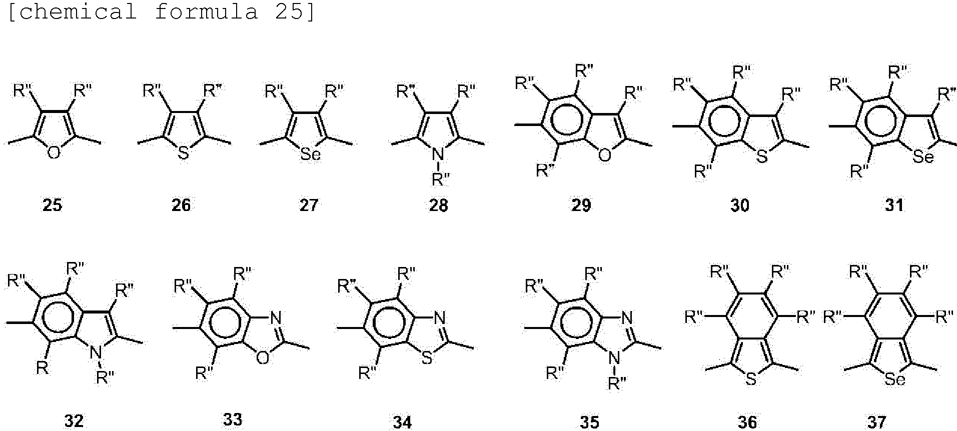

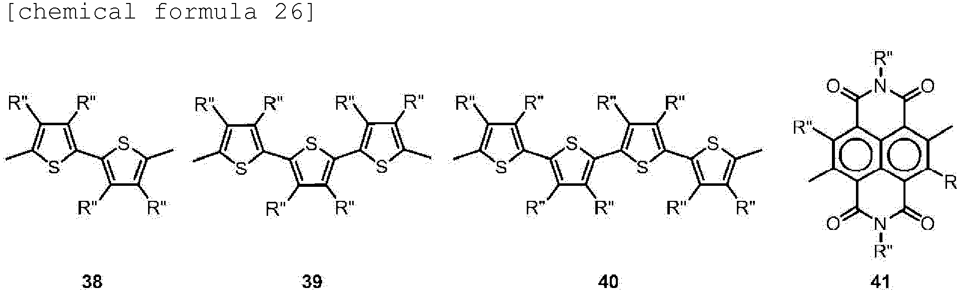

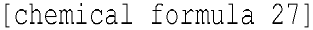

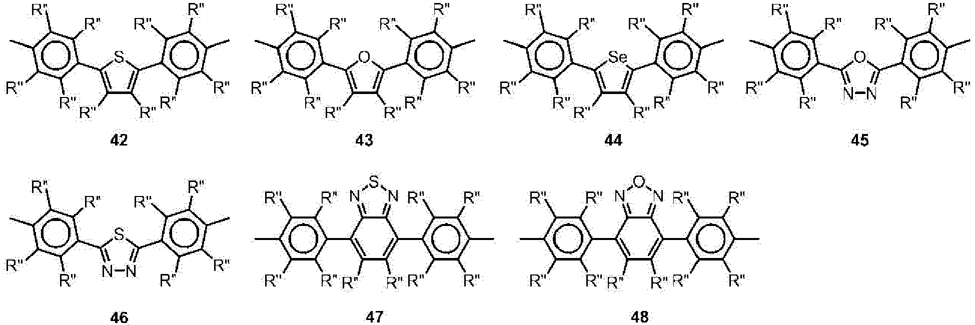

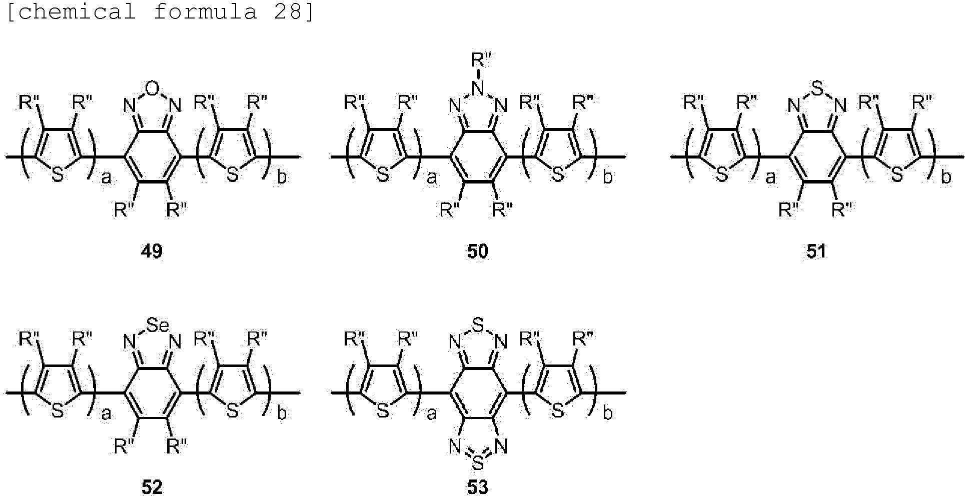

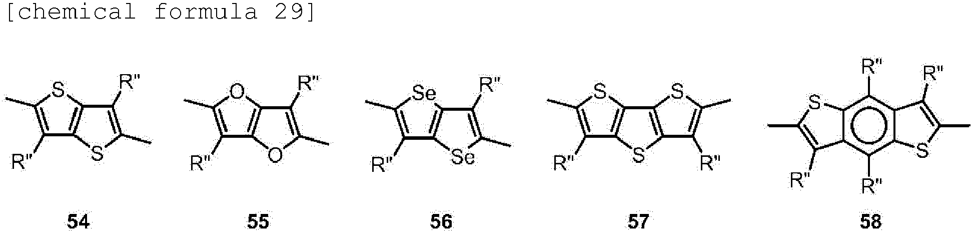

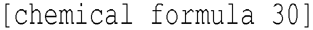

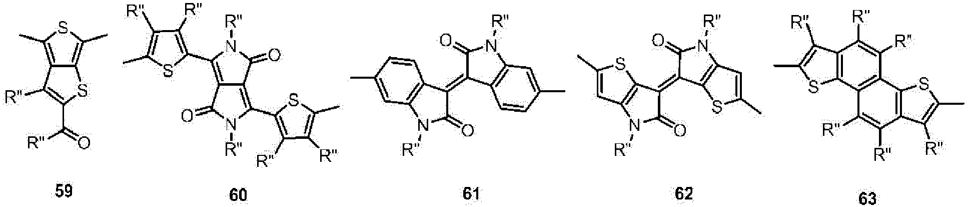

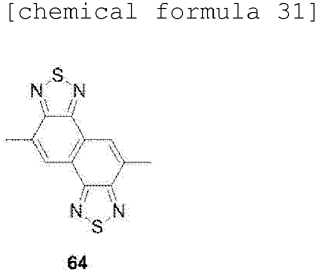

In the formulae 13 to 64, R" represents the same meaning as described above. a and b each independently represent the number of repetition, and usually an integer of 0 to 5, preferably an integer of 0 to 3, more preferably an integer of 0 to 1.

The second structural unit is preferably a divalent heterocyclic ring group, more preferably a divalent heterocyclic ring group represented by the formula 49 to the formula 53, the formulae 59 to 62 or the formula 64, further preferably a divalent heterocyclic ring group represented by the formula 51 or the formula 64, since an organic film transistor produced by using the composition of the present invention is more excellent in electric field effect mobility.

The polymer compound contained in the composition of the present invention has a polystyrene-equivalent number-average molecular weight (Mn) measured by gel permeation chromatography (hereinafter, referred to as "GPC") of usually 1×10³ to 1×10⁷. The number-average molecular weight is preferably 3×10³ or more, from the standpoint of forming an excellent film. The number-average molecular weight is preferably 1×10⁶ or less, from the standpoint of enhancing solubility in a solvent and making film formation easy.

The polymer compound contained in the composition of the present invention has high solubility in a solvent (preferably, an organic solvent), and specifically, it preferably has solubility by which a solution containing the polymer compound contained in the composition of the present invention in an amount of 0.1% by weight (hereinafter, referred to as "wt%" in some cases) or more can be prepared, more preferably has solubility by which a solution containing the polymer compound in an amount of 0.4 wt% or more can be prepared.

The number of a structural unit represented by the formula (1) in the polymer compound contained in the composition of the present invention may be one in the polymer compound, preferably three or more in the polymer compound, more preferably five or more in the polymer compound.

The polymer compound contained in the composition of the present invention may be any of a homopolymer and a copolymer. The copolymer may be any kind of copolymer, and for example, may be any of a block copolymer, a random copolymer, an alternating copolymer or a graft copolymer. The polymer compound contained in the composition of the present invention is preferably a copolymer composed of a structural unit represented by the formula (1) and a structural unit represented by the formula (3), more preferably an alternating copolymer composed of a structural unit represented by the formula (1) and a structural unit represented by the formula (3), since an organic film transistor produced by using the composition of the present invention is more excellent in electric field effect mobility.

When a group active to the polymerization reaction remains at the molecular chain end of the polymer compound contained in the composition of the present invention, the electric field effect mobility of an organic film transistor produced by using the composition of the present invention possibly lowers. Therefore, it is preferable that the molecular chain end is a stable group such as an aryl group, a monovalent aromatic heterocyclic ring group or the like.

### <Production method of polymer compound contained in composition>

Next, the method of producing the polymer compound contained in the composition of the present invention will be illustrated.

The polymer compound contained in the composition of the present invention may be produced by any method, and for example, a compound represented by the formula: X²¹-A¹¹-X²² and a compound represented by the formula: X²³-A¹²-X²⁴ are, if necessary dissolved in an organic solvent, if necessary with addition of a base, and subjected to a known polymerization method such as aryl coupling and the like using a suitable catalyst, thus, the polymer compound can be synthesized.

A¹¹ represents a structural unit represented by the formula (1) and A¹² represents a structural unit represented by the formula (3). X²¹, X²², X²³ and X²⁴ each independently represent a polymerization reactive group.

The polymerization reactive group includes, for example, a halogen atom, a borate residue, a boric acid residue and an organic tin residue. Here, the boric acid residue denotes a group represented by -B(OH)₂.

The organic tin residue includes organic tin residues substituted with three alkyl groups or three cycloalkyl groups (for example, a trialkylstannyl group or a tricycloalkylstannyl group).

The halogen atom as the polymerization reactive group includes, for example, a fluorine atom, a chlorine atom, a bromine atom and an iodine atom.

The borate residue as the polymerization reactive group includes, for example, groups represented by the following formulae.

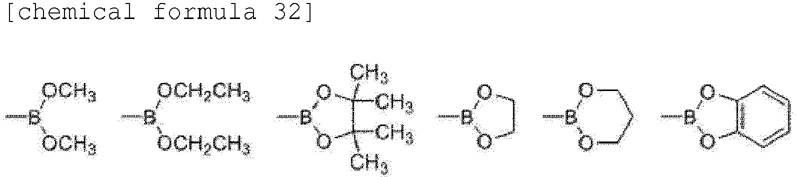

The organic tin residue substituted with three alkyl groups as the polymerization reactive group includes, for example, an organic tin residue substituted with three methyl groups (a trimethylstannyl group) and an organic tin residue substituted with three butyl groups (a tributylstannyl group).

The organic tin residue substituted with a cycloalkyl group includes a tricyclohexylstannyl group.

The above-described polymerization method such as aryl coupling and the like includes, for example, a method of polymerization by the Suzuki coupling reaction (Chemical Review, 1995, vol. 95, pp. 2457-2483) and a method of polymerization by the Stille coupling reaction (European Polymer Journal, 2005, vol. 41, pp. 2923-2933).

The polymerization reactive group is preferably a halogen atom, a borate residue or a boric acid residue in the case of use of a nickel catalyst or a palladium catalyst such as in the Suzuki coupling reaction and the like, and preferably a bromine atom, an iodine atom or a borate residue since the polymerization reaction becomes simple.

When the polymer compound contained in the composition of the present invention is polymerized by the Suzuki coupling reaction, the ratio of the total number of moles of a bromine atom and an iodine atom as the above-described polymerization reactive group to the total number of moles of a borate residue as the above-described polymerization reactive group is preferably 0.7 to 1.3, more preferably 0.8 to 1.2.

The polymerization reactive group is preferably a halogen atom, or an organic tin residue substituted with three alkyl groups or three cycloalkyl groups in the case of use of a palladium catalyst such as in the Stille coupling reaction and the like, and preferably a bromine atom, an iodine atom, or an organic tin residue substituted with three alkyl groups or three cycloalkyl groups since the polymerization reaction becomes simple.

When the polymer compound contained in the composition of the present invention is polymerized by the Stille coupling reaction, the ratio of the total number of moles of a bromine atom and an iodine atom as the above-described polymerization reactive group to the total number of moles of an organic tin residue (preferably, an organic tin residue substituted with three alkyl groups or three cycloalkyl groups) as the above-described polymerization reactive group is preferably 0.7 to 1.3, more preferably 0.8 to 1.2.

The organic solvent used in polymerization includes, for example, benzene, toluene, xylene, chlorobenzene, dichlorobenzene, tetrahydrofuran and dioxane. These organic solvents may be used each singly or in combination of two or more.

The base used in polymerization includes, for example, inorganic bases such as sodium carbonate, potassium carbonate, cesium carbonate, potassium fluoride, cesium fluoride, tripotassium phosphate and the like, and organic bases such as tetrabutylammonium fluoride, tetrabutylammonium chloride, tetrabutylammonium bromide, tetraethylammonium hydroxide, tetrabutylammonium hydroxide and the like.

The catalyst used for polymerization is preferably a catalyst composed of a transition metal complex such as a palladium complex such as tetrakis(triphenylphosphine)palladium, tris(dibenzylideneacetone)dipalladium, palladium acetate, dichlorobistriphenylphosphinepalladium and the like, and if necessary, of a ligand such as triphenylphosphine, tri-tert-butylphosphine, tricyclohexylphosphine and the like. As these catalysts, those synthesized previously may be used or those prepared in the reaction system may be used as they are. These catalysts may be used each singly or in combination of two or more.

The reaction temperature of polymerization is preferably 0 to 200°C, more preferably 0 to 150°C, further preferably 0 to 120°C.

The reaction time of polymerization is usually 1 hour or more, preferably 2 to 500 hours.

The post treatment of polymerization can be conducted by a known method, and there are, for example, methods in which the reaction solution obtained in the above-described polymerization is added to a lower alcohol such as methanol and the like to deposit a precipitate which is then filtrated and dried.

When the purity of the polymer compound contained in the composition of the present invention is low, it is preferable that the polymer compound is purified by a method such as recrystallization, continuous extraction by a Soxhlet extractor, column chromatography and the like.

The compound represented by the formula (11) can be suitably used as the raw material of the polymer compound contained in the composition of the present invention, in the above-described polymer compound production method.

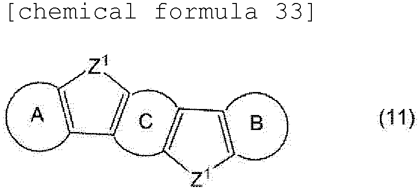

In the formula (11), Ring A, Ring B, Ring C and Z¹ represent the same meaning as described above.

In the formula (11), Ring A and Ring B preferably have a borate residue, a boric acid residue or an organic tin residue.

The compound represented by the formula (11) is preferably a compound represented by the formula (11-1), a compound represented by the formula (11-2) or a compound represented by the formula (11-3), since synthesis of the compound represented by the formula (11) is easy.

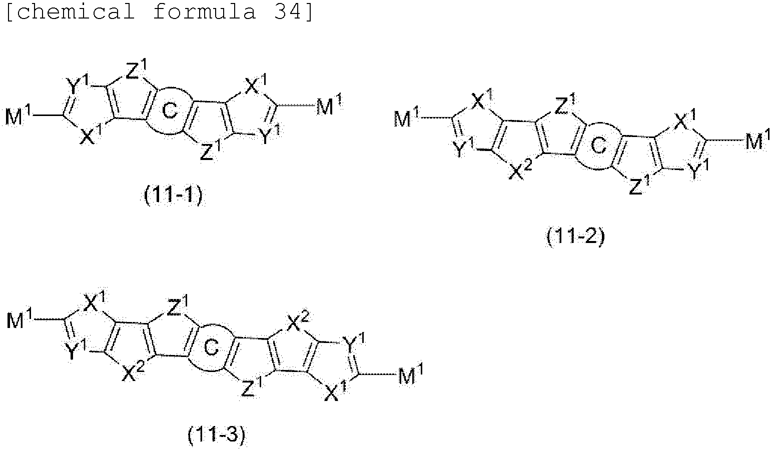

In the formula (11-1) to the formula (11-3), Ring C, Z¹, X¹, X² and Y¹ represent the same meaning as described above. M¹ represents a borate residue, a boric acid residue or an organic tin residue. A plurality of M¹ may be the same or different.

The definition and specific examples of the borate residue, the boric acid residue or the organic tin residue are the same as the definition and specific examples of the borate residue, the boric acid residue or the organic tin residue as the above-described polymerization reactive group.

The compound represented by the formula (11) (may also be a compound represented by the formula (11-1) to the formula (11-3)) includes, for example, compounds represented by the formula (5a-11-1) to the formula (5a-11-10), the formula (5a-12-1) to the formula (5a-12-10) and the formula (5a-13-1) to the formula (5a-13-10), and a compound represented by the formula (5a-11-1), the formula (5a-11-2), the formula (5a-11-3), the formula (5a-12-1), the formula (5a-12-3), the formula (5a-12-5), the formula (5a-13-1), the formula (5a-13-3) or the formula (5a-13-5) is preferable, a compound represented by the formula (5a-11-1), the formula (5a-11-2), the formula (5a-11-3), the formula (5a-12-1), the formula (5a-12-3), the formula (5a-13-1) or the formula (5a-13-3) is more preferable, a compound represented by the formula (5a-11-1), the formula (5a-11-2) or the formula (5a-11-3) is further preferable, since synthesis of the compound represented by the formula (11) is easy.

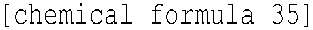

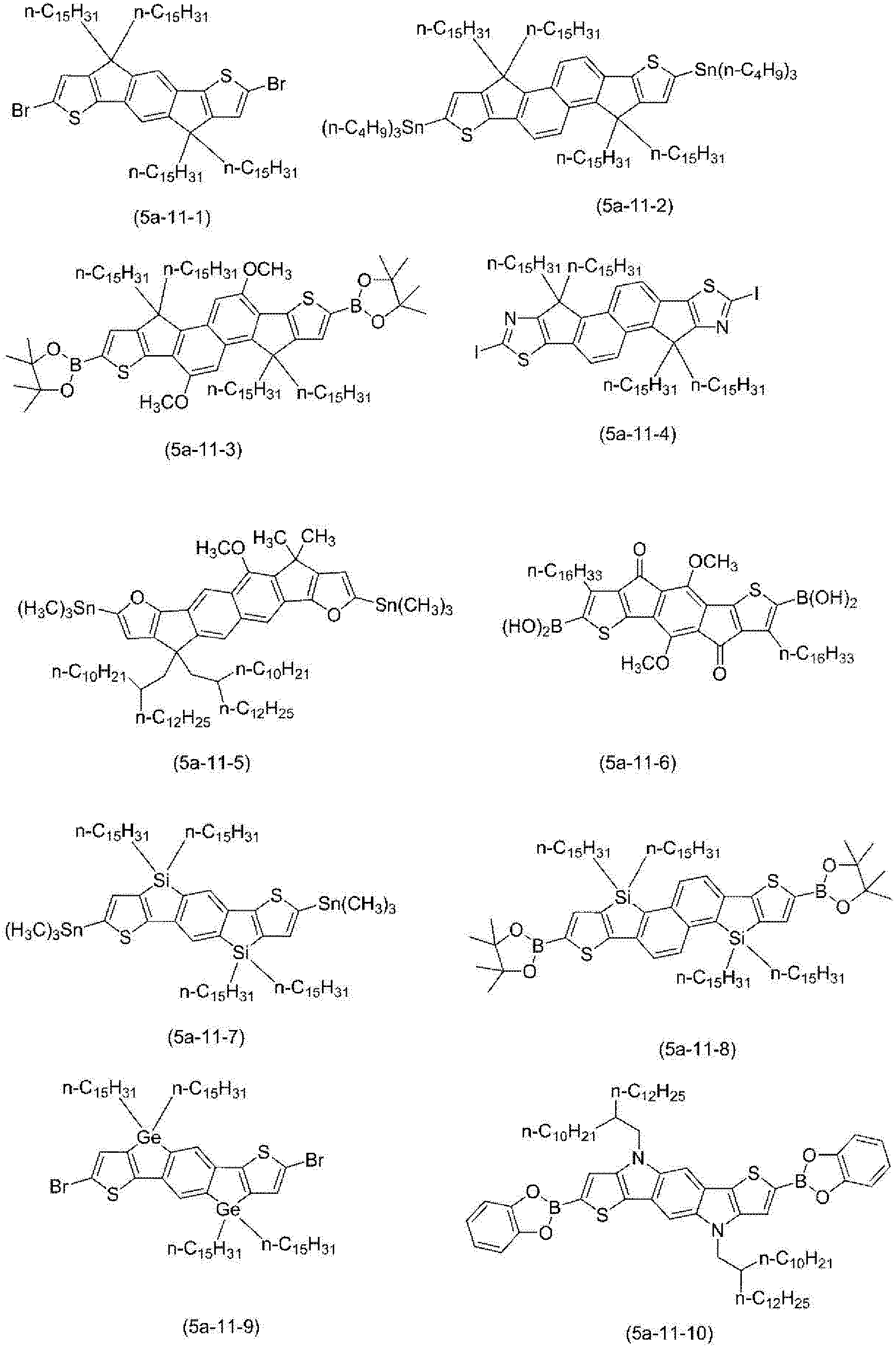

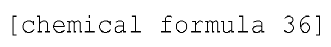

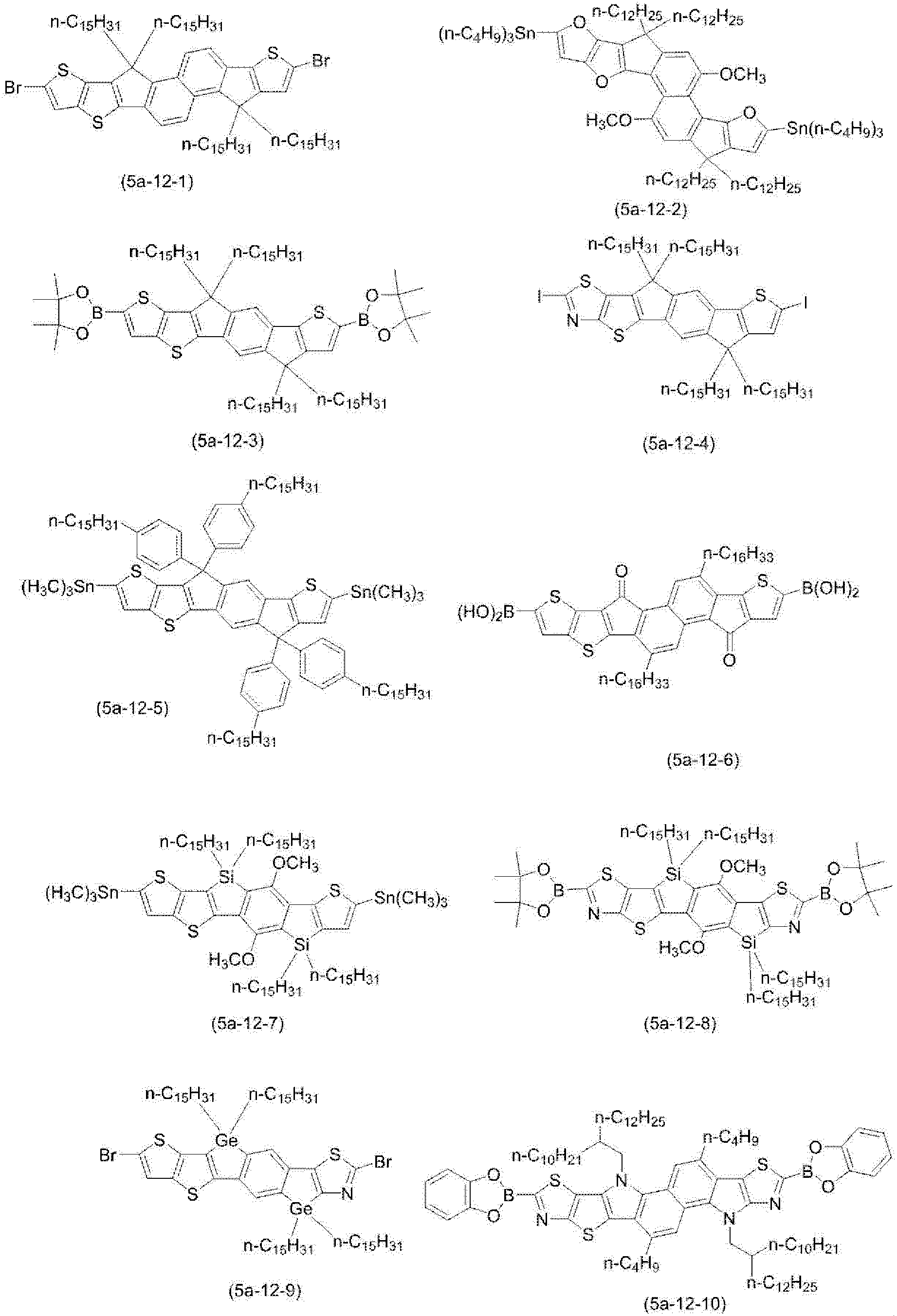

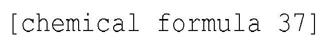

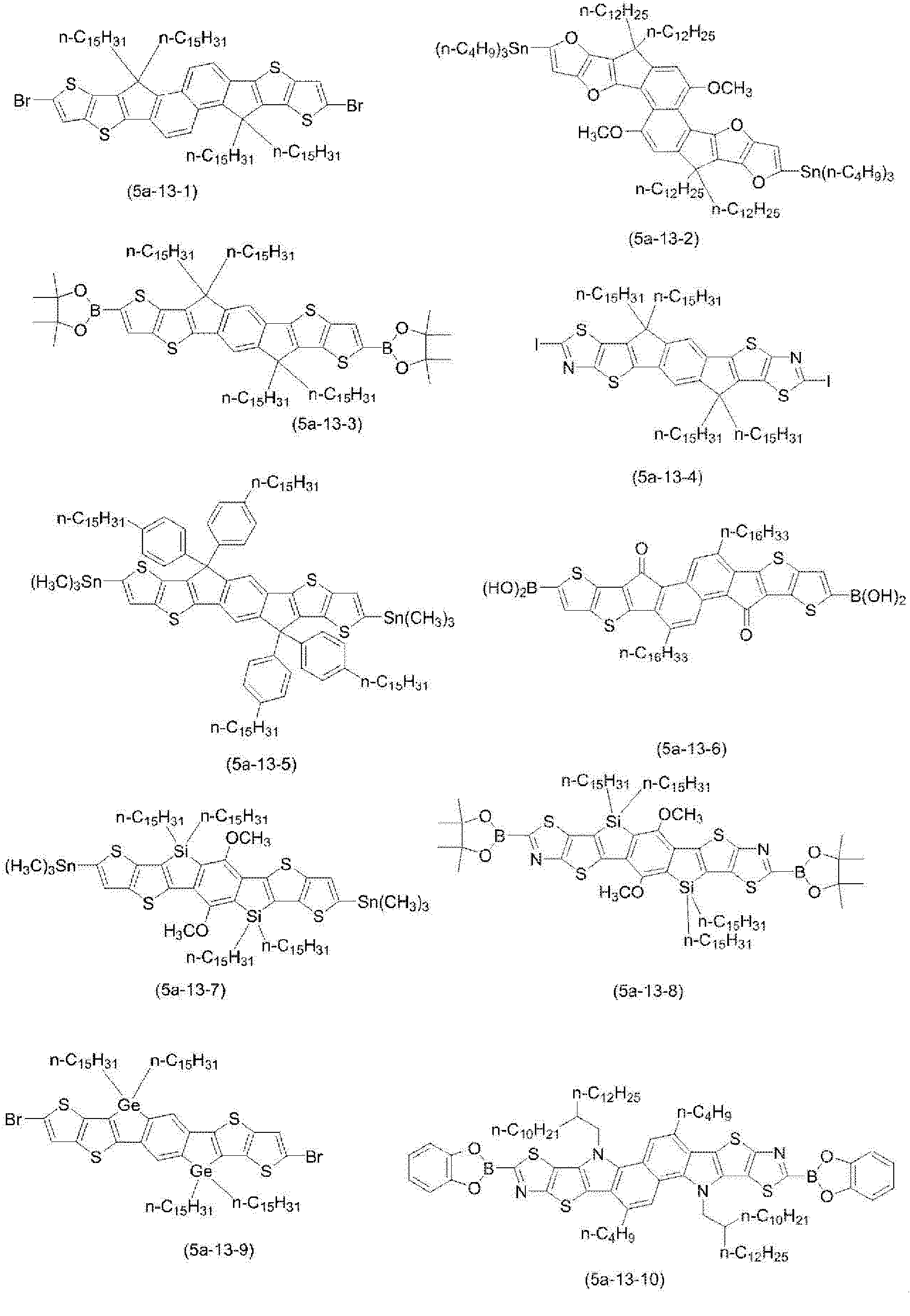

Next, the method of producing the compound represented by the formula (11) is explained.

The compound represented by the formula (11) may be produced by any method, and for example, can be produced by a bromination reaction, the Suzuki coupling reaction, the Wolff-Kishner reduction reaction, the Buchwald-Hartwig amination reaction and an oxidative cyclization reaction, as explained below.

When Z¹ is a group represented by the formula (Z-5), the compound can be produced, for example, by
a first step of reacting a compound represented by the formula (S1), a compound represented by the formula (S2) and a compound represented by the formula (S3) by the Suzuki coupling reaction, and
a second step of intramolecularly cyclizing a compound represented by the formula (S4) obtained in the first step.

In this case, the resultant compound is a compound represented by the formula (S5). Then, the compound represented by the formula (S5) (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (11).

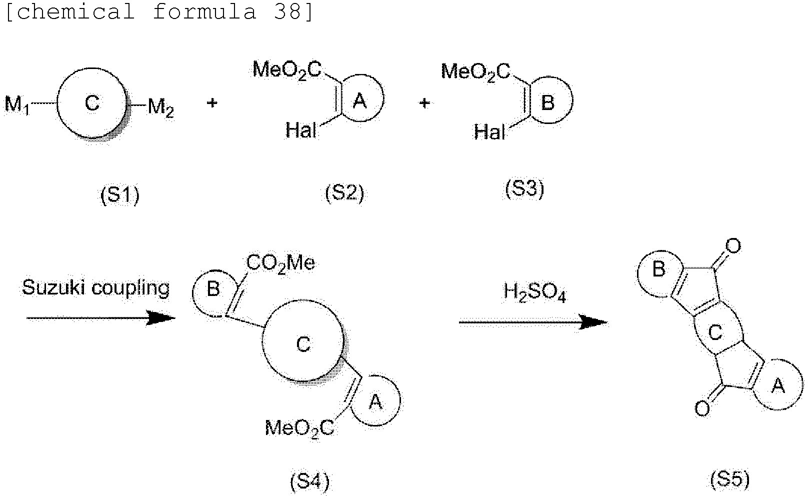

In the formulae (S1) to (S5), Ring A, Ring B and Ring C represent the same meaning as described above. M₁ and M₂ each independently represent a borate residue or a boric acid residue (a group represented by -B(OH)₂). Hal represents an iodine atom, a bromine atom or a chlorine atom. Hal in the formula (S2) and Hal in the formula (S3) may be the same or different.

When Z¹ is a group represented by the formula (Z-1), the compound can be produced, for example, by
a first step of reacting a compound represented by the formula (S5) described above by the Wolff-Kishner reduction reaction, and
a second step of reacting a compound represented by the formula (S6) obtained in the first step, a base such as a sodium alkoxide and the like, and an alkyl halide.

In this case, the resultant compound is a compound represented by the formula (S7). Then, the compound represented by the formula (S7) (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (11).

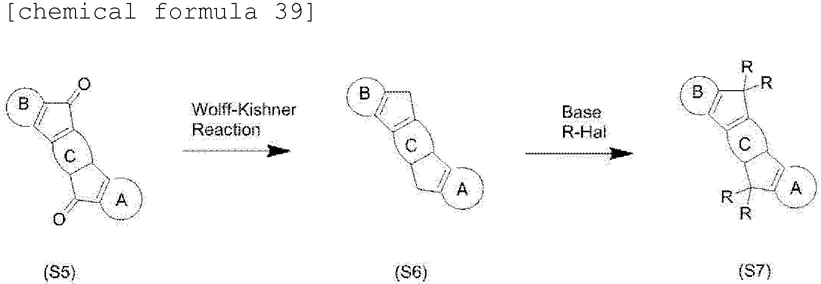

In the formulae (S5) to (S7), Ring A, Ring B, Ring C and Hal represent the same meaning as described above. R represents an alkyl group, a cycloalkyl group, an alkoxy group, a cycloalkoxy group, an alkylthio group, a cycloalkylthio group, an aryl group or a monovalent heterocyclic ring group, and these groups may have a substituent. A plurality of R may be mutually the same or different.

When Z¹ and Z² are a group represented by the formula (Z-1), the compound can be produced, in addition, by
a first step of reacting a compound represented by the formula (S1), a compound represented by the formula (S8) and a compound represented by the formula (S9) by the Suzuki coupling reaction,
a second step of reacting a compound represented by the formula (S10) obtained in the first step with butyllithium to cause lithiation, and further, reacting with a ketone, and
a third step of reacting a compound represented by the formula (S11) obtained in the second step with an acid such as trifluoroboric acid, sulfuric acid or the like to cause cyclization.

In this case, the resultant compound is a compound represented by the formula (S7). Then, the compound represented by the formula (S7) (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (11).

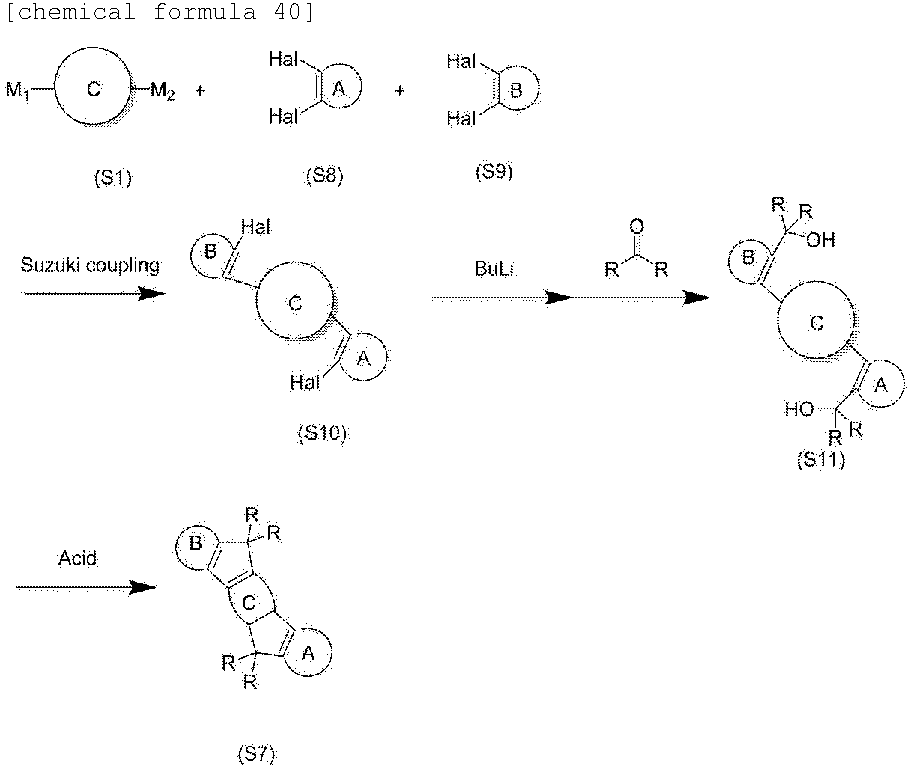

In the formulae (S1) and (S7) to (S11), R, M₁, M₂, Ring A, Ring B, Ring C and Hal represent the same meaning as described above. A plurality of Hal present in the formula (S8) may be the same or different, a plurality of Hal present in the formula (S9) may be the same or different, and Hal in the formula (S8) and Hal in the formula (S9) may be the same or different.

When Z¹ is a group represented by the formula (Z-2) or the formula (Z-3), the compound can be produced, for example, by
a first step of reacting a compound represented by the formula (S10) described above with a halogenating agent such as N-bromosuccinimide and the like, and
a second step of reacting a compound represented by the formula (S12) obtained in the first step with butyllithium to cause lithiation, and further, reacting with a compound represented by the formula: R₂ECl₂, and the like.

In this case, the resultant compound is a compound represented by the formula (S13). Then, the compound represented by the formula (S13) (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (11).

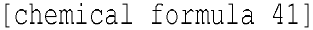

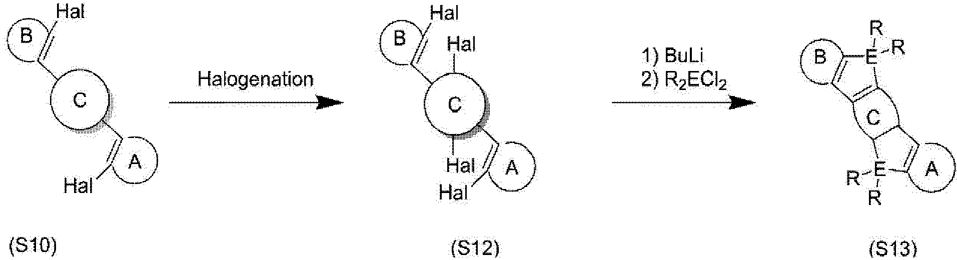

In the formulae (S10), (S12) and (S13), R, Ring A, Ring B, Ring C and Hal represent the same meaning as described above. E represents a silicon atom or a germanium atom. A plurality of Hal present in the formula (S10) may be the same or different, and a plurality of Hal present in the formula (S12) may be the same or different.

When Z¹ is a group represented by the formula (Z-4), the compound can be produced, for example, by
reacting a compound represented by the formula (S12) described above and a compound represented by the formula (S14) according to the Buchwald-Hartwig amination reaction. In this case, the resultant compound is a compound represented by the formula (S15). Then, the compound represented by the formula (S15) (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (11).

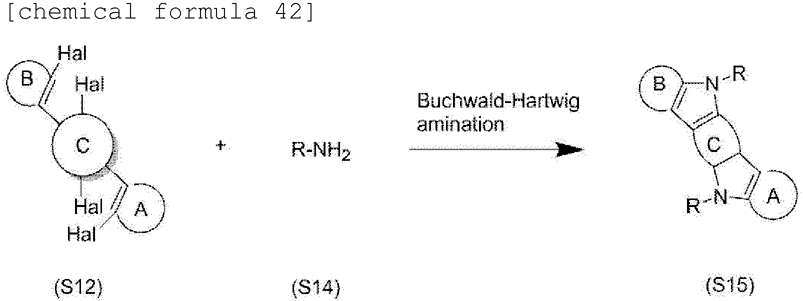

In the formulae (S12), (S14) and (S15), R, Ring A, Ring B, Ring C and Hal represent the same meaning as described above. A plurality of Hal present in the formula (S12) may be the same or different.

When Z¹ is a group represented by the formula (Z-1), the compound can be produced, in addition, by
a first step of reacting a compound represented by the formula (S16), a compound represented by the formula (S19) and a compound represented by the formula (S20) according to the Suzuki coupling reaction, and
a second step of intramolecularly cyclizing a compound represented by the formula (S21) obtained in the first step.

In this case, the resultant compound is a compound represented by the formula (S7). Then, the compound represented by the formula (S7) (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (11).

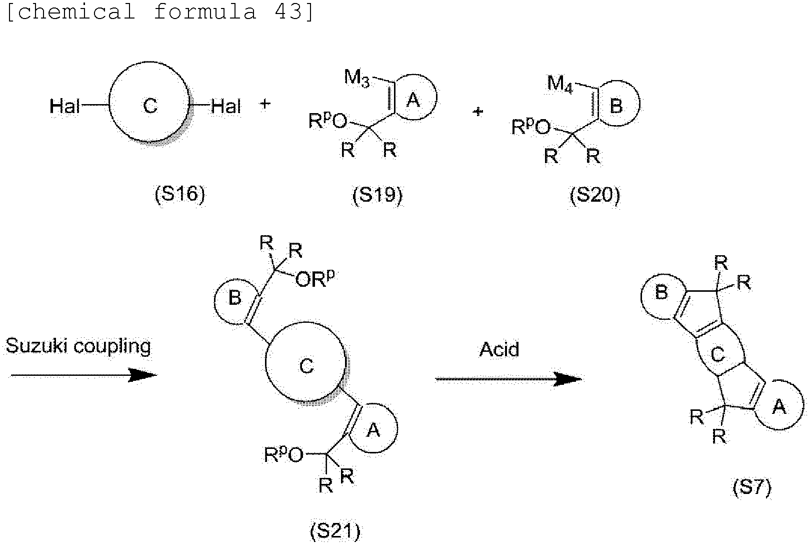

In the formulae (S7), (S16), (S19), (S20) and (S21), R, Ring A, Ring B and Hal represent the same meaning as described above. M₃ and M₄ each independently represent a borate residue or a boric acid residue (a group represented by -B(OH)₂). R^{p} represents an alkyl group, a silyl group or an acetyl group. A plurality of Hal present in the formula (S24) may be the same or different. R^{p} in the formula (S19) and R^{p} in the formula (S20) may be the same or different.

The compound represented by the formula (11) can also be synthesized, for example, according to methods described in JP-A No. 2009-155648, JP-A No. 2009-209134, Japanese Patent Application National Publication No. 2012-500308, Japanese Patent Application National Publication No. 2013-501076 and International Publication WO2013/010614.

### <Compound>

The compound contained in the composition of the present invention is a compound represented by the formula (2).

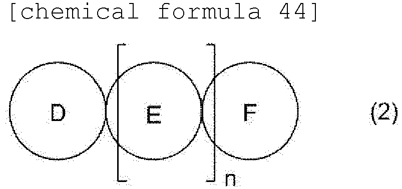

In the formula (2), n represents an integer of 1 or more. n is preferably an integer of 2 to 8, more preferably an integer of 2 to 6, further preferably an integer of 2 to 4, since an organic film transistor produced by using the composition of the present invention is more excellent in electric field effect mobility.

In the formula (2), Ring D and Ring F each independently represent a benzene ring, a 5-membered heterocyclic ring or a 6-membered heterocyclic ring, and these rings may have a substituent. Ring D and Ring F are preferably a 5-membered heterocyclic ring or a benzene ring, more preferably a benzene ring, since an organic film transistor produced by using the composition of the present invention is more excellent in electric field effect mobility.

The hetero atom which a 5-membered heterocyclic ring and a 6-membered heterocyclic ring have includes, for example, an oxygen atom, a sulfur atom, a fluorine atom, a nitrogen atom, a phosphorus atom and a silicon atom, and an oxygen atom, a sulfur atom, a nitrogen atom or a silicon atom is preferable and a sulfur atom is more preferable, since an organic film transistor produced by using the composition of the present invention is more excellent in electric field effect mobility.

The 5-membered heterocyclic ring and the 6-membered heterocyclic ring include, for example, a furan ring, a thiophene ring, a selenophene ring, a pyrrole ring, an oxazole ring, a thiazole ring, an imidazole ring and a pyridine ring, and a furan ring, a thiophene ring or a thiazole ring is preferable, a thiophene ring or a thiazole ring is more preferable and a thiophene ring is further preferable, since an organic film transistor produced by using the composition of the present invention is more excellent in electric field effect mobility.

The substituent which the benzene ring, the 5-membered heterocyclic ring and the 6-membered heterocyclic ring represented by Ring D and Ring F may have includes, for example, an alkyl group, a cycloalkyl group, an alkoxy group, a cycloalkoxy group, an alkylthio group, a cycloalkylthio group, an aryl group, a monovalent heterocyclic ring group, a halogen atom, a silyl group, an amino group, an alkenyl group, a cycloalkenyl group, an alkynyl group, a cycloalkynyl group, a hydroxyl group, a nitro group, a cyano group, a carboxyl group, an alkylcarbonyl group, a cycloalkylcarbonyl group, an alkoxycarbonyl group or a cycloalkoxycarbonyl group, and the definition and specific examples of these substituents are the same as the definition and specific examples of the alkyl group, the cycloalkyl group, the alkoxy group, the cycloalkoxy group, the alkylthio group, the cycloalkylthio group, the aryl group, the monovalent heterocyclic ring group, the halogen atom, the silyl group, the amino group, the alkenyl group, the cycloalkenyl group, the alkynyl group, the cycloalkynyl group, the alkylcarbonyl group, the cycloalkylcarbonyl group, the alkoxycarbonyl group and the cycloalkoxycarbonyl group as the substituent which the heterocyclic ring represented by Ring A and Ring B may have described above.

In the formula (2), Ring E represents a benzene ring, a cyclopentadiene ring, a 5-membered heterocyclic ring or a 6-membered heterocyclic ring, and these rings may have a substituent. When there are a plurality of Rings E, they may be the same or different. Ring E is preferably a cyclopentadiene ring, a benzene ring or a thiophene ring, more preferably a benzene ring or a thiophene ring, since an organic film transistor produced by using the composition of the present invention is more excellent in electric field effect mobility.

The definition and specific examples of the 5-membered heterocyclic ring and the 6-membered heterocyclic ring represented by Ring E are the same as the definition and specific examples of the 5-membered heterocyclic ring and the 6-membered heterocyclic ring represented by Ring D and Ring F.

The substituent which the benzene ring, the cyclopentadiene ring, the 5-membered heterocyclic ring and the 6-membered heterocyclic ring represented by Ring E may have includes, for example, an alkyl group, a cycloalkyl group, an alkoxy group, a cycloalkoxy group, an alkylthio group, a cycloalkylthio group, an aryl group, a monovalent heterocyclic ring group, a halogen atom, a silyl group, an amino group, an alkenyl group, a cycloalkenyl group, an alkynyl group, a cycloalkynyl group, a hydroxyl group, a nitro group, a cyano group, a carboxyl group, an alkylcarbonyl group, a cycloalkylcarbonyl group, an alkoxycarbonyl group or a cycloalkoxycarbonyl group, and the definition and specific examples of these substituents are the same as the definition and specific examples of the alkyl group, the cycloalkyl group, the alkoxy group, the cycloalkoxy group, the alkylthio group, the cycloalkylthio group, the aryl group, the monovalent heterocyclic ring group, the halogen atom, the silyl group, the amino group, the alkenyl group, the cycloalkenyl group, the alkynyl group, the cycloalkynyl group, the alkylcarbonyl group, the cycloalkylcarbonyl group, the alkoxycarbonyl group and the cycloalkoxycarbonyl group as the substituent which the heterocyclic ring represented by Ring A and Ring B may have described above.

It is preferable that at least one ring among Ring D, Ring E and Ring F is a thiophene ring, since an organic film transistor produced by using the composition of the present invention is more excellent in electric field effect mobility.

The compound represented by the formula (2) is preferably a compound represented by the formula (2-1) to the formula (2-14), more preferably a compound represented by the formula (2-1), the formula (2-4), the formula (2-5), the formula (2-6), the formula (2-9), the formula (2-11) or the formula (2-12), further preferably a compound represented by the formula (2-4), the formula (2-6), the formula (2-9) or the formula (2-11), particularly preferably a compound represented by the formula (2-4) or the formula (2-6), since an organic film transistor produced by using the composition of the present invention is more excellent in electric field effect mobility.

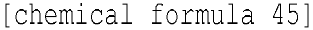

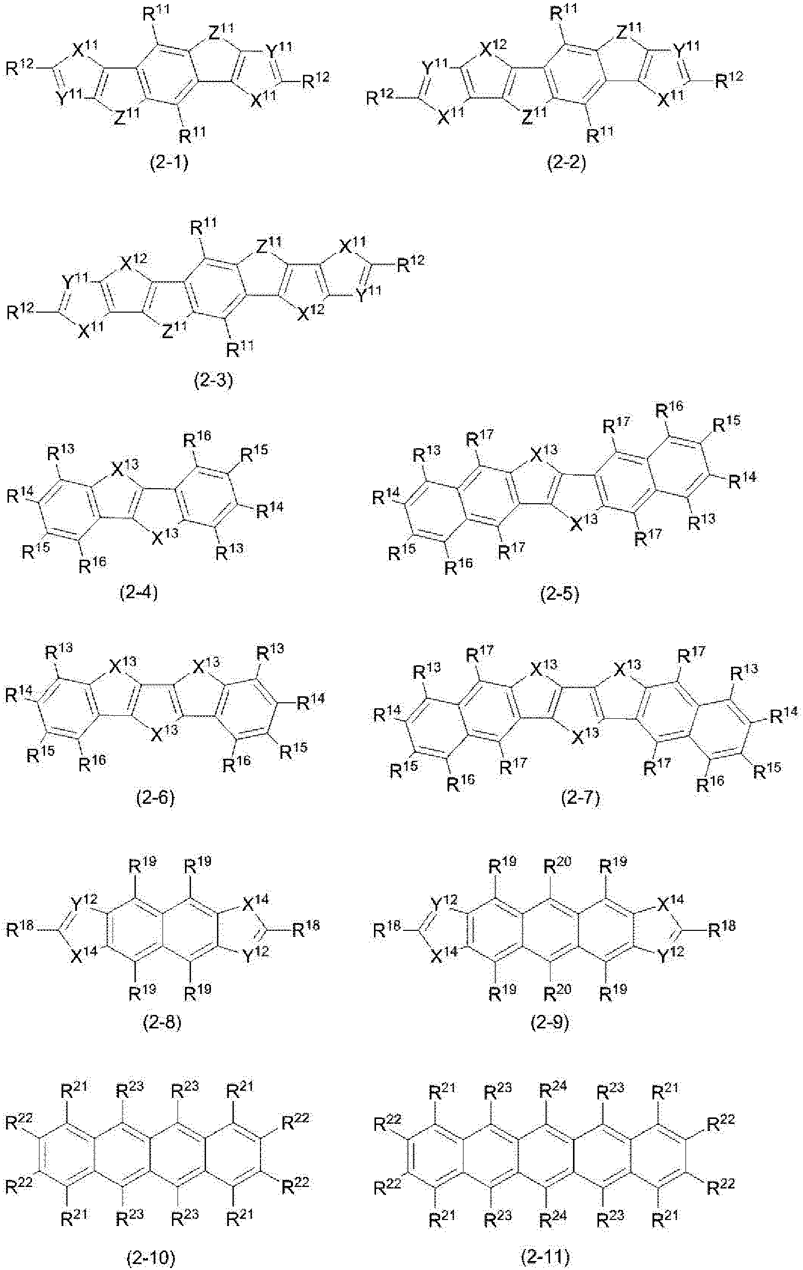

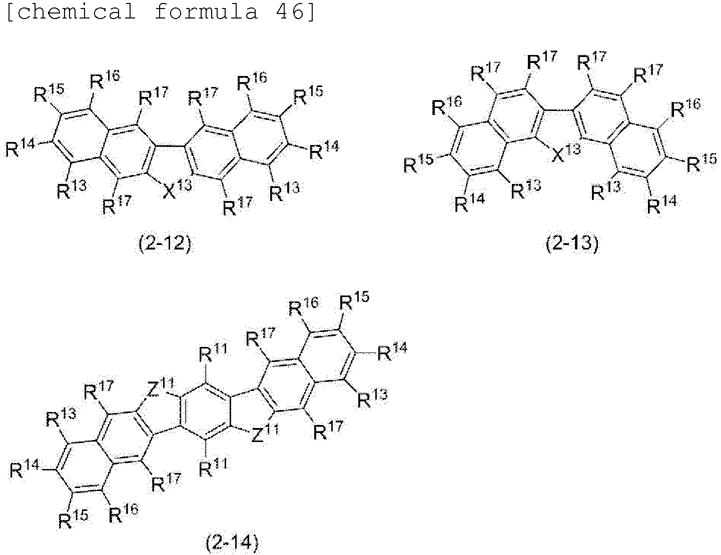

In the formula (2-1) to the formula (2-14), Z¹¹ represents a group represented by the formula (Z-1'), a group represented by the formula (Z-2'), a group represented by the formula (Z-3'), a group represented by the formula (Z-4') or a group represented by the formula (Z-5'). A plurality of Z¹¹ may be mutually the same or different. 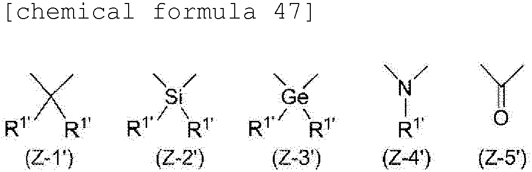 [wherein R¹' represents an alkyl group, a cycloalkyl group, an alkoxy group, a cycloalkoxy group, an alkylthio group, a cycloalkylthio group, an aryl group or a monovalent heterocyclic ring group, and these groups may have a substituent. When there are a plurality of R¹', they may be the same or different.].

Z¹ is preferably a group represented by the formula (Z-1') or the formula (Z-2'), more preferably a group represented by the formula (Z-1'), since an organic film transistor produced by using the composition of the present invention is more

### excellent in electric field effect mobility.

In the formula (Z-1') to the formula (Z-5'), R¹' represents an alkyl group, a cycloalkyl group, an alkoxy group, a cycloalkoxy group, an alkylthio group, a cycloalkylthio group, an aryl group or a monovalent heterocyclic ring group, and these groups may have a substituent.

The definition and specific examples of the alkyl group, the cycloalkyl group, the alkoxy group, the cycloalkoxy group, the alkylthio group, the cycloalkylthio group, the aryl group and the monovalent heterocyclic ring group are the same as the definition and specific examples of the alkyl group, the cycloalkyl group, the alkoxy group, the cycloalkoxy group, the alkylthio group, the cycloalkylthio group, the aryl group and the monovalent heterocyclic ring group as the substituent which the heterocyclic ring may have described above.

R¹' is preferably an alkyl group, a cycloalkyl group or an aryl group, since an organic film transistor produced by using the composition of the present invention is more excellent in electric field effect mobility.

Z¹¹ is preferably a group represented by the formula (Z-1') or the formula (Z-2'), more preferably a group represented by the formula (Z-1'), since an organic film transistor produced by using the composition of the present invention is more excellent in electric field effect mobility.

In the formula (2-1) to the formula (2-14), X¹¹, X¹², X¹³ and X¹⁴ each independently represent an oxygen atom, a sulfur atom or a selenium atom. A plurality of X¹¹, X¹³ and X¹⁴ each may be mutually the same or different. When there are a plurality of X¹², they may be the same or different.

It is preferable that X¹¹, X¹², X¹³ and X¹⁴ are a sulfur atom, since an organic film transistor produced by using the composition of the present invention is more excellent in electric field effect mobility.

In the formula (2-1) to the formula (2-14), Y¹¹ and Y¹² each independently represent a nitrogen atom or a group represented by -CR²' =. R²' represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent. A plurality of Y¹¹ and Y¹² each may be mutually the same or different.

The definition and specific examples of the alkyl group, the cycloalkyl group, the alkoxy group, the cycloalkoxy group, the alkylthio group, the cycloalkylthio group, the aryl group and the monovalent heterocyclic ring group are the same as the definition and specific examples of the alkyl group, the cycloalkyl group, the alkoxy group, the cycloalkoxy group, the alkylthio group, the cycloalkylthio group, the aryl group and the monovalent heterocyclic ring group as the substituent which the heterocyclic ring may have described above.

R²' is preferably a hydrogen atom, an alkyl group, a cycloalkyl group, an alkoxy group, a cycloalkoxy group or a halogen atom, more preferably a hydrogen atom, an alkyl group, a cycloalkyl group or a halogen atom, since synthesis of the compound represented by the formula (2) contained in the composition of the present invention is easy.

Y¹¹ and Y¹² are preferably a group represented by -CR²' =, more preferably a group represented by -CH=, since synthesis of the compound contained in the composition of the present invention is easy.

In the formula (2-1) to the formula (2-14), R¹¹, R¹², R¹³, R¹⁴, R¹⁵, R¹⁶, R¹⁷, R¹⁸, R¹⁹, R²⁰, R²¹, R²², R²³ and R²⁴ each independently represent a hydrogen atom, an alkyl group, a cycloalkyl group, an alkoxy group, a cycloalkoxy group, an alkylthio group, a cycloalkylthio group, an aryl group, an alkynyl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group, the alkynyl group and the monovalent heterocyclic ring group each may have a substituent. A plurality of R¹¹, R¹², R¹³, R¹⁴, R¹⁵, R¹⁶, R¹⁷, R¹⁸, R¹⁹, R²⁰, R²¹, R²², R²³ and R²⁴ each may be mutually the same or different.

The definition and specific examples of the alkyl group, the cycloalkyl group, the alkoxy group, the cycloalkoxy group, the alkylthio group, the cycloalkylthio group, the aryl group, the alkynyl group and the monovalent heterocyclic ring group are the same as the definition and specific examples of the alkyl group, the cycloalkyl group, the alkoxy group, the cycloalkoxy group, the alkylthio group, the cycloalkylthio group, the aryl group, the alkynyl group and the monovalent heterocyclic ring group as the substituent which the heterocyclic ring represented by Ring A and Ring B may have described above.

The compound represented by the formula (2) (may also be a compound represented by the formula (2-1) to the formula (2-14)) includes, for example, compounds represented by the formula (2-101) to the formula (2-127), and is preferably a compound represented by the formula (2-102), the formula (2-107), the formula (2-108), the formula (2-109), the formula (2-110), the formula (2-111), the formula (2-114), the formula (2-118), the formula (2-120), the formula (2-121) or the formula (2-122), more preferably a compound represented by the formula (2-107), the formula (2-108), the formula (2-111) or the formula (2-118), further preferably a compound represented by the formula (2-107), the formula (2-108) or the formula (2-111), since an organic film transistor produced by using the composition of the present invention is more excellent in electric field effect mobility.

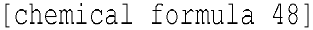

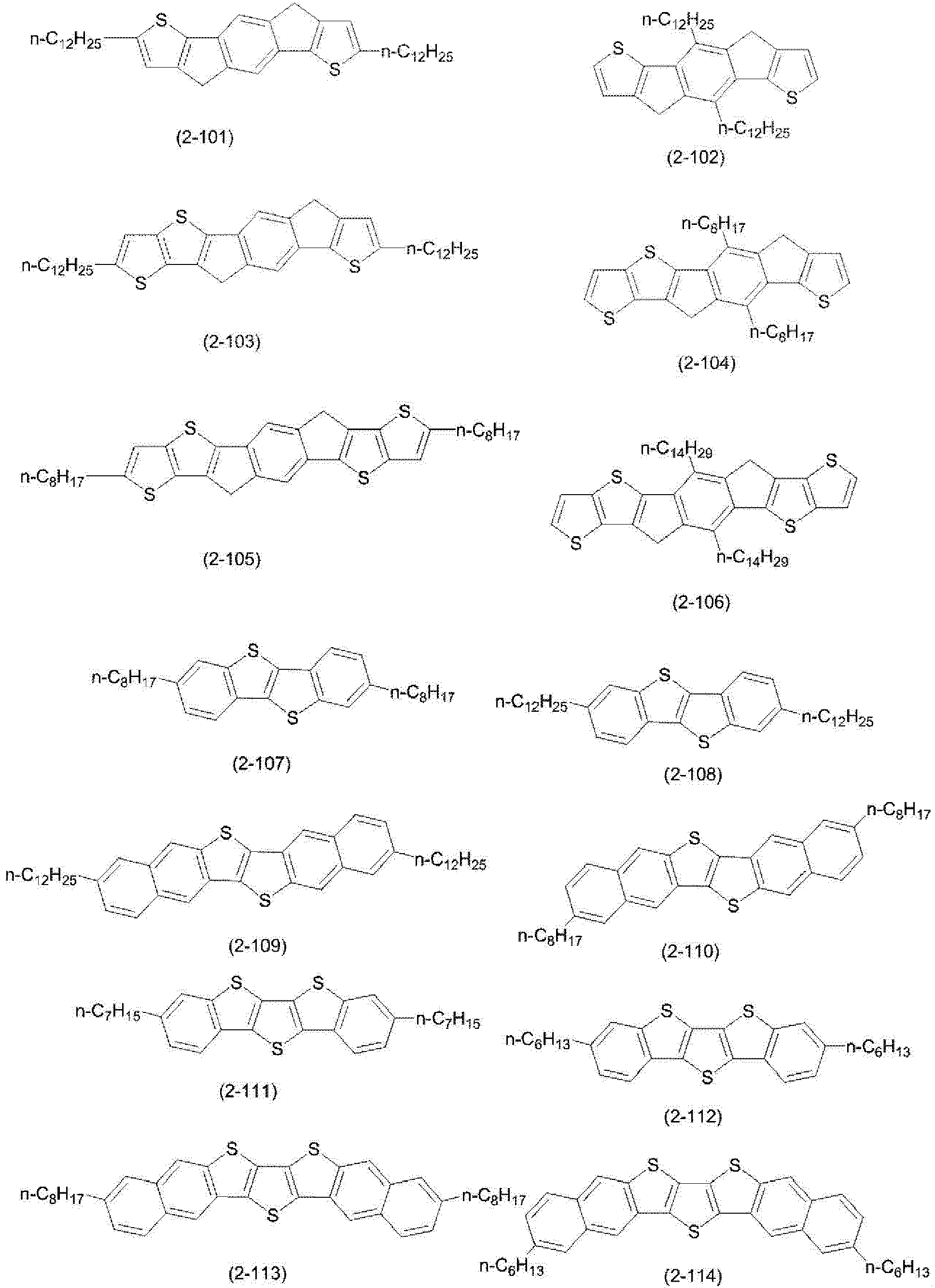

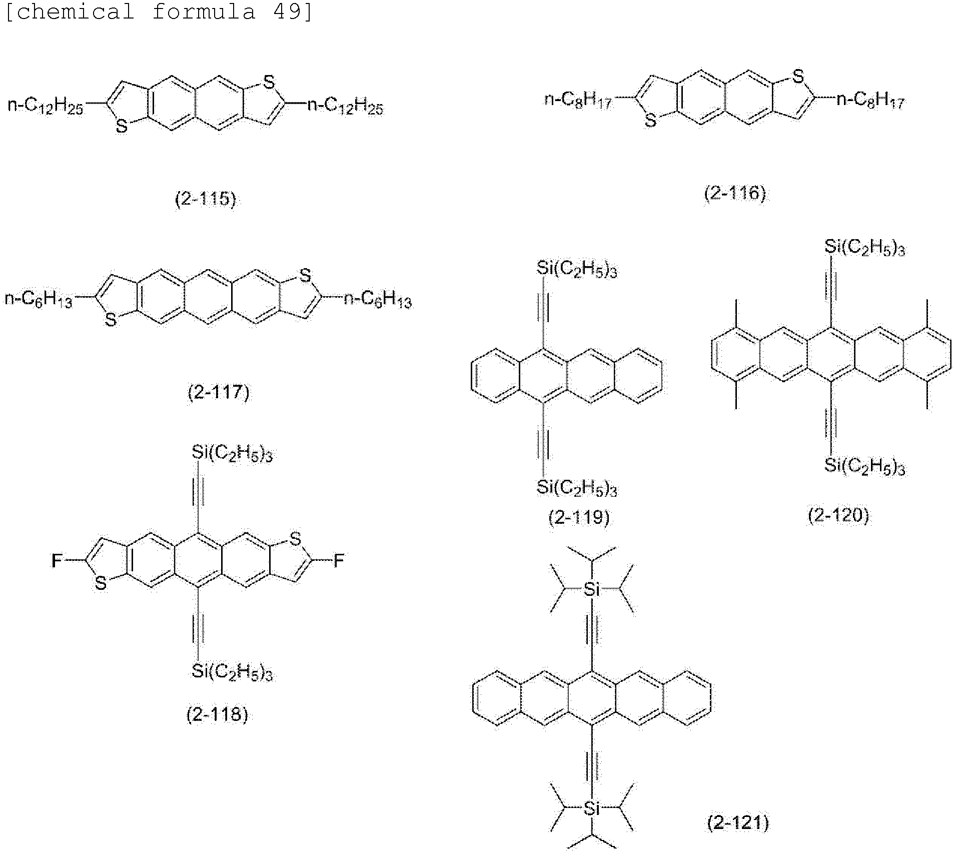

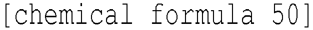

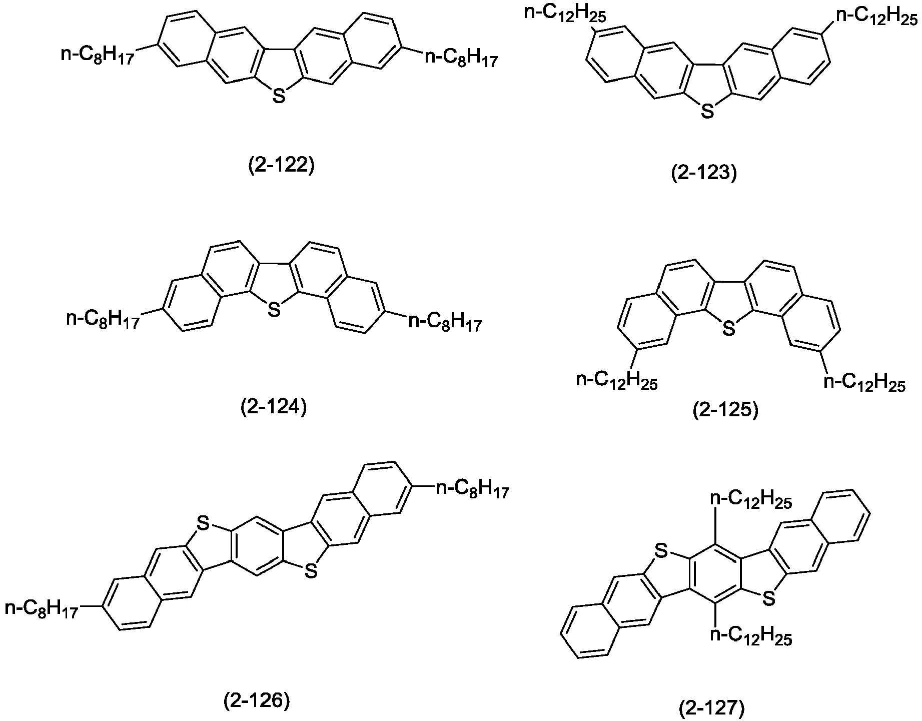

The compound represented by the formula (2) can be synthesized, for example, according to methods described in JP-ANo. 2009-267372, JP-ANo. 2012-39103, JP-ANo. 2009-209134 and Japanese Patent Application National Publication No. 2013-501076.

### <Composition ratio and the like>

The composition of the present invention comprises a polymer compound containing a structural unit represented by the formula (1) and a compound represented by the formula (2). The polymer compound containing a structural unit represented by the formula (1) may be contained singly in the composition of the present invention, or two or more of the polymer compounds may be contained therein. Further, the compound represented by the formula (2) may be contained singly in the composition of the present invention, or two or more of the compounds may be contained therein.

The content of the compound represented by the formula (2) is preferably 5 to 50 parts by mass, more preferably 10 to 40 parts by mass, further preferably 15 to 30 parts by mass, with respect to 100 parts by mass of the sum of the polymer compound containing a structural unit represented by the formula (1) and the compound represented by the formula (2) described above, since an organic film transistor produced by using the composition of the present invention is more excellent in electric field effect mobility.

The composition of the present invention may further contain a compound having carrier transportability (may be a low molecular weight compound or a polymer compound), in addition to the polymer compound containing a structural unit represented by the formula (1) and the compound represented by the formula (2).

The compound having carrier transportability includes low molecular weight compounds such as arylamine derivatives, stilbene derivatives, oligothiophene and derivatives thereof, oxadiazole derivatives, fullerenes and derivatives thereof and the like; polyvinylcarbazole and derivatives thereof, polyaniline and derivatives thereof, polythiophene and derivatives thereof, polypyrrole and derivatives thereof, polyphenylene vinylene and derivatives thereof, polythienylene vinylene and derivatives thereof, polyfluorene and derivatives thereof and the like.

The composition of the present invention may contain, as a polymer binder, a polymer compound different from the polymer compound containing a structural unit represented by the formula (1), for improving its property. As the polymer binder, those not excessively lowering carrier transportability are preferable.

Examples of the polymer binder include poly(N-vinylcarbazole), polyaniline and derivatives thereof, polythiophene and derivatives thereof, poly(p-phenylene vinylene) and derivatives thereof, poly(2,5-thienylene vinylene) and derivatives thereof, polycarbonate, polyacrylate, polymethyl acrylate, polymethyl methacrylate, polystyrene, polyvinyl chloride and polysiloxane.

### <Ink composition>

The composition of the present invention can be prepared in the form of an ink composition, from the standpoint of facilitating works such as application and the like. The ink composition contains, for example, the polymer compound containing a structural unit represented by the formula (1), the compound represented by the formula (2), and a solvent, and may further contain other additives. The suitable solvent includes halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, bromocyclohexane and the like, halogenated unsaturated hydrocarbon solvents such as chlorobenzene, dichlorobenzene, trichlorobenzene and the like, and additionally, tetrahydrofuran, tetrahydropyran, dioxane, toluene, xylene, mesitylene, tetralin, decalin, bicyclohexyl, cyclohexylbenzene and cyclohexane. It is preferable that the polymer compound containing a structural unit represented by the formula (1) and the compound represented by the formula (2) are those which can be dissolved at a concentration of 0.1% by weight or more in these solvents.

It is preferable that the ink composition manifests suitable viscosity for an application method as described later. The viscosity of the ink composition according to a suitable embodiment can be controlled in a wide range by adjusting the composition ratio of a polymer compound containing a structural unit represented by the formula (1) to a compound represented by the formula (2).

Thus, the viscosity of the ink composition can be controlled without depending on the kind and the amount of a solvent, resulting in an increase in the degree of freedom of selection of a solvent. For example, even for a substrate having large surface free energy and on which application is usually difficult due to too large contact angle to an application solution (for example, 90 degree or more), an organic film can be formed thereon by performing suitable adjustment, since the ink composition can be prepared with high degree of freedom. As a result, according to the ink composition of the present embodiment, it becomes possible to successfully form an organic film which is approximately uniform and having high carrier transportability, in production of an organic semiconductor device.

### <Organic film>

Next, the organic film containing the composition of the present invention will be illustrated referring to an organic film obtained by using the ink composition described above, by way of example.

The organic film is a film largely constituted of a polymer compound containing a structural unit represented by the formula (1) and a compound represented by the formula (2) contained in the composition of the present invention, and may partially contain a solvent and other unavoidable components contained in the ink composition. The thickness of the organic film is preferably 1 nm to 100 µm, more preferably 2 nm to 1000 nm, further preferably 5 nm to 500 nm, particularly preferably 20 nm to 200 nm. According to the organic film having such a thickness, an organic semiconductor device having excellent carrier transportability and sufficient also in strength and the like can be formed.

The organic film can be formed by applying the ink composition described above on a prescribed substrate, and the like. The method of applying the ink composition includes application methods such as, for example, a spin coat method, a casting method, a push coat method, a micro gravure coat method, a gravure coat method, a bar coat method, a roll coat method, a wire bar coat method, a dip coat method, a spray coat method, a screen printing method, a flexo printing method, an offset printing method, an inkjet printing method, a dispenser printing method, a micro contact printing method, a nozzle coat method and a capillary coat method. Of them, a spin coat method, a push coat method, a gravure coat method, a screen printing method, a flexo printing method, an offset printing method, an inkjet printing method, a dispenser printing method, a micro contact printing method, a nozzle coat method or a capillary coat method is preferable.

Application may be conducted also under heated condition. By this, an ink composition having high concentration can be applied, a more uniform organic film can be formed, and additionally, materials of which application at room temperature has been difficult can be selected and used. Application under heated condition can be attained, for example, by using an ink composition heated previously or by performing application while heating a substrate.

The viscosity of the ink composition which is suitable for the above-described application method is, for example, in a gravure coat method, preferably 0.01 to 1 Pa·s, more preferably 0.05 to 0.2 Pa·s, in a screen printing method, preferably 0.1 to 100 Pa·s, more preferably 0.5 to 50 Pa·s, in a flexo printing method, preferably 0.01 to 1 Pa·s, more preferably 0.05 to 0.5 Pa·s, in an offset printing method, preferably 1 to 500 Pa· s, more preferably 20 to 100 Pa·s, and in an inkjet printing method, preferably 0.1 Pa·s or less, more preferably 0.02 Pa ·s or less. The viscosity of the ink composition can be controlled by appropriately setting the composition ratio of a polymer compound containing a structural unit represented by the formula (1) to a compound represented by the formula (2), or selecting the kind of a solvent, as described above.

The step of forming an organic film as described above can also be carried out as one step in production of an organic semiconductor device. In this case, for example, a substrate on which an organic film is to be formed is a structure generated in a production process of an organic semiconductor device. In an organic semiconductor device, a step of imparting prescribed orientation may be further carried out on an organic film formed as described above, from the standpoint of further enhancing the carrier transportability of the organic film. In an oriented organic film, a polymer compound containing a structural unit represented by the formula (1) and a compound represented by the formula (2) in an organic semiconductor composition constituting this are arranged in one direction, therefore, carrier transportability tends to be further enhanced.

As the orientation method, for example, methods which are known as a means for orienting a liquid crystal can be used. Of them, a rubbing method, a photo-aligning method, a shearing method (shear stress applying method), a draw up application method and the like are simple and thus can be utilized easily as the orientation method, and particularly, a rubbing method or a shearing method is preferable.

### <Polymer compound of the present invention>

### (I-st structural unit)

The polymer compound of the present invention is a polymer compound containing a structural unit represented by the formula (4) (hereinafter, referred to as "I-st structural unit" in some cases) and having a polystyrene-equivalent weight-average molecular weight of 3.0×10⁴ or more. The I-st structural unit may be contained singly in the polymer compound or two or more of the structural units may be contained therein. The polymer compound of the present invention is preferably a conjugated polymer compound.

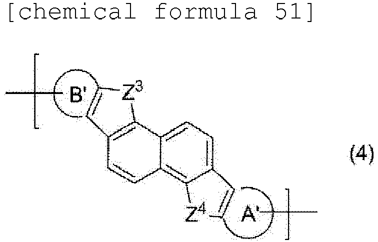

In the formula (4), Ring A' and Ring B' each independently represent a heterocyclic ring, and this heterocyclic ring may have a substituent. The heterocyclic ring has a number of carbon atoms of preferably 2 to 30, more preferably 2 to 14, further preferably 3 to 10. Here, the above-described number of carbon atoms does not include the number of carbon atoms of a substituent.

The heterocyclic ring includes, for example, a furan ring, a thiophene ring, a selenophene ring, a pyrrole ring, an oxazole ring, a thiazole ring, an imidazole ring, a pyridine ring, a benzofuran ring, a benzothiophene ring, a thienothiophene ring and a 2,1,3-benzothiadiazole ring.

The substituent which the heterocyclic ring may have includes, for example, an alkyl group, a cycloalkyl group, an alkoxy group, a cycloalkoxy group, an alkylthio group, a cycloalkylthio group, an aryl group, a monovalent heterocyclic ring group, a halogen atom, a silyl group, an amino group, an alkenyl group, a cycloalkenyl group, an alkynyl group, a cycloalkynyl group, a hydroxyl group, a nitro group, a cyano group, a carboxyl group, an alkylcarbonyl group, a cycloalkylcarbonyl group, an alkoxycarbonyl group and a cycloalkoxycarbonyl group.

The alkyl group as the substituent which the heterocyclic ring may have may be any of a linear alkyl group or a branched alkyl group. The number of carbon atoms of the alkyl group is usually 1 to 30 (in the case of a branched alkyl group, usually 3 to 30), and preferably 1 to 20 (in the case of a branched alkyl group, 3 to 20). The number of carbon atoms of the cycloalkyl group as the substituent which the heterocyclic ring may have is usually 3 to 30, preferably 3 to 20. Here, the above-described number of carbon atoms does not include the number of carbon atoms of a substituent.

The alkyl group includes, for example, linear alkyl groups such as a methyl group, an ethyl group, a n-propyl group, a n-butyl group, a n-hexyl group, a n-octyl group, a n-dodecyl group, a n-hexadecyl group and the like, and branched alkyl groups such as an isopropyl group, an isobutyl group, a sec-butyl group, a tert-butyl group, a 2-ethylhexyl group, a 3,7-dimethyloctyl group and the like. The cycloalkyl group includes, for example, a cyclopentyl group and a cyclohexyl group.

The alkyl group may have a substituent, and the substituent includes, for example, a cycloalkyl group, an alkoxy group, a cycloalkoxy group, an aryl group and a halogen atom. The cycloalkyl group may have a substituent, and the substituent includes, for example, an alkyl group, a cycloalkyl group, an alkoxy group, a cycloalkoxy group, an aryl group and a halogen atom. The alkyl group having a substituent includes, for example, a methoxyethyl group, a benzyl group, a trifluoromethyl group and a perfluorohexyl group.

The alkoxy group as the substituent which the heterocyclic ring may have may be any of a linear alkoxy group or a branched alkoxy group. The number of carbon atoms of the alkoxy group is usually 1 to 30 (in the case of a branched alkoxy group, usually 3 to 30), and preferably 1 to 20 (in the case of a branched alkoxy group, 3 to 20). The number of carbon atoms of the cycloalkoxy group as the substituent which the heterocyclic ring may have is usually 3 to 30, preferably 3 to 20. Here, the above-described number of carbon atoms does not include the number of carbon atoms of a substituent.

The alkoxy group includes, for example, linear alkoxy groups such as a methoxy group, an ethoxy group, a n-propyloxy group, a n-butyloxy group, a n-hexyloxy group, a n-octyloxy group, a n-dodecyloxy group, a n-hexadecyloxy group and the like, and branched alkoxy groups such as an isopropyloxy group, an isobutyloxy group, a sec-butyloxy group, a tert-butyloxy group, a 2-ethylhexyloxy group, a 3,7-dimethyloctyloxy group and the like. The cycloalkoxy group includes, for example, a cyclopentyloxy group and a cyclohexyloxy group.

The alkoxy group may have a substituent, and the substituent includes, for example, a cycloalkyl group, an alkoxy group, a cycloalkoxy group, an aryl group and a halogen atom. The cycloalkoxy group may have a substituent, and the substituent includes, for example, an alkyl group, a cycloalkyl group, an alkoxy group, a cycloalkoxy group, an aryl group and a halogen atom.

The alkylthio group as the substituent which the heterocyclic ring may have may be any of a linear alkylthio group or a branched alkylthio group. The number of carbon atoms of the alkylthio group is usually 1 to 30 (in the case of a branched alkylthio group, usually 3 to 30), and preferably 1 to 20 (in the case of a branched alkylthio group, 3 to 20). The number of carbon atoms of the cycloalkylthio group as the substituent which the heterocyclic ring may have is usually 3 to 30, preferably 3 to 20. Here, the above-described number of carbon atoms does not include the number of carbon atoms of a substituent.

The alkylthio group includes, for example, linear alkylthio groups such as a methylthio group, an ethylthio group, a n-propylthio group, a n-butylthio group, a n-hexylthio group, a n-octylthio group, a n-dodecylthio group, a n-hexadecylthio group and the like, and branched alkylthio groups such as an isopropylthio group, an isobutylthio group, a sec-butylthio group, a tert-butylthio group, a 2-ethylhexylthio group, a 3,7-dimethyloctylthio group and the like. The cycloalkylthio group includes, for example, a cyclopentylthio group and a cyclohexylthio group.

The alkylthio group may have a substituent, and the substituent includes, for example, a cycloalkyl group, an alkoxy group, a cycloalkoxy group, an aryl group and a halogen atom. The cycloalkylthio group may have a substituent, and the substituent includes, for example, an alkyl group, a cycloalkyl group, an alkoxy group, a cycloalkoxy group, an aryl group and a halogen atom.

The aryl group as the substituent which the heterocyclic ring may have is an atomic group remaining after removing from an aromatic hydrocarbon which may have a substituent one hydrogen atom linking directly to a carbon atom constituting the ring, and includes a group having a condensed ring and a group obtained by directly bonding two or more moieties selected from the group consisting of an independent benzene ring and condensed rings. The number of carbon atoms of the aryl group is usually 6 to 30, preferably 6 to 20. Here, the above-described number of carbon atoms does not include the number of carbon atoms of a substituent.

The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group and a 4-phenylphenyl group.

The aryl group may have a substituent, and the substituent includes, for example, an alkyl group, a cycloalkyl group, an alkoxy group, a cycloalkoxy group, an alkylthio group, a cycloalkylthio group, a monovalent heterocyclic ring group and a halogen atom. The aryl group having a substituent includes, for example, a 4-hexadecylphenyl group, a 3,5-dimethoxyphenyl group and a pentafluorophenyl group. When the aryl group has a substituent, the substituent is preferably an alkyl group or a cycloalkyl group.

The monovalent heterocyclic ring group as the substituent which the heterocyclic ring may have is an atomic group remaining after removing from a heterocyclic compound which may have a substituent one hydrogen atom linking directly to a carbon atom or a hetero atom constituting the ring, and includes a group having a condensed ring and a group obtained by directly bonding two or more moieties selected from the group consisting of independent heterocyclic rings and condensed rings. The number of carbon atoms of the monovalent heterocyclic ring group is usually 2 to 30, preferably 3 to 20. Here, the above-described number of carbon atoms does not include the number of carbon atoms of a substituent.

The monovalent heterocyclic ring group includes, for example, a 2-furyl group, a 3-furyl group, a 2-thienyl group, a 3-thienyl group, a 2-pyrrolyl group, a 3-pyrrolyl group, a 2-oxazolyl group, a 2-thiazolyl group, a 2-imidazolyl group, a 2-pyridyl group, a 3-pyridyl group, a 4-pyridyl group, a 2-benzofuryl group, a 2-benzothienyl group, a 2-thienothienyl group and a 4-(2,1,3-benzothiadiazolyl) group.

The monovalent heterocyclic ring group may have a substituent, and the substituent includes, for example, an alkyl group, a cycloalkyl group, an alkoxy group, a cycloalkoxy group, an alkylthio group, a cycloalkylthio group, an aryl group and a halogen atom. The monovalent heterocyclic ring group having a substituent includes, for example, a 5-octyl-2-thienyl group and a 5-phenyl-2-furyl group. When the monovalent heterocyclic ring group has a substituent, the substituent is preferably an alkyl group or a cycloalkyl group.

The halogen atom as the substituent which the heterocyclic ring may have includes, for example, a fluorine atom, a chlorine atom, a bromine atom and an iodine atom.

J The silyl group as the substituent which the heterocyclic ring may have may have a substituent. The substituent which the silyl group may have includes, for example, an alkyl group, a cycloalkyl group and an aryl group. The silyl group having a substituent includes, for example, a trimethylsilyl group, a triethylsilyl group, a triisopropylsilyl group, a tert-butyldimethylsilyl group, a phenylsilyl group and a triphenylsilyl group.

The amino group as the substituent which the heterocyclic ring may have may have a substituent. The substituent which the amino group may have includes, for example, an alkyl group, a cycloalkyl group and an aryl group. The amino group having a substituent includes, for example, a dimethylamino group, a diethylamino group, a diisopropylamino group and a diphenylamino group.

The alkenyl group as the substituent which the heterocyclic ring may have may be any of a linear alkenyl group or a branched alkenyl group. The number of carbon atoms of the alkenyl group is usually 2 to 30 (in the case of a branched alkenyl group, usually 3 to 30), and preferably 2 to 20 (in the case of a branched alkenyl group, 3 to 20). The number of carbon atoms of the cycloalkenyl group as the substituent which the heterocyclic ring may have is usually 3 to 30, preferably 3 to 20. Here, the above-described number of carbon atoms does not include the number of carbon atoms of a substituent.

The alkenyl group includes, for example, a vinyl group, a 1-propenyl group, a 2-propenyl group, a 1-hexenyl group, a 1-dodecenyl group, a 1-hexadecenyl group and a 1-cyclohexenyl group.

The alkenyl group may have a substituent, and the substituent includes, for example, an aryl group, a halogen atom and a silyl group. The cycloalkenyl group may have a substituent, and the substituent includes, for example, an aryl group, a halogen atom and a silyl group.

The alkynyl group as the substituent which the heterocyclic ring may have may be any of a linear alkynyl group or a branched alkynyl group. The number of carbon atoms of the alkynyl group is usually 2 to 30 (in the case of a branched alkynyl group, usually 4 to 30), and preferably 2 to 20 (in the case of a branched alkynyl group, 4 to 20). The number of carbon atoms of the cycloalkynyl group as the substituent which the heterocyclic ring may have is usually 6 to 30, preferably 6 to 20. Here, the above-described number of carbon atoms does not include the number of carbon atoms of a substituent.

The alkynyl group includes, for example, an ethynyl group, a 1-propynyl group, a 1-hexynyl group, a 1-dodecynyl group and a 1-hexadecynyl group.

The alkynyl group may have a substituent, and the substituent includes, for example, an aryl group, a halogen atom and a silyl group. The cycloalkynyl group may have a substituent, and the substituent includes an aryl group, a halogen atom and a silyl group.

The alkylcarbonyl group as the substituent which the heterocyclic ring may have includes, for example, groups obtained by bonding of the above-described alkyl group and a carbonyl group. The cycloalkylcarbonyl group as the substituent which the heterocyclic ring may have includes, for example, groups obtained by bonding of the above-described cycloalkyl group and a carbonyl group.

The alkylcarbonyl group includes, for example, linear alkylcarbonyl groups such as an acetyl group, a n-propanoyl group, a n-butanoyl group, a n-hexanoyl group, a n-octanoyl group, a n-dodecanoyl group, a n-hexadecanoyl group and the like, and branched alkylcarbonyl groups such as an isobutanoyl group, a sec-butanoyl group, a tert-butanoyl group, a 2-ethylhexanoyl group and the like. The cycloalkylcarbonyl group includes, for example, a cyclopentylcarbonyl group and a cyclohexylcarbonyl group.

The alkoxycarbonyl group as the substituent which the heterocyclic ring may have includes, for example, groups obtained by bonding of the above-described alkoxy group and a carbonyl group. The cycloalkoxycarbonyl group as the substituent which the heterocyclic ring may have includes, for example, groups obtained by bonding of the above-described cycloalkoxy group and a carbonyl group.

The alkoxycarbonyl group includes, for example, linear an alkoxycarbonyl groups such as a methoxycarbonyl group, an ethoxycarbonyl group, a n-propyloxycarbonyl group, a n-butoxycarbonyl group, a n-hexyloxycarbonyl group, a n-octyloxycarbonyl group, a n-dodecyloxycarbonyl group, a n-hexadecyloxycarbonyl group and the like, and branched alkoxycarbonyl groups such as an isopropyloxycarbonyl group, an isobutyloxycarbonyl group, a sec-butyloxycarbonyl group, a tert-butyloxycarbonyl group, a 2-ethylhexyloxycarbonyl group and the like. The cycloalkoxycarbonyl group includes, for example, a cyclopentyloxycarbonyl group and a cyclohexyloxycarbonyl group.

It is preferable that Ring A' and Ring B' are the same heterocyclic ring, since synthesis of the polymer compound of the present invention is easy.

Ring A' and Ring B' are preferably constituted of a 5-membered and/or a 6-membered heterocyclic ring, more preferably constituted only of a 5-membered heterocyclic ring, further preferably a 5-membered heterocyclic ring, since an organic film transistor produced by using the polymer compound of the present invention is more excellent in electric field effect mobility.

In the formula (4), Z³ and Z⁴ each independently represent a group represented by the formula (Z-1"), a group represented by the formula (Z-2"), a group represented by the formula (Z-3"), a group represented by the formula (Z-4") or a group represented by the formula (Z-5").

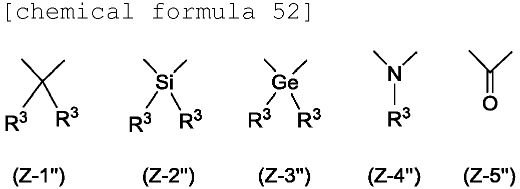

It is preferable that Z³ and Z⁴ are the same group, since synthesis of the polymer compound of the present invention is easy.

Z³ and Z⁴ are preferably a group represented by the formula (Z-1") or the formula (Z-2"), more preferably a group represented by the formula (Z-1"), since an organic film transistor produced by using the polymer compound of the present invention is more excellent in electric field effect mobility.

In the formula (Z-1") to the formula (Z-5"), R³ represents an alkyl group which may have a substituent. When there are a plurality of R³, they may be the same or different.

The definition and specific examples of the alkyl group are the same as the definition and specific examples of the alkyl group as the substituent which the heterocyclic ring may have described above.

It is more preferable that R³ is a linear alkyl group, since an organic film transistor produced by using the polymer compound of the present invention is more excellent in electric field effect mobility.

It is preferable that the structural unit represented by the formula (4) is a structural unit represented by the formula (5), since an organic film transistor produced by using the polymer compound of the present invention is more excellent in electric field effect mobility.

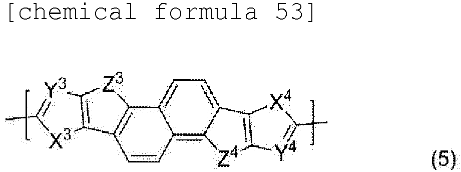

In the formula (5), X³ and X⁴ each independently represent an oxygen atom, a sulfur atom or a selenium atom.

X³ and X⁴ are preferably a sulfur atom, since an organic film transistor produced by using the polymer compound of the present invention is more excellent in electric field effect mobility

In the formula (5), Y³ represents a nitrogen atom or a group represented by -CR⁵=. Y⁴ represents a nitrogen atom or a group represented by -CR⁶=. R⁵ and R⁶ each independently represent a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent.

The definition and specific examples of the alkyl group, the cycloalkyl group, the alkoxy group, the cycloalkoxy group, the alkylthio group, the cycloalkylthio group, the aryl group and the monovalent heterocyclic ring group are the same as the definition and specific examples of the alkyl group, the cycloalkyl group, the alkoxy group, the cycloalkoxy group, the alkylthio group, the cycloalkylthio group, the aryl group and the monovalent heterocyclic ring group as the substituent which the heterocyclic ring may have described above.

R⁵ and R⁶ are preferably a hydrogen atom, an alkyl group, a cycloalkyl group, an alkoxy group, a cycloalkoxy group or a halogen atom, more preferably a hydrogen atom, an alkyl group, a cycloalkyl group or a halogen atom, since synthesis of the polymer compound of the present invention is easy.

Y³ is preferably a group represented by -CR⁵=, more preferably a group represented by -CH=, since synthesis of the polymer compound of the present invention is easy. Y⁴ is preferably a group represented by -CR⁶ =, more preferably a group represented by -CH=. It is further preferable that Y³ and Y⁴ are both a group represented by -CH=.

The structural unit represented by the formula (4) includes, for example, structural units represented by the formula (4-1) to the formula (4-16).

The structural unit represented by the formula (4) is preferably a structural unit represented by the formula (4-1) to the formula (4-8), more preferably a structural unit represented by the formula (4-1) to the formula (4-6), further preferably a structural unit represented by the formula (4-1) to the formula (4-4), since an organic film transistor produced by using the polymer compound of the present invention is more excellent in electric field effect mobility.

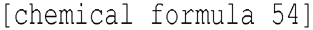

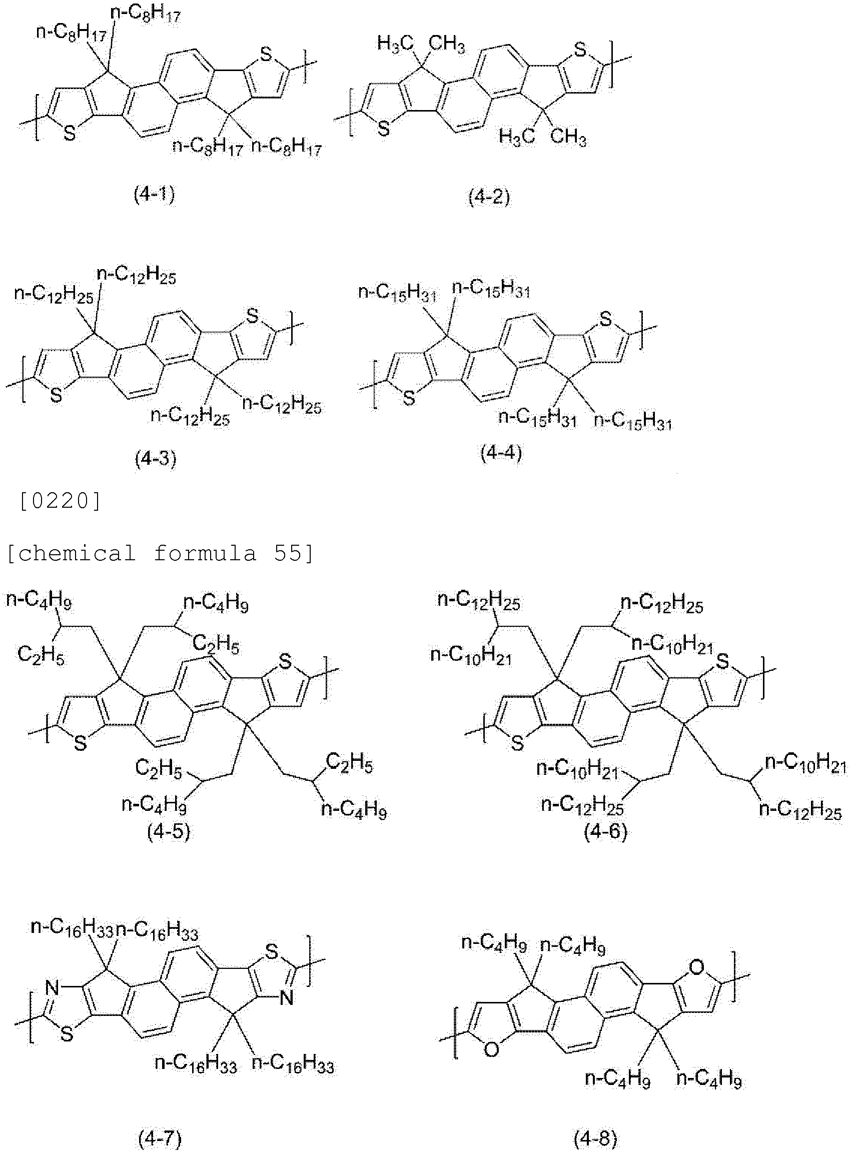

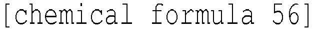

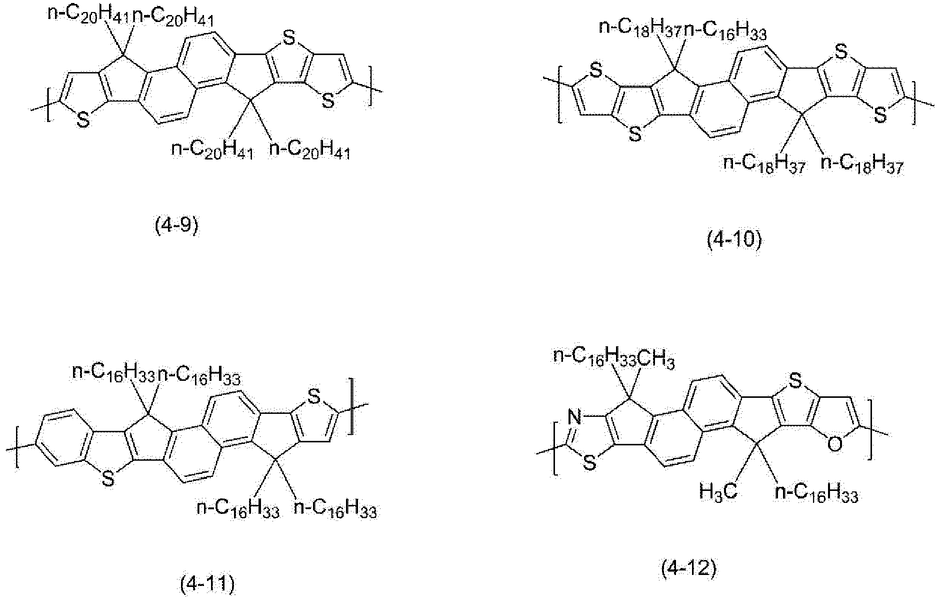

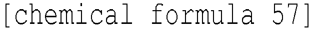

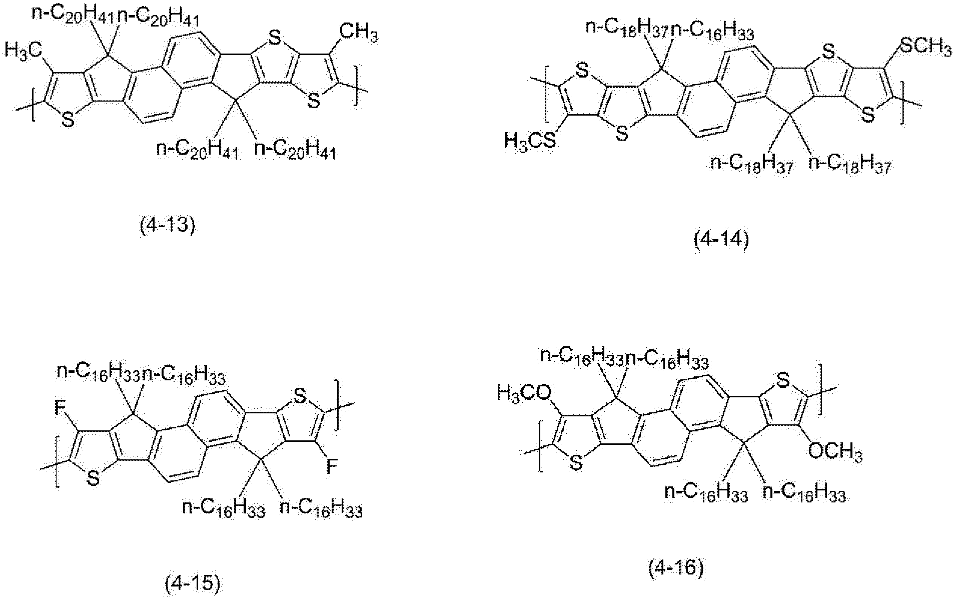

### (II-nd structural unit)

It is preferable that the polymer compound of the present invention further comprises a structural unit represented by the formula (6) (different from the structural unit represented by the above-described formula (4)) (hereinafter, referred to as "II-nd structural unit" in some cases), in addition to the structural unit represented by the formula (4).

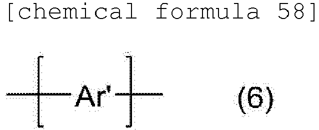

In the formula (6), Ar' represents an arylene group or a divalent heterocyclic ring group, and these groups may have a substituent.

When the polymer compound of the present invention contains the II-nd structural unit, it is preferable that the structural unit represented by the formula (4) and the structural unit represented by the formula (6) form conjugation.

The arylene group is an atomic group remaining after removing from an aromatic hydrocarbon which may have a substituent two hydrogen atoms linking directly to carbon atoms constituting the ring, and includes a group having a condensed ring, a group obtained by directly bonding two or more moieties selected from the group consisting of an independent benzene ring and condensed rings and a group obtained by bonding two or more moieties selected from the group consisting of an independent benzene ring and condensed rings via vinylene or the like. The number of carbon atoms of the arylene group is usually 6 to 60, preferably 6 to 20. Here, the above-described number of carbon atoms does not include the number of carbon atoms of a substituent.

The arylene group may have a substituent, and the substituent includes, for example, an alkyl group, a cycloalkyl group, an alkoxy group, a cycloalkoxy group, an alkylthio group, a cycloalkylthio group, a monovalent heterocyclic ring group and a halogen atom. The definition and specific examples of these substituents are the same as the definition and specific examples of the alkyl group, the cycloalkyl group, the alkoxy group, the cycloalkoxy group, the alkylthio group, the cycloalkylthio group, the monovalent heterocyclic ring group and the halogen atom as the substituent which the heterocyclic ring may have described above.

The arylene group includes, for example, arylene groups represented by the following formulae 1' to 12'.

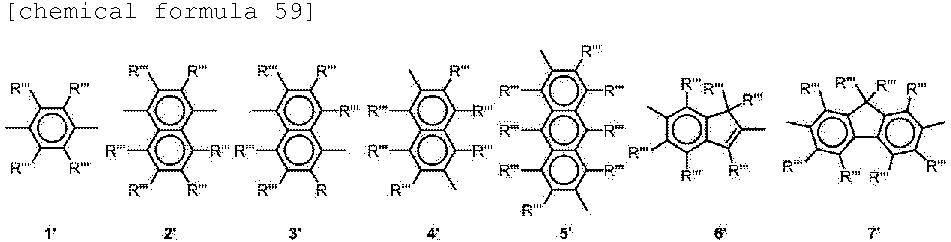

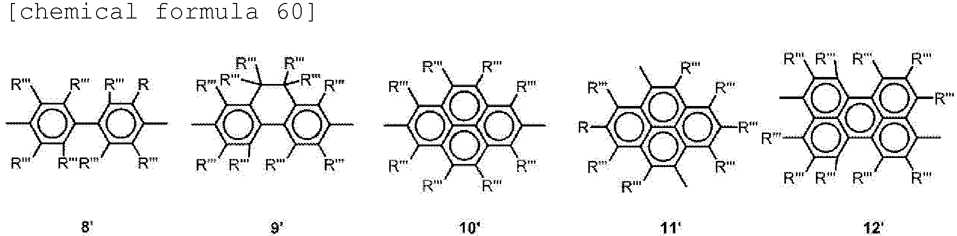

In the formulae 1' to 12' , R"' represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. A plurality of R"' may be the same or different.

The definition and specific examples of the alkyl group, the cycloalkyl group, the alkoxy group, the cycloalkoxy group, the alkylthio group, the cycloalkylthio group, the aryl group, the monovalent heterocyclic ring group and the halogen atom are the same as the definition and specific examples of the alkyl group, the cycloalkyl group, the alkoxy group, the cycloalkoxy group, the alkylthio group, the cycloalkylthio group, the aryl group, the monovalent heterocyclic ring group and the halogen atom as the substituent which the heterocyclic ring may have described above.

The divalent heterocyclic ring group is an atomic group remaining after removing from a heterocyclic compound which may have a substituent two hydrogen atoms linking directly to carbon atoms or hetero atoms constituting the ring, and includes a group having a condensed ring and a group obtained by directly bonding two or more moieties selected from the group consisting of independent heterocyclic rings and condensed rings. The number of carbon atoms of the divalent heterocyclic ring group is usually 2 to 30, preferably 3 to 20. Here, the above-described number of carbon atoms does not include the number of carbon atoms of a substituent. The divalent heterocyclic ring group is preferably a divalent aromatic heterocyclic ring group.

The divalent heterocyclic ring group may have a substituent, and the substituent includes, for example, an alkyl group, a cycloalkyl group, an alkoxy group, a cycloalkoxy group, an alkylthio group, a cycloalkylthio group, an aryl group and a halogen atom. The definition and specific examples of these substituents are the same as the definition and specific examples of the alkyl group, the cycloalkyl group, the alkoxy group, the cycloalkoxy group, the alkylthio group, the cycloalkylthio group, the aryl group and the halogen atom as the substituent which the heterocyclic ring may have described above.

The divalent heterocyclic ring group includes, for example, divalent heterocyclic ring groups represented by the following formulae 13' to 64'.

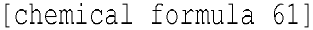

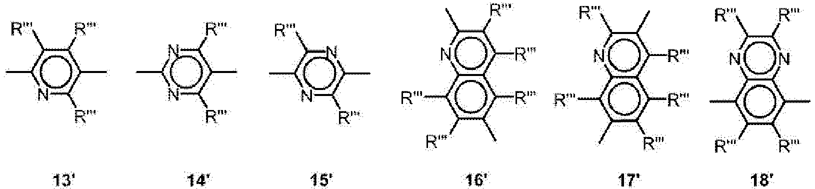

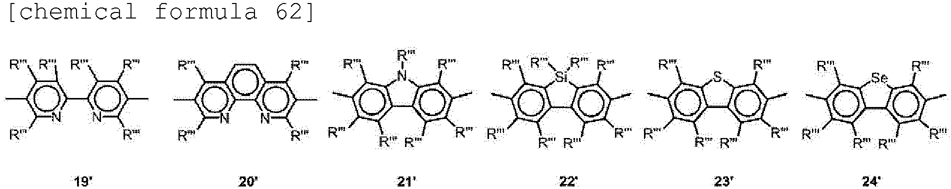

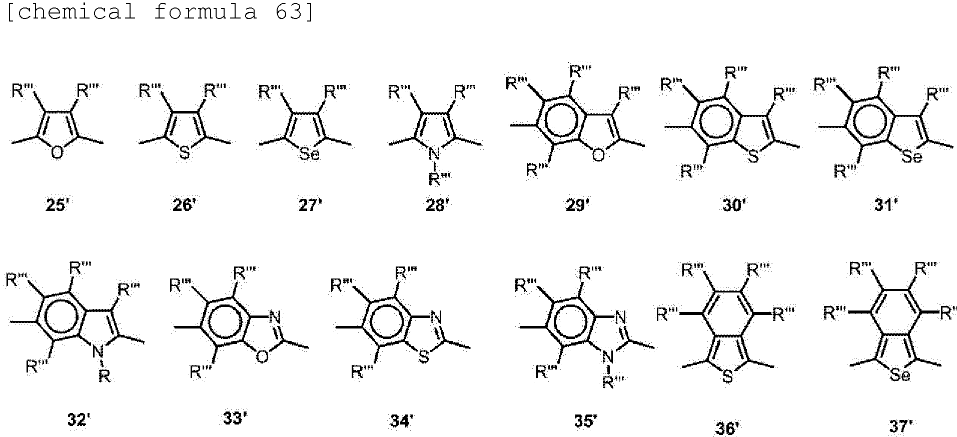

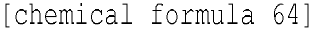

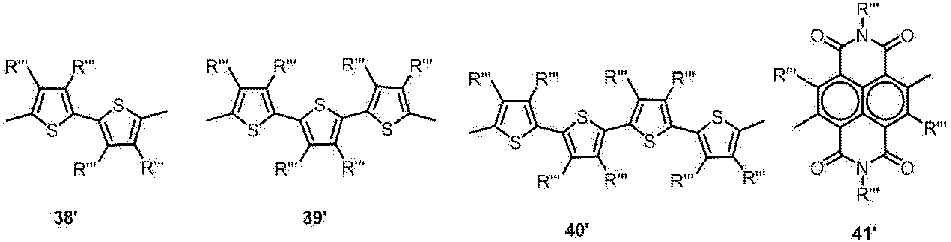

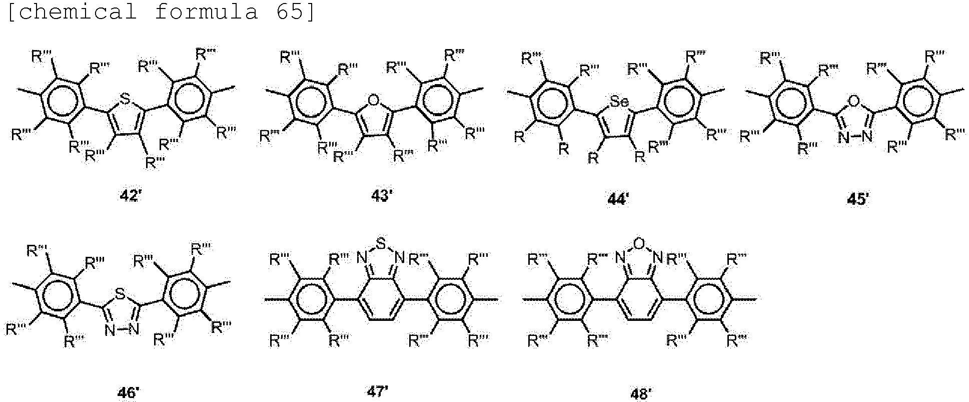

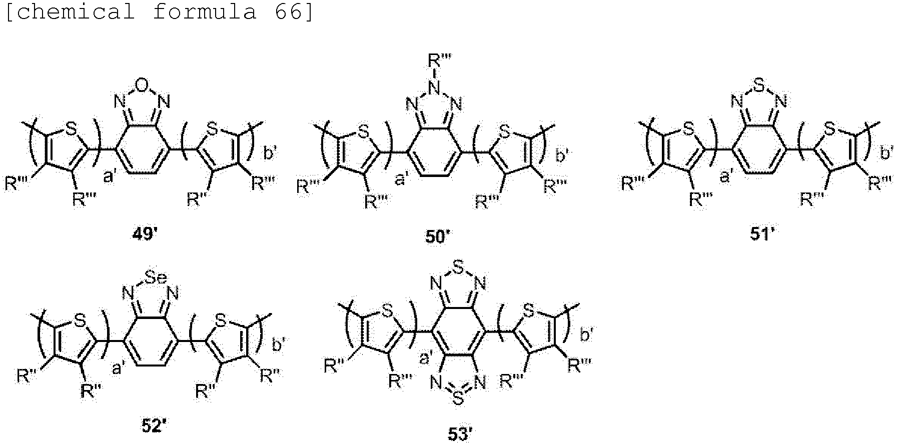

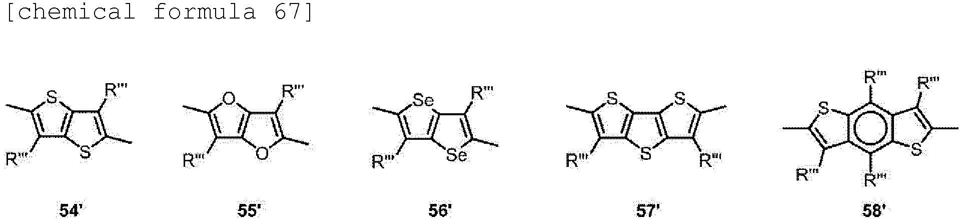

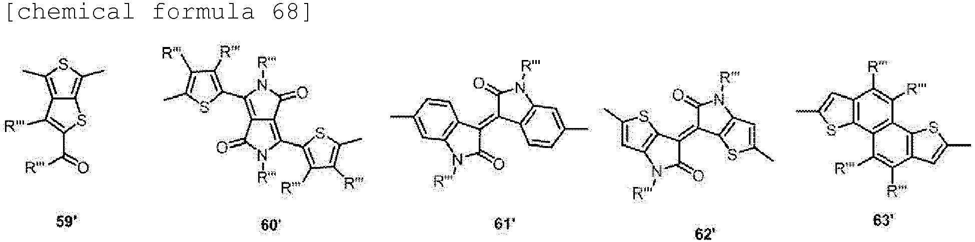

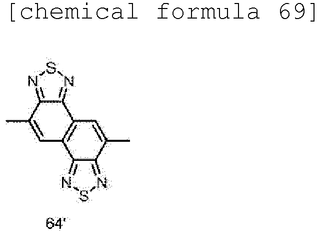

In the formulae 13' to 64', R"' represents the same meaning as described above. a' and b' each independently represent the number of repetition, and usually an integer of 0 to 5, preferably an integer of 0 to 3, more preferably an integer of 0 to 1.

The II-nd structural unit is preferably a divalent heterocyclic ring group, more preferably a divalent heterocyclic ring group represented by the formula 49' to the formula 53' , the formulae 59' to 62' and the formula 64', further preferably a divalent heterocyclic ring group represented by the formula 51' and the formula 64', since an organic film transistor produced by using the polymer compound of the present invention is more excellent in electric field effect mobility.

The polymer compound of the present invention has a polystyrene-equivalent number-average molecular weight (Mn) measured by gel permeation chromatography (hereinafter, referred to as "GPC") of usually 1.5×10⁴ to 1×10⁷. The number-average molecular weight is preferably 1. 6×10⁴ or more, since an organic film transistor produced by using the polymer compound of the present invention is more excellent in electric field effect mobility. It is preferable that the number-average molecular weight is 1×10⁶ or less, from the standpoint of enhancing solubility in a solvent and making film formation easy.

The polymer compound of the present invention has a polystyrene-equivalent weight-average molecular weight (Mw) measured by gel permeation chromatography (hereinafter, referred to as "GPC") of 3.0×10⁴ or more. The weight-average molecular weight (Mw) of the polymer compound of the present invention is usually 1×10⁷ or less.

Since the polymer compound of the present invention has a weight-average molecular weight (Mw) of 3.0×10⁴ or more, when used in an organic film transistor, its electric field effect mobility shows a remarkably high value, as compared with a polymer compound having a weight-average molecular weight (Mw) of less than 3.0×10⁴. The weight-average molecular weight of the polymer compound of the present invention is preferably 4.0×10⁴ or more, since an organic film transistor produced by using the polymer compound of the present invention is more excellent in electric field effect mobility. The weight-average molecular weight is preferably 2×10⁶ or less, from the standpoint of enhancing solubility in a solvent and making film formation easy.

The polymer compound of the present invention has high solubility in a solvent (preferably, an organic solvent), and specifically, it is preferable that the polymer compound has solubility by which a solution containing the polymer compound of the present invention in an amount of 0.1% by weight (hereinafter, referred to as "wt%" in some cases) or more can be prepared, and it is more preferable that the polymer compound has solubility by which a solution containing the polymer compound in an amount of 0.4 wt% or more can be prepared.

The number of the structural unit represented by the formula (4) in the polymer compound of the present invention may be at least one in the polymer compound, and is preferably three or more in the polymer compound, more preferably five or more in the polymer compound.

The polymer compound of the present invention may be any kind of copolymer, and for example, may be any of a block copolymer, a random copolymer, an alternating copolymer or a graft copolymer. The polymer compound of the present invention is preferably a copolymer composed of a structural unit represented by the formula (4) and a structural unit represented by the formula (6), more preferably an alternating copolymer composed of a structural unit represented by the formula (4) and a structural unit represented by the formula (6), since an organic film transistor produced by using the polymer compound of the present invention is more excellent in electric field effect mobility.

When a group active to the polymerization reaction remains at the molecular chain end of the polymer compound of the present invention, the electric field effect mobility of an organic film transistor produced by using the polymer compound of the present invention possibly lowers. Therefore, it is preferable that the molecular chain end is a stable group such as an aryl group, a monovalent aromatic heterocyclic ring group or the like.

### <Production method of polymer compound of the present invention>

Next, the production method of the polymer compound of the present invention will be explained.

The polymer compound of the present invention may be produced by any method, and for example, a compound represented by the formula: X²¹-A²¹-X²² and a compound represented by the formula: X²³-A²²-X²⁴ are, if necessary dissolved in an organic solvent, if necessary with addition of a base, and subjected to a known polymerization method such as aryl coupling and the like using a suitable catalyst, thus, the polymer compound can be synthesized.

In the above-described the formulae, A²¹ represents a structural unit represented by the formula (4) and A²² represents a structural unit represented by the formula (6). X²¹, X²², X²³ and X²⁴ each independently represent a polymerization reactive group.

The polymerization reactive group includes, for example, a halogen atom, a borate residue, a boric acid residue (-B(OH)₂), and an organic tin residue substituted with three alkyl groups or three cycloalkyl groups.

The halogen atom as the polymerization reactive group includes, for example, a fluorine atom, a chlorine atom, a bromine atom and an iodine atom.

The borate residue as the polymerization reactive group includes, for example, groups represented by the following formulae.

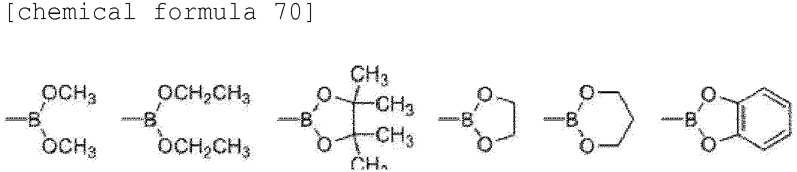

The organic tin residue substituted with three alkyl groups as the polymerization reactive group includes, for example, an organic tin residue substituted with three methyl groups (trimethylstannyl group) and an organic tin residue substituted with three butyl groups (tributylstannyl group).

The above-described polymerization method such as aryl coupling and the like includes, for example, a method of polymerization by the Suzuki coupling reaction (Chemical Review, 1995, vol. 95, pp. 2457-2483) and a method of polymerization by the Stille coupling reaction (European Polymer Journal, 2005, vol. 41, pp. 2923-2933).

The polymerization reactive group is preferably a halogen atom, a borate residue or a boric acid residue, in the case of use of a nickel catalyst or a palladium catalyst such as in the Suzuki coupling reaction and the like. A bromine atom, an iodine atom or a borate residue is preferable, since the polymerization reaction is simple.

When the polymer compound of the present invention is polymerized by the Suzuki coupling reaction, the ratio of the total number of moles of a bromine atom and an iodine atom as the above-described polymerization reactive group to the total number of moles of a borate residue as the above-described polymerization reactive group is preferably 0.76 to 1.24, more preferably 0.8 to 1.2, from the standpoint of obtaining a polymer compound having a polystyrene-equivalent weight-average molecular weight of 3.0×10⁴ or more.

The polymerization reactive group is preferably a halogen atom or an organic tin residue substituted with three alkyl groups in the case of use of a palladium catalyst such as in the Stille coupling reaction and the like, and a bromine atom, an iodine atom or an organic tin residue substituted with three alkyl groups is preferable since the polymerization reaction is simple.

When the polymer compound of the present invention is polymerized by the Stille coupling reaction, the ratio of the total number of moles of a bromine atom and an iodine atom as the above-described polymerization reactive group to the total number of moles of an organic tin residue substituted with three alkyl groups as the above-described polymerization reactive group is preferably 0.76 to 1.24, more preferably 0.8 to 1.2, from the standpoint of obtaining a polymer compound having a polystyrene-equivalent weight-average molecular weight of 3.0x10⁴ or more.

The organic solvent used in polymerization includes, for example, benzene, toluene, xylene, chlorobenzene, dichlorobenzene, tetrahydrofuran and dioxane. These organic solvents may be used each singly or in combination of two or more.

The base used in polymerization includes, for example, inorganic bases such as sodium carbonate, potassium carbonate, cesium carbonate, potassium fluoride, cesium fluoride, tripotassium phosphate and the like, and organic bases such as tetrabutylammonium fluoride, tetrabutylammonium chloride, tetrabutylammonium bromide, tetraethylammonium hydroxide, tetrabutylammonium hydroxide and the like.

The catalyst used for polymerization is preferably a catalyst composed of a transition metal complex such as a palladium complex such as tetrakis(triphenylphosphine)palladium, tris(dibenzylideneacetone)dipalladium, palladium acetate, dichlorobistriphenylphosphinepalladium and the like, and if necessary, of a ligand such as triphenylphosphine, tri-tert-butylphosphine, tricyclohexylphosphine and the like. As these catalysts, those synthesized previously may be used or those prepared in the reaction system may be used as they are. These catalysts may be used each singly or in combination of two or more.

The reaction temperature of polymerization is preferably 0 to 200°C, more preferably 0 to 150°C, further preferably 0 to 120°C.

The reaction time of polymerization is usually 1 hour or more, preferably 2 to 500 hours.

The post treatment of polymerization can be conducted by a known method, and there are, for example, methods in which the reaction solution obtained in the above-described polymerization is added to a lower alcohol such as methanol and the like to deposit a precipitate which is then filtrated and dried.

When the purity of the polymer compound of the present invention is low, it is preferable that the polymer compound is purified by a method such as recrystallization, continuous extraction by a Soxhlet extractor, column chromatography and the like.

The compound represented by the formula (12) can be suitably used in the above-described polymer compound production method as the raw material of the polymer compound of the present invention.

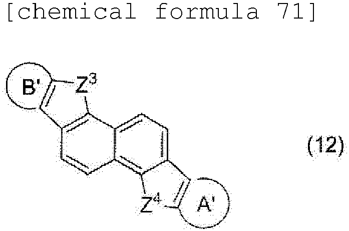

In the formula (12), Ring A', Ring B', Z³ and Z⁴ represent the same meaning as described above.

In the formula (12), Ring A' and Ring B' preferably have a borate residue, a boric acid residue or an organic tin residue.

It is preferable that the compound represented by the formula (12) is a compound represented by the formula (13), since synthesis of the compound represented by the formula (12) is easy.

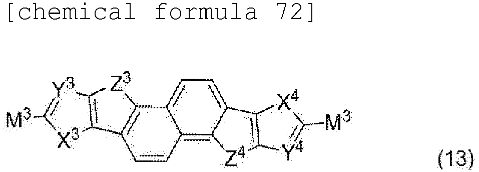

In the formula (13), Z³, Z⁴, X³, X⁴, Y³ and Y⁴ represent the same meaning as described above. M³ represents a borate residue, a boric acid residue or an organic tin residue. A plurality of M³ may be the same or different.

The definition and specific examples of the borate residue, the boric acid residue or the organic tin residue are the same as the definition and specific examples of the borate residue, the boric acid residue or the organic tin residue as the polymerization reactive group described above.

The compound represented by the formula (12) includes, for example, compounds represented by the formula (12-1) to the formula (12-16), and a compound represented by the formula (12-1) to the formula (12-8) is preferable, a compound represented by the formula (12-1) to the formula (12-4) is more preferable.

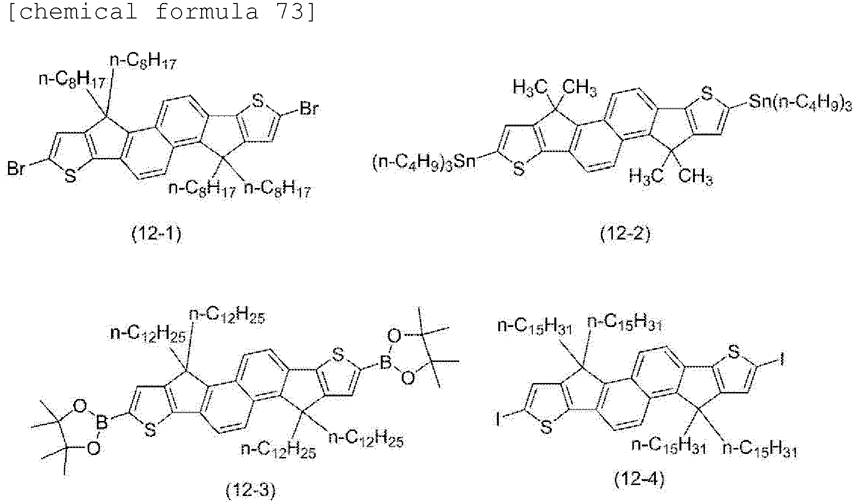

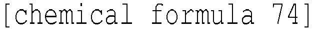

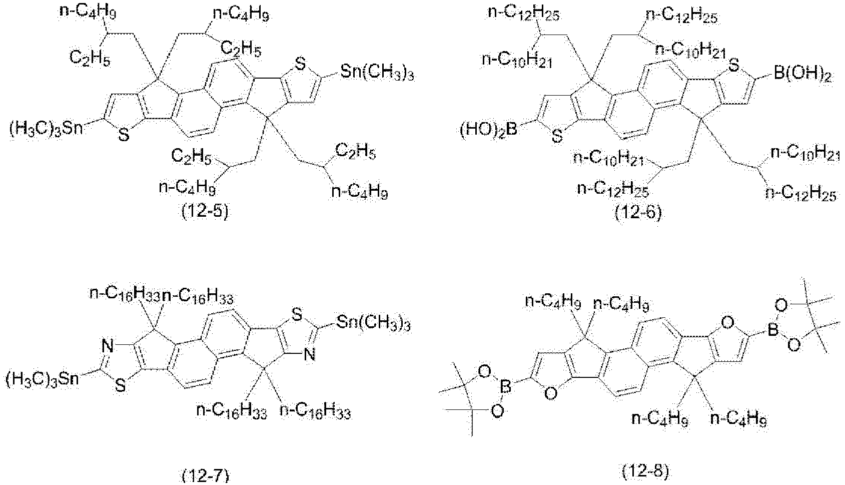

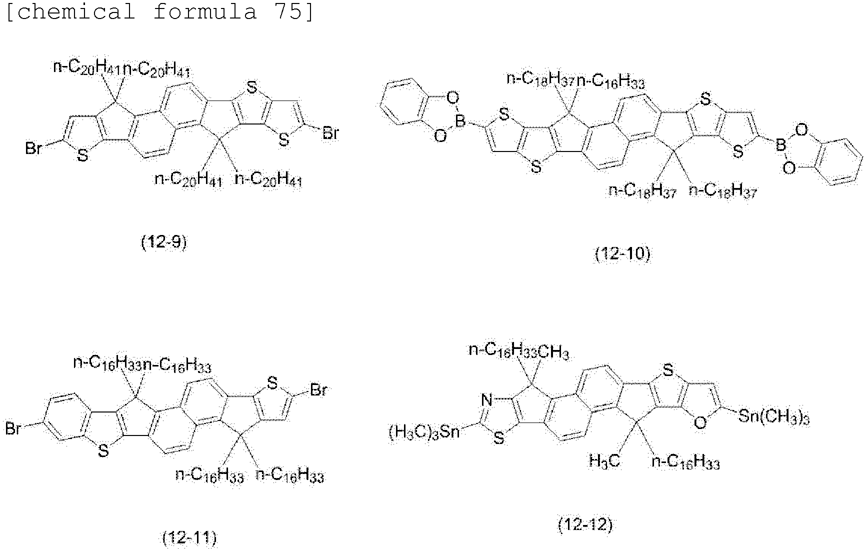

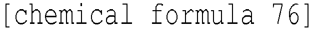

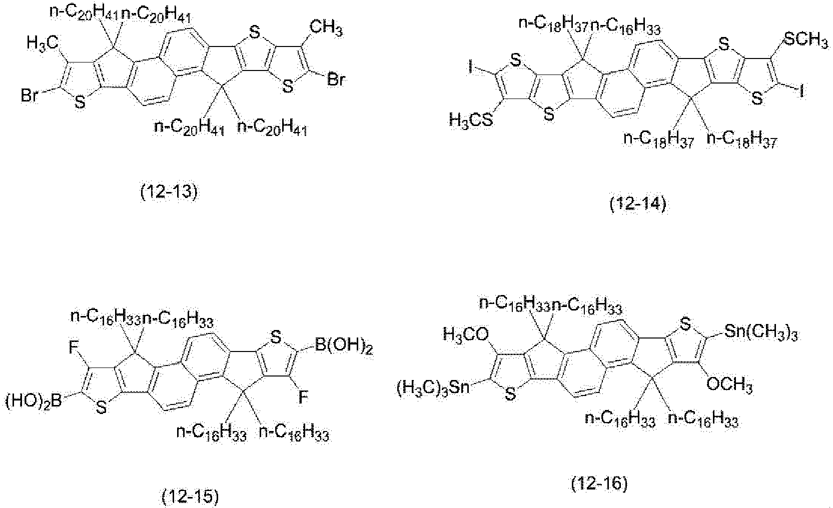

Next, the production method of the compound represented by the formula (12) will be explained.

The compound represented by the formula (12) may be produced by any method, and for example, can be produced by a bromination reaction, the Suzuki coupling reaction, the Wolff-Kishner reduction reaction, the Buchwald-Hartwig amination reaction and an oxidative cyclization reaction, as explained below.

When Z³ and Z⁴ are a group represented by the formula (Z-5"), the compound can be produced, for example, by
a first step of reacting a compound represented by the formula (S1'), a compound represented by the formula (S2') and a compound represented by the formula (S3') by the Suzuki coupling reaction, and
a second step of intramolecularly cyclizing a compound represented by the formula (S4') obtained in the first step.

In this case, the resultant compound is a compound represented by the formula (S5'). Then, the compound represented by the formula (S5') (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (13).

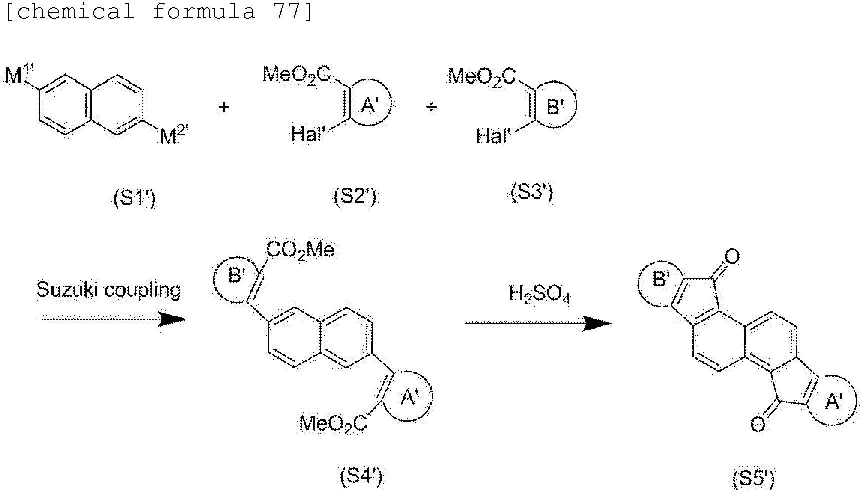

In the formulae (S1') to (S5'), Ring A' and Ring B' represent the same meaning as described above. M¹' and M²' each independently represent a borate residue or a boric acid residue (a group represented by -B(OH)₂). Hal' represents an iodine atom, a bromine atom or a chlorine atom. Hal' in the formula (S2') and Hal' in the formula (S3') may be the same or different.

When Z³ and Z⁴ are a group represented by the formula (Z-1"), the compound can be produced, for example, by
a first step of reacting the compound represented by the formula (S5') described above by the Wolff-Kishner reduction reaction, and
a second step of reacting a compound represented by the formula (S6') obtained in the first step, a base such as a sodium alkoxide and the like, and an alkyl halide.

In this case, the resultant compound is a compound represented by the formula (S7'). Then, the compound represented by the formula (S7') (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (12).

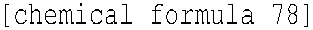

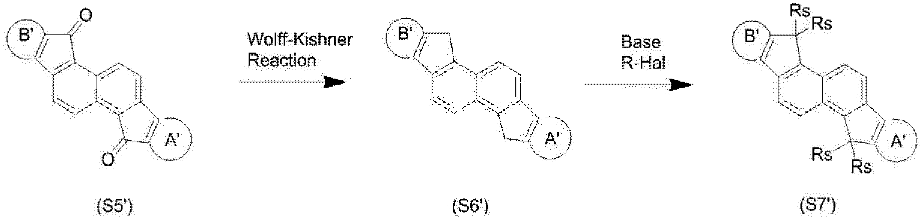

In the formulae (S5') to (S7'), Ring A' , Ring B' and Hal' represent the same meaning as described above. Rs represents an alkyl group, a cycloalkyl group, an alkoxy group, a cycloalkoxy group, an alkylthio group, a cycloalkylthio group, an aryl group or a monovalent heterocyclic ring group, and these groups may have a substituent. A plurality of Rs may be mutually the same or different.

When Z³ and Z⁴ are a group represented by the formula (Z-1"), the compound can be produced, additionally, by
a first step of reacting a compound represented by the formula (S1'), a compound represented by the formula (S8') and a compound represented by the formula (S9') by the Suzuki coupling reaction,
a second step of reacting a compound represented by the formula (S10') obtained in the first step with butyllithium to cause lithiation, and further, reacting with a ketone, and
a third step of reacting a compound represented by the formula (S11') obtained in the second step with an acid such as trifluoroboric acid, sulfuric acid or the like to cause cyclization.

In this case, the resultant compound is a compound represented by the formula (S7'). Then, the compound represented by the formula (S7') (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (12).

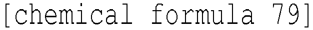

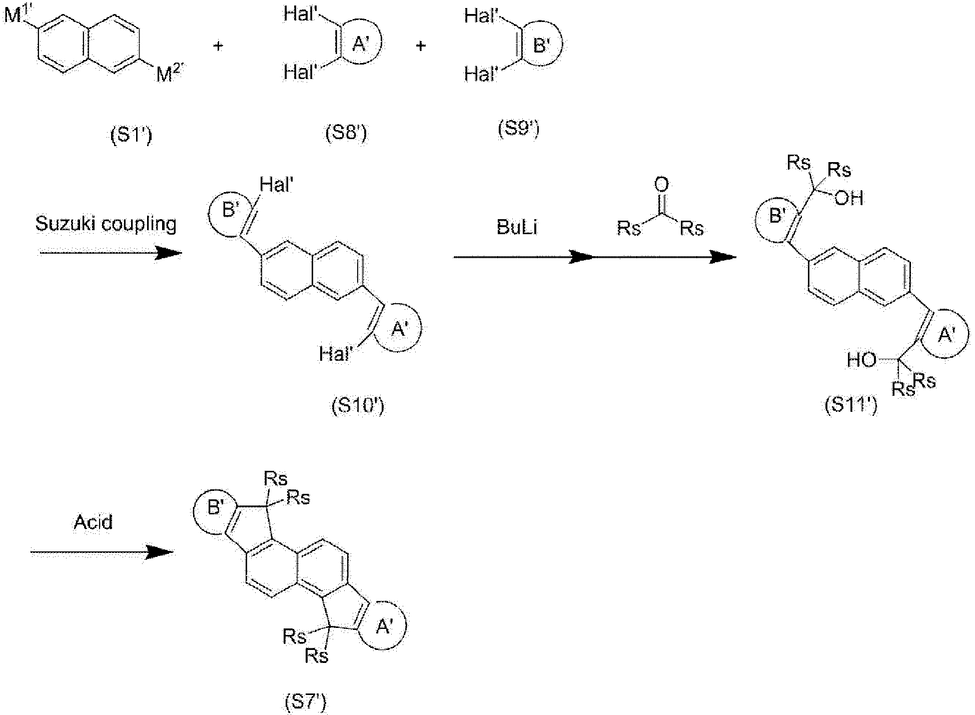

In the formulae (S1') and (S7') to (S11'), Rs, M¹', M²', Ring A' , Ring B' and Hal' represent the same meaning as described above. A plurality of Hal' present in the formula (S8') may be the same or different, a plurality of Hal' present in the formula (S9') may be the same or different, and Hal' in the formula (S8') and Hal' in the formula (S9') may be the same or different.

When Z³ and Z⁴ are a group represented by the formula (Z-3") or the formula (Z-2"), the compound can be produced, for example, by
a first step of reacting the compound represented by the formula (S10') described above with a halogenating agent such as N-bromosuccinimide and the like, and
a second step of reacting a compound represented by the formula (S12') obtained in the first step with butyllithium to cause lithiation, and further, reacting with a compound represented by the formula: Rs₂ECl₂ or the like. In this case, the resultant compound is a compound represented by the formula (S13'). Then, the compound represented by the formula (S13') (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (12).

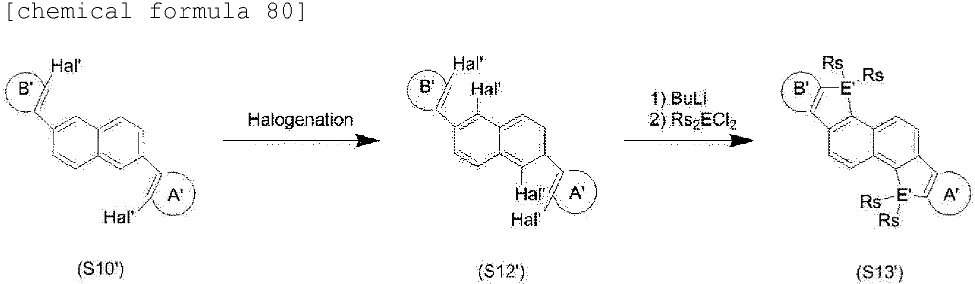

In the formulae (S10'), (S12') and (S13'), Rs, Ring A', Ring B' and Hal' represent the same meaning as described above. E' represents a silicon atom or a germanium atom.

A plurality of Hal' present in the formula (S10') may be the same or different and a plurality of Hal' present in the formula (S12') may be the same or different.

When Z³ and Z⁴ are a group represented by the formula (Z-4"), the compound can be produced, for example, by
reacting the compound represented by the formula (S12') described above and a compound represented by the formula (S14') by the Buchwald-Hartwig amination reaction. In this case, the resultant compound is a compound represented by the formula (S15'). Then, the compound represented by the formula (S15') (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (12).

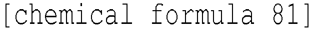

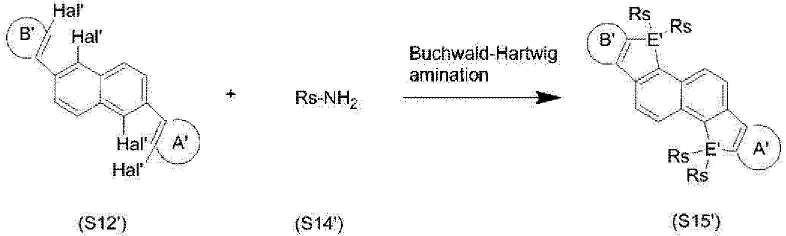

In the formulae (S12'), (S14') and (S15'), Rs, Ring A', Ring B' and Hal' represent the same meaning as described above. A plurality of Hal' present in the formula (S12') may be the same or different.

When Z³ and Z⁴ are a group represented by the formula (Z-1"), the compound can be produced, additionally, by
a first step of reacting a compound represented by the formula (S16'), a compound represented by the formula (S19') and a compound represented by the formula (S20') by the Suzuki coupling reaction, and
a second step of intramolecularly cyclizing a compound represented by the formula (S21') obtained in the first step.

In this case, the resultant compound is a compound represented by the formula (S7'). Then, the compound represented by the formula (S7') (I) can be reacted with a halogenating agent such as N-bromosuccinimide and the like, (II) can be subjected to a coupling reaction using a palladium catalyst and the like or (III) can be reacted with an alkyllithium to cause lithiation, and further, reacted with tributylbutyltin chloride and the like, thereby producing the compound represented by the formula (12).

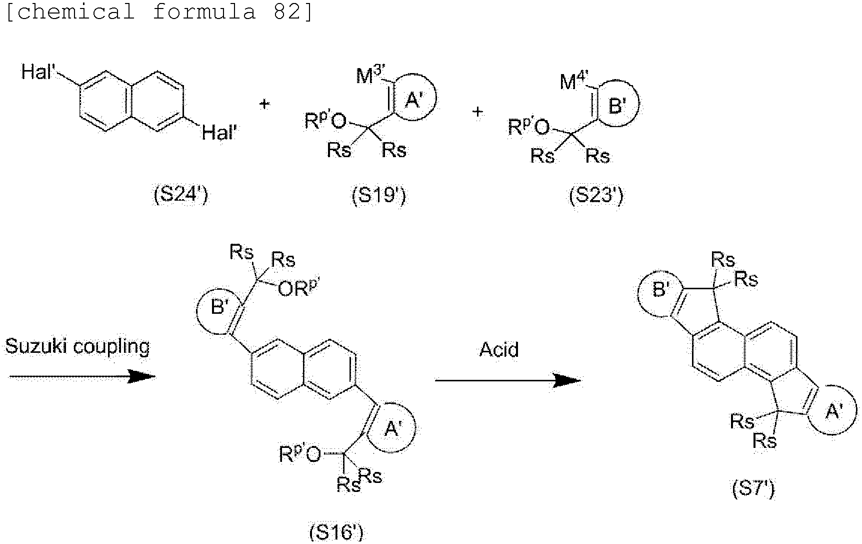

In the formulae (S7'), (S16'), (S19'), (S20') and (S21'), Rs, Ring A', Ring B' and Hal' represent the same meaning as described above. M³' and M⁴' each independently represent a borate residue or a boric acid residue (a group represented by -B(OH)₂). R^{p}' represents an alkyl group, a silyl group or an acetyl group. A plurality of Hal' present in the formula (S24') may be the same or different. R^{p}' in the formula (S19') and R^{p}' in the formula (S20') may be the same or different.

The compound represented by the formula (13) can also be synthesized, for example, according to methods described in JP-A No. 2009-155648, JP-A No. 2009-209134, Japanese Patent Application National Publication No. 2012-500308, Japanese Patent Application National Publication No. 2013-501076 and International Publication WO2013/010614.

### <Ink composition containing polymer compound of the present invention>

The polymer compound of the present invention can be prepared in the form of an ink composition, from the standpoint of facilitating works such as application and the like. The ink composition contains, for example, the polymer compound of the present invention and a solvent, and may further contain other additives. The suitable solvent includes halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, bromocyclohexane and the like, halogenated unsaturated hydrocarbon solvents such as chlorobenzene, dichlorobenzene, trichlorobenzene and the like, and additionally, tetrahydrofuran, tetrahydropyran, dioxane, toluene, xylene, mesitylene, tetralin, decalin, bicyclohexyl, cyclohexylbenzene and cyclohexane. It is preferable that the polymer compound of the present invention can be dissolved in an amount of 0.1% by weight or more in these solvents.

### <Organic film containing polymer compound of the present invention>

Next, the organic film containing the polymer compound of the present invention will be explained referring to an organic film obtained by using the ink composition containing the polymer compound of the present invention described above by way of example.

The organic film is a film constituted mainly of the polymer compound of the present invention, and a solvent and other unavoidable components contained in an ink composition may also be partially contained in the film. The thickness of the organic film is preferably 1 nm to 100 µm, more preferably 2 nm to 1000 nm, further preferably 5 nm to 500 nm, particularly preferably 20 nm to 200 nm. When the organic film having such a thickness is used, an organic semiconductor device having excellent carrier transportability and sufficient also in strength and the like can be formed.

The organic film can be formed by applying the ink composition containing the polymer compound of the present invention described above on a prescribed substrate and the like. The ink composition application method includes application methods such as, for example, a spin coat method, a casting method, a push coat method, a micro gravure coat method, a gravure coat method, a bar coat method, a roll coat method, a wire bar coat method, a dip coat method, a spray coat method, a screen printing method, a flexo printing method, an offset printing method, an inkjet printing method, a dispenser printing method, a micro contact printing method, a nozzle coat method and a capillary coat method. Of them, a spin coat method, a push coat method, a gravure coat method, a screen printing method, a flexo printing method, an offset printing method, an inkjet printing method, a dispenser printing method, a micro contact printing method, a nozzle coat method or a capillary coat method is preferable.

Application may be conducted also under heated condition. By this, an ink composition having high concentration can be applied, a more uniform organic film can be formed, and additionally, materials of which application at room temperature has been difficult can be selected and used. Application under heated condition can be attained, for example, by using an ink composition heated previously or by performing application while heating a substrate.

The viscosity of the ink composition containing the polymer compound of the present invention which is suitable for the above-described application method is, for example, in a gravure coat method, preferably 0.01 to 1 Pa·s, more preferably 0.05 to 0.2 Pa·s, in a screen printing method, preferably 0.1 to 100 Pa·s, more preferably 0.5 to 50 Pa·s, in a flexo printing method, preferably 0.01 to 1 Pa·s, more preferably 0.05 to 0.5 Pa·s, in an offset printing method, preferably 1 to 500 Pa· s, more preferably 20 to 100 Pa·s, and in an inkjet printing method, preferably 0.1 Pa·s or less, more preferably 0.02 Pa ·s or less. The viscosity of the ink composition containing the polymer compound of the present invention can be controlled by selecting the kind of a solvent.

The step of forming an organic film as described above can also be carried out as one step in production of an organic semiconductor device. In this case, for example, a substrate on which an organic film is to be formed is a structure generated in a production process of an organic semiconductor device. In an organic semiconductor device, a step of imparting prescribed orientation may be further carried out on an organic film formed as described above, from the standpoint of further enhancing the carrier transportability of the organic film. In an oriented organic film, a polymer compound containing a structural unit represented by the formula (4) in an organic semiconductor composition constituting this is arranged in one direction, therefore, carrier transportability tends to be further enhanced.

As the orientation method, for example, methods which are known as a means for orienting a liquid crystal can be used. Of them, a rubbing method, a photo-aligning method, a shearing method (shear stress applying method), a draw up application method and the like are simple and thus can be utilized easily as the orientation method, and particularly, a rubbing method or a shearing method is preferable.

### <Organic semiconductor device>

The organic semiconductor device of the present invention is an organic semiconductor device having a first electrode and a second electrode and having an active layer between the first electrode and the second electrode in which the active layer contains the composition or the polymer compound of the present invention. The organic semiconductor device of the present invention may further contain electrodes other than the first electrode and the second electrode. An organic film containing the composition or the polymer compound of the present invention can exert high carrier (electron or hole) transportability, therefore, electrons or holes injected from an electrode provided on the organic film or charges generated by light absorption can be transported. Further, in production of an organic semiconductor device, the viscosity of an ink composition can be adjusted easily, and additionally, crystallization thereof unlikely occurs, hence, uniform properties are obtained even if the area of the device is increased. In view of this, the organic semiconductor device of the present invention can be applied to various organic semiconductor devices such as an organic film transistor, a photoelectric conversion device (organic film solar battery), an organic electroluminescent device, an organic electric field effect transistor sensor (hereinafter, referred to also as "OFET sensor"), an organic conductivity modulation type sensor and the like, by utilizing these properties. These organic semiconductor devices will be individually explained below.

### (Organic film transistor)

The organic film transistor using the organic film described above includes one having a constitution having a source electrode and a drain electrode, an organic semiconductor layer (active layer) acting as a current pathway between these electrodes, and a gate electrode controlling the quantity of current passing the current pathway, in which the organic semiconductor layer is constituted of the organic film containing the composition or the polymer compound of the present invention. Such an organic film transistor includes, for example, an electric field effect organic film transistor and an electrostatic induction organic film transistor.

The electric field effect organic film transistor preferably has a source electrode and a drain electrode, an organic semiconductor layer (active layer) acting as a current pathway between these electrodes, a gate electrode controlling the quantity of current passing the current pathway, and an insulation layer disposed between the organic semiconductor layer and the gate electrode. Particularly, it is preferable that a source electrode and a drain electrode are disposed in contact with an organic semiconductor layer (active layer), and further, a gate electrode is disposed sandwiching an insulation layer in contact with the organic semiconductor layer. In the electric field effect organic film transistor, the organic semiconductor layer is constituted of an organic film containing the composition or the polymer compound of the present invention.

The electrostatic induction organic film transistor preferably has a source electrode and a drain electrode, an organic semiconductor layer (active layer) acting as a current pathway between these electrodes, and a gate electrode controlling the quantity of current passing the current pathway, wherein this gate electrode is disposed in the organic semiconductor layer. Particularly, it is preferable that a source electrode, a drain electrode and, a gate electrode disposed in an organic semiconductor layer are disposed in contact with the organic semiconductor layer. Here, the gate electrode may have a structure by which a current pathway flowing from a source electrode to a drain electrode can be formed and the quantity of current passing the current pathway can be controlled by voltage applied to the gate electrode, and for example, a comb-shaped electrode is mentioned. Also in the electrostatic induction organic film transistor, the organic semiconductor layer is constituted of an organic film containing the composition or the polymer compound of the present invention.

The organic semiconductor layer may partially contain a solvent and other unavoidable components used in production. The thickness is preferably 1 nm to 100 µm, more preferably 2 nm to 1000 nm, further preferably 5 nm to 500 nm, particularly preferably 20 nm to 200 nm, from the standpoint of having excellent carrier transportability and from the standpoint of easily forming an organic film having sufficient strength.

As the gate insulation layer, a gate insulation film composed of an inorganic insulator or an organic insulator can be used. The inorganic insulator includes silicon oxide, silicon nitride, aluminum oxide, aluminum nitride and titanium oxide. The organic insulator includes polyethylene, polyester, polyimide, polyphenylene sulfide, organic glass, polyvinyl alcohol, polyvinyl phenol, poly-p-xylene and polyacrylonitrile. The inorganic insulator and the organic insulator may each be used singly or two or more of them may be used in combination. The thickness of the gate insulation layer is preferably 50 to 1000 nm.

In the gate electrode, materials such as metals such as gold, platinum, silver, copper, chromium, palladium, aluminum, indium, molybdenum, low resistance polysilicon, low resistance amorphous silicon and the like and tin oxide, indium oxide, indium·tin oxide (ITO) and the like can be used. These materials may be each used singly or two or more of them may be used in combination. Further, as the gate electrode, a silicon substrate doped at high concentration may be used. The silicon substrate doped at high concentration has a nature as a gate electrode and a nature as a substrate together. Hence, in the case of use of the silicon substrate doped at high concentration, representation of a substrate in the following figures may be omitted, in an organic film transistor in which a substrate and a gate electrode are in contact. The thickness of the gate electrode is preferably 0.02 to 100 µm.

The source electrode and the drain electrode are preferably constituted of a low resistance material, and the thicknesses of the source electrode and the drain electrode are each preferably 0.02 to 1000 µm.

The substrate includes a glass substrate, a flexible film substrate, a plastic substrate and the like. The thickness of the substrate is preferably 10 to 2000 µm.

In an organic film transistor, a layer composed of a compound different from an organic semiconductor material contained in an organic semiconductor layer may be allowed to intervene between source and drain electrodes and the organic semiconductor layer. By intervention of such a layer, contact resistance between source and drain electrodes and the organic semiconductor layer is reduced and the carrier mobility of the organic film transistor can be further enhanced in some cases.

The layer containing a compound different from the composition or the polymer compound of the present invention contained in an organic semiconductor layer includes layers containing, for example, low molecular weight compounds having electron or hole transportability; alkali metals, alkaline earth metals, rare earth metals, complexes of these metals with an organic compound; halogens such as iodine, bromine, chlorine, iodine chloride and the like; sulfur oxide compounds such as sulfuric acid, anhydrous sulfuric acid, sulfur dioxide, sulfuric acid salt and the like; nitrogen oxide compounds such as nitric acid, nitrogen dioxide, nitric acid salt and the like; halogenated compounds such as perchloric acid, hypochlorous acid and the like;aromatic thiol compounds such as alkylthiol compounds, aromatic thiols, fluorinated alkyl aromatic thiols and the like.

Next, a typical example of an electric field effect organic film transistor will be illustrated referring to drawings.

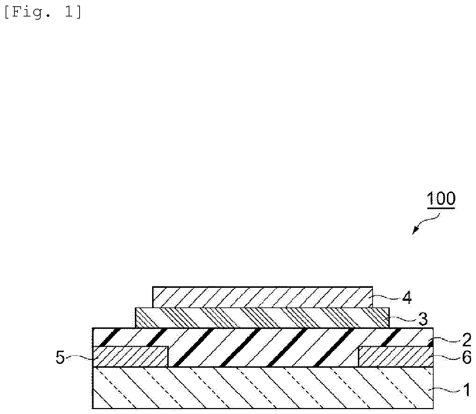

Fig. 1 is a schematic cross-sectional view an organic film transistor (electric field effect organic film transistor) according to a first embodiment. The organic film transistor 100 shown in Fig. 1 has a substrate 1, a source electrode 5 and a drain electrode 6 formed at a prescribed interval on the substrate 1, an organic semiconductor layer 2 so formed on the substrate 1 as to over the source electrode 5 and the drain electrode 6, an insulation layer 3 formed on the organic semiconductor layer 2, and a gate electrode 4 so formed on the insulation layer 3 as to cover a region of the insulation layer 3 between the source electrode 5 and the drain electrode 6.

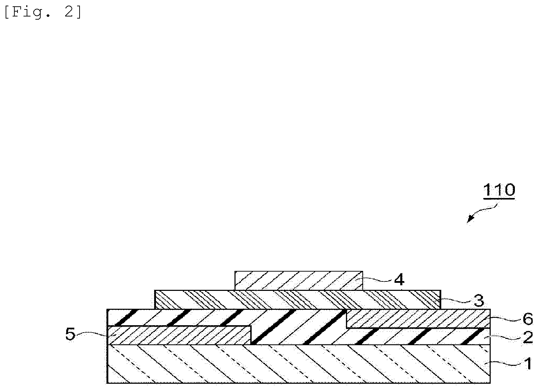

Fig. 2 is a schematic cross-sectional view of an organic film transistor (electric field effect organic film transistor) according to a second embodiment. The organic film transistor 110 shown in Fig. 2 has a substrate 1, a source electrode 5 formed on the substrate 1, an organic semiconductor layer 2 so formed on the substrate 1 as to cover the source electrode 5, a drain electrode 6 formed at a prescribed interval from the source electrode 5 on the organic semiconductor layer 2, an insulation layer 3 formed on the organic semiconductor layer 2 and the drain electrode 6, and a gate electrode 4 so formed on the insulation layer 3 as to cover a region of the insulation layer 3 between the source electrode 5 and the drain electrode 6.

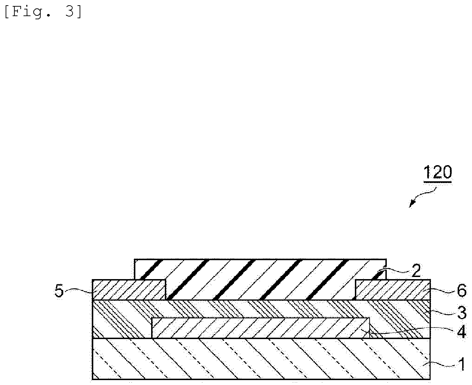

Fig. 3 is a schematic cross-sectional view of an organic film transistor (electric field effect organic film transistor) according to a third embodiment. The organic film transistor 120 shown in Fig. 3 has a substrate 1, a gate electrode 4 formed on the substrate 1, an insulation layer 3 so formed on the substrate 1 as to cover the gate electrode 4, a source electrode 5 and a drain electrode 6 so formed at a prescribed interval on the insulation layer 3 as to partially cover a region of the insulation layer 3 where the gate electrode 4 is formed beneath, and an organic semiconductor layer 2 so formed on the insulation layer 3 as to partially cover the source electrode 5 and the drain electrode 6.

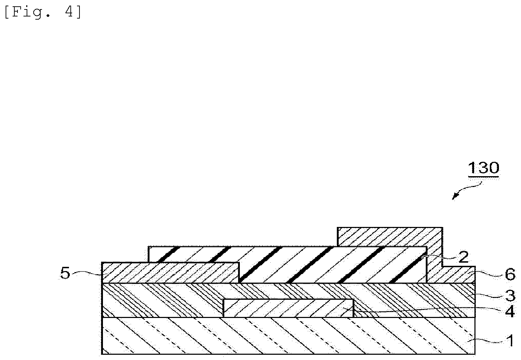

Fig. 4 is a schematic cross-sectional view of an organic film transistor (electric field effect organic film transistor) according to a fourth embodiment. The organic film transistor 130 shown in Fig. 4 has a substrate 1, a gate electrode 4 formed on the substrate 1, an insulation layer 3 so formed on the substrate 1 as to cover the gate electrode 4, a source electrode 5 so formed on the insulation layer 3 as to partially cover a region of the insulation layer 3 where the gate electrode 4 is formed beneath, an organic semiconductor layer 2 so formed on the insulation layer 3 as to partially cover the source electrode 5, and a drain electrode 6 so formed on the insulation layer 3 at a prescribed interval from the source electrode 5 as to partially cover a region of the organic semiconductor layer 2 where the gate electrode 4 is formed beneath.

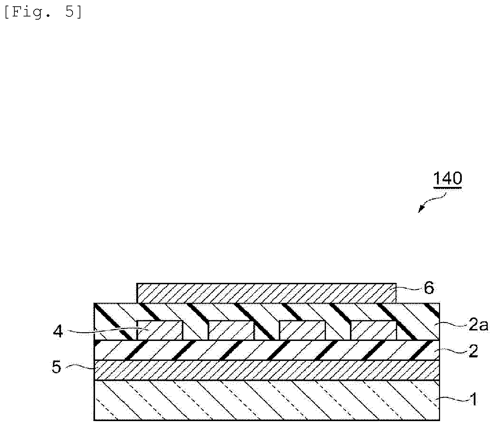

Fig. 5 is a schematic cross-sectional view of an organic film transistor (electrostatic induction organic film transistor) according to a fifth embodiment. The organic film transistor 140 shown in Fig. 5 has a substrate 1, a source electrode 5 formed on the substrate 1, an organic semiconductor layer 2 formed on the source electrode 5, a plurality of gate electrodes 4 formed at a prescribed interval on the organic semiconductor layer 2, an organic semiconductor layer 2a so formed on the organic semiconductor layer 2 as to cover all the gate electrodes 4 (the material constituting the organic semiconductor layer 2a may be the same as or different from that of the organic semiconductor layer 2), and a drain electrode 6 formed on the organic semiconductor layer 2a.

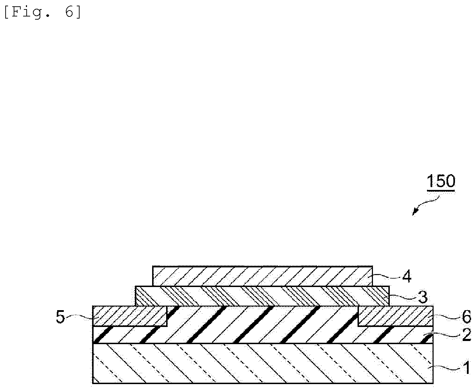

Fig. 6 is a schematic cross-sectional view of an organic film transistor (electric field effect organic film transistor) according to a sixth embodiment. The organic film transistor 150 shown in Fig. 6 has a substrate 1, an organic semiconductor layer 2 formed on the substrate 1, a source electrode 5 and a drain electrode 6 formed at a prescribed interval on the organic semiconductor layer 2, an insulation layer 3 so formed on the organic semiconductor layer 2 as to partially cover the source electrode 5 and the drain electrode 6, and a gate electrode 4 so formed on the insulation layer 3 as to partially cover a region of the insulation layer 3 where the source electrode 5 is formed beneath and a region of the insulation layer 3 where the drain electrode 6 is formed beneath respectively.

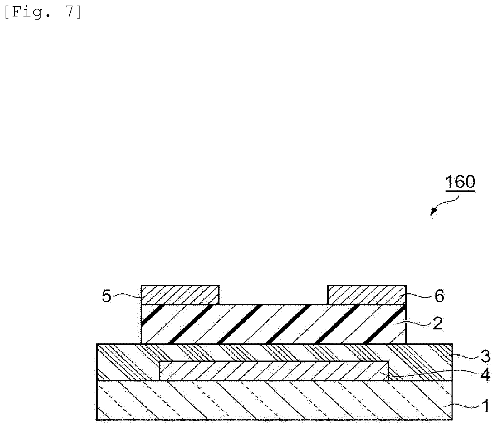

Fig. 7 is a schematic cross-sectional view of an organic film transistor (electric field effect organic film transistor) according to a seventh embodiment. The organic film transistor 160 shown in Fig. 7 has a substrate 1, a gate electrode 4 formed on the substrate 1, an insulation layer 3 so formed on the substrate 1 as to cover the gate electrode 4, an organic semiconductor layer 2 so formed as to cover a region of the insulation layer 3 where the gate electrode 4 is formed beneath, a source electrode 5 so formed on the organic semiconductor layer 2 as to partially cover a region of the organic semiconductor layer 2 where the gate electrode 4 is formed beneath, and a drain electrode 6 so formed on the organic semiconductor layer 2 at a prescribed interval from the source electrode 5 as to partially cover a region of the organic semiconductor layer 2 where the gate electrode 4 is formed beneath.

In the organic film transistors according to the first to seventh embodiments, the organic semiconductor layer 2 and/or the organic semiconductor layer 2a is constituted of an organic film composed of the organic semiconductor composition according to the suitable embodiments described above, thereby providing a current pathway (channel) between the source electrode 5 and the drain electrode 6.

The gate electrode 4 controls the quantity of current passing a current pathway (channel) in the organic semiconductor layer 2 and/or the organic semiconductor layer 2a by applying voltage.

### <Production method of organic film transistor>

The method of producing an organic film transistor will be illustrated below, referring to the organic film transistor according to the first embodiment shown in Fig. 3 by way of example.

A substrate 1 is not particularly restricted providing it does not disturb a property as an organic film transistor, and a glass substrate, a flexible film substrate and a plastic substrate can also be used.

First, a gate electrode 4 is formed on the substrate 1 by a vapor deposition method, a sputtering method, a plating method, a CVD method and the like. As the gate electrode 4, an n-type silicon substrate doped at high concentration may be used.

Next, an insulation layer 3 is formed on the gate electrode 4 by a CVD method, a plasma CVD method, a plasma polymerization method, a thermal vapor deposition method, a thermal oxidation method, an anodization method, a cluster ion beam vapor deposition method, an LB method, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method and the like. In the case of use of an n-type silicon substrate doped at high concentration as the gate electrode 4, its surface can be thermally oxidized to form a film of silicon oxide, and this film of silicon oxide may also be used as the insulation layer 3.

Next, a source electrode 5 and a drain electrode 6 are formed on the insulation layer 3 by a vapor deposition method, a sputtering method, a plating method, a CVD method and the like. Though not illustrated in Fig. 3, a layer promoting charge injection may be provided thereafter between the source electrode 5 and the drain electrode 6 and an organic semiconductor layer 2.

When the organic semiconductor layer 2 is formed on the insulation layer 3, it is preferable to use the ink composition described above from the standpoint of production. The organic film transistor of the present invention can be produced using an ink composition by a spin coat method, a casting method, a push coat method, a micro gravure coat method, a gravure coat method, a bar coat method, a roll coat method, a wire bar coat method, a dip coat method, a spray coat method, a screen printing method, a flexo printing method, an offset printing method, an inkjet printing method, a micro contact printing method, a gravure-offset printing method and the like.

After fabrication of an organic film transistor, a protective film is preferably formed on the organic film transistor for protecting the device. By this protective film, the organic film transistor is isolated from atmospheric air and lowering of a property of the organic film transistor can be suppressed. Further, an influence in forming a driving display device on the organic film transistor can be reduced by the protective film.

The method of forming the protective film includes methods of covering with an UV hardening resin, a thermosetting resin, an inorganic SiONx film and the like. For effectively isolating form atmospheric air, it is preferable that a process from fabrication of an organic film transistor until formation of a protective film is conducted without exposing to atmospheric air (for example, in a dried nitrogen atmosphere, in vacuo and the like).

The organic film transistor of the present invention can be suitably used for an organic electroluminescent device, an electronic tag and a liquid crystal display.

The composition or the polymer compound of the present invention can also be used for production of an OFET sensor. In the OFET sensor of the present invention, an organic electric field effect transistor is used as a signal conversion device in outputting an input signal as an electric signal, and sensitivity function or selectivity function is imparted to any structure of a metal, an insulation film and an organic semiconductor layer. The OFET sensor of the present invention includes, for example, a biosensor, a gas sensor, an ion sensor and a humidity sensor.

The biosensor has a substrate and an organic film transistor disposed on the substrate. The organic film transistor has an organic semiconductor layer, a source region and a drain region disposed in contact with the organic semiconductor, a channel region in the organic semiconductor layer disposed between the source region and the drain region, a gate electrode capable of applying electric filed on the channel region, and a gate insulation film disposed between the channel region and the gate electrode. The organic film transistor has a probe (sensitive region) specifically interacting with a standard substance in the channel region and/or the gate insulation film, and when the concentration of the standard substance changes, a characteristic change occurs in the probe, providing the function as a biosensor.

The means for detecting the standard substance in a test sample includes, for example, biosensors in which biomolecules such as nucleic acids, proteins and the like or artificially synthesized functional groups are fixed as a probe to the surface of a solid phase support.

In this method, the standard substance is captured to the surface of a solid phase support by utilizing specific affinity of biomolecules such as a mutual action of complementary nucleic acid chains, a mutual action of an antigen-antibody reaction, a mutual action of an enzyme-substrate reaction, a receptor-ligand mutual action and the like. Therefore, a substance showing specific affinity with the standard substance is selected as a probe.

The probe is fixed to the surface of a solid phase support by a method according to the kind of the probe and the kind of the solid phase support. Alternatively, it is also possible to synthesize a probe on the surface of a solid phase support (for example, a method of synthesizing a probe by a nucleic acid elongating reaction). In any cases, the probe-fixed solid phase support surface is brought into contact with a test sample, and culturing is performed under suitable conditions, thus, a probe-standard substance complex is formed on the surface of the solid phase support. The channel region and/or the gate insulation film itself of the organic film transistor may function as a probe.

The gas sensor has a substrate and an organic film transistor disposed on the substrate. The organic film transistor has an organic semiconductor layer, a source region and a drain region disposed in contact with the organic semiconductor, a channel region in the semiconductor layer disposed between the source region and the drain region, a gate electrode capable of applying electric field to the channel region, and a gate insulation film disposed between the channel region and the gate electrode. The channel region and/or the gate insulation film of the organic film transistor functions as a gas sensitive part. When a detection gas is adsorbed to or desorbed from the gas sensitive part, characteristic changes (of electric conductivity, dielectric constant and the like) occur on the gas sensitive part, providing a function as a gas sensor.

The gas to be detected includes, for example, an electron accepting gas and an electron donating gas. The electron accepting gas includes, for example, gases of halogens such as F₂, Cl₂ and the like; nitrogen oxide gases; sulfur oxide gases; and gases of organic acids such as acetic acid and the like. The electron donating gas includes, for example, an ammonia gas; gases of amines such as aniline and the like; a carbon monoxide gas; and a hydrogen gas.

The composition or the polymer compound of the present invention can also be used for production of a pressure sensor. The pressure sensor of the present invention has a substrate and an organic film transistor provided on the substrate. The organic film transistor has an organic semiconductor layer, a source region and a drain region disposed in contact with the organic semiconductor, a channel region in the organic semiconductor layer disposed between the source region and the drain region, a gate electrode capable of applying electric field on the channel region, and a gate insulation film disposed between the channel region and the gate electrode. The channel region and/or the gate insulation film of the organic film transistor functions as a pressure sensitive part. When the pressure sensitive part senses pressure, a characteristic change occurs on the pressure sensitive part, providing a function as a pressure sensor.

When the gate insulation film functions as a pressure sensitive part, it is preferable that the gate insulation film contains an organic material, since an organic material is excellent in flexibility and a stretching property as compared with an inorganic material.

When the channel region functions as a pressure sensitive part, the organic film transistor may further have an orientation layer for further enhancing crystallinity of an organic semiconductor contained in the channel region. The orientation layer includes, for example, a monomolecular film formed on the gate insulation film by using a silane coupling agent such as hexamethyldisilazane and the like.

The composition or the polymer compound of the present invention can also be used for production of a conductivity modulation type sensor. The conductivity modulation type sensor of the present invention uses a conductivity measuring device as a signal conversion device in outputting an input signal as an electric signal, and sensitivity function or selectivity function against sensor target input is imparted to a film containing the composition or the polymer compound of the present invention or to a coat of a film containing the composition or the polymer compound of the present invention. The conductivity modulation type sensor of the present invention detects the sensor target input as a variation of conductivity of the composition or the polymer compound of the present invention. The conductivity modulation type sensor of the present invention includes, for example, a biosensor, a gas sensor, an ion sensor and a humidity sensor.

The composition or the polymer compound of the present invention can also be used for production of an amplifying circuit containing an organic electric field effect transistor as an amplifying circuit for amplifying the output signal from various sensors such as a biosensor, a gas sensor, an ion sensor, a humidity sensor, a pressure sensor and the like formed separately.

The composition or the polymer compound of the present invention can also be used for production of a sensor array containing a plurality of various sensors such as a biosensor, a gas sensor, an ion sensor, a humidity sensor, a pressure sensor and the like.

Further, the composition or the polymer compound of the present invention can also be used for production of an amplifying circuit-equipped sensor array containing a plurality of various sensors such as a biosensor, a gas sensor, an ion sensor, a humidity sensor, a pressure sensor and the like formed separately and containing an organic electric field effect transistor as an amplifying circuit for individually amplifying the output signal from each sensor.

### EXAMPLES

Examples are shown below for illustrating the present invention further in detail, but the present invention is not limited to them.

### (NMR analysis)

For NMR measurement, a compound was dissolved in deuterated chloroform and NMR was measured using an NMR apparatus (INOVA300, manufactured by Varian).

### (Molecular weight analysis)

The number-average molecular weight and the weight-average molecular weight of a polymer compound were measured using gel permeation chromatography (GPC, manufactured by Waters, trade name: Alliance GPC 2000). The polymer compound to be measured was dissolved in ortho dichlorobenzene, and the solution was injected into GPC.

As the mobile phase of GPC, ortho dichlorobenzene was used. As the column, TSKgel GMHHR-H(S)HT (two columns are connected, manufactured by Tosoh Corp.) was used. As the detector, an UV detector was used.

### Synthesis Example 1

### (Synthesis of compound 2)

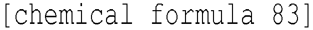

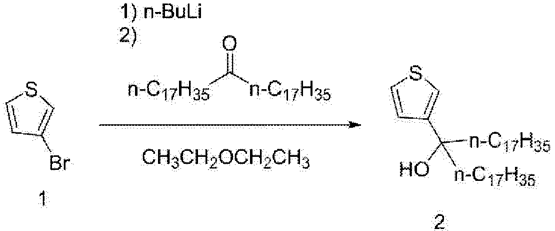

A nitrogen gas atmosphere was prepared in a reaction vessel, then, a compound 1 (32 g, 0.20 mol) and dehydrated diethyl ether (470 mL) were added, and a uniform solution was prepared. While keeping the resultant solution at -68°C, a 1.60 M n-butyllithium hexane solution (135 mL, 0.22 mol) was dropped over a period of 30 minutes. Thereafter, the mixture was stirred at -68°C for 2 hours. Thereafter, to this was added 18-pentatriacontanone (69.7 g, 0.14 mol), and the mixture was stirred for 10 minutes at -78°C, then, the mixture was stirred for 5 hours at room temperature (25°C). Thereafter, to this was added water (200 mL) to stop the reaction, and a 10 wt% acetic acid aqueous solution was added to make the reaction solution acidic. Thereafter, the reaction product was extracted using hexane. The resultant organic layer was washed with water, dried over anhydrous magnesium sulfate, and filtrated. The resultant filtrate was concentrated by an evaporator, then, the solvent was distilled off, to obtain 125 g of a compound 2. The yield was 100%.

¹H-NMR (300 MHz, CDCl₃) : δ (ppm) = 0.88 (t, 6H), 1.25 (m, 60H), 1.75 (m, 4H), 6.96 (d, 1H), 7.27 (d, 1H).

### Synthesis Example 2

### (Synthesis of compound 3)

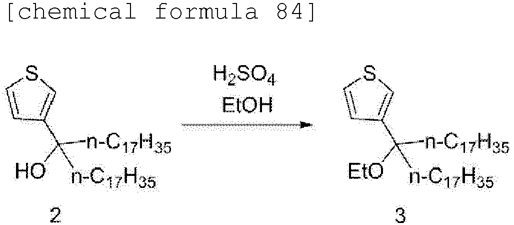

A nitrogen gas atmosphere was prepared in a reaction vessel, then, the compound 2 (232 g, 0.39 mol), dehydrated ethanol (880 mL) and hexane (350 mL) were added, and a suspension was prepared. To the resultant suspension was added 96 wt% concentrated sulfuric acid (31 mL, 0.59 mol), then, the mixture was stirred at room temperature for 6 hours. Thereafter, to this was added water (200 mL) to stop the reaction, and the reaction product was extracted using hexane. The resultant organic layer was washed with water, dried over anhydrous magnesium sulfate, and filtrated. The resultant filtrate was concentrated by an evaporator, then, the solvent was distilled off. The resultant residue was purified using silica gel column chromatography using hexane as a moving bed, to obtain 104 g of a compound 3. The yield was 43%.

¹H-NMR (300 MHz, CDCl₃): δ (ppm) =0.88 (t, 6H), 1.13 (t, 3H), 1.24 (m, 60H), 1.77 (m, 4H), 3.15 (q, 2H), 7.05 (m, 2H), 7.24 (d, 1H).

### Synthesis Example 3

### (Synthesis of compound 4)

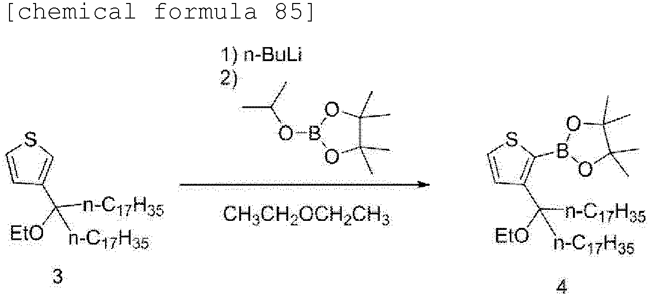

A nitrogen gas atmosphere was prepared in a reaction vessel, then, the compound 3 (104 g, 0.17 mol) and dehydrated diethyl ether (1020 mL) were added, and a uniform solution was prepared. While keeping the resultant solution at -68°C, a 1.60 M n-butyllithium hexane solution (136 mL, 0.22 mol) was dropped over a period of 10 minutes. Thereafter, the mixture was stirred for 10 minutes at -68°C, then, the mixture was stirred for 1.5 hours at room temperature (25°C). Thereafter, while keeping the resultant solution at -68°C, 2-isopropoxy-4,4,5,5-tetramethyl-1,3,2-dioxaborolane (62.5 g, 0.34 mmol) was added. Thereafter, the mixture was stirred for 10 minutes at -68°C, then, the mixture was stirred for 2 hours at room temperature (25°C). Thereafter, to this was added water (100 mL) to stop the reaction, and the reaction product was extracted using diethyl ether. The resultant organic layer was washed with water, dried over anhydrous magnesium sulfate, and filtrated. The resultant filtrate was concentrated by an evaporator, then, the solvent was distilled off, to obtain 117 g of a compound 4. The yield was 93%.

¹H-NMR (300 MHz, CDCl₃): δ (ppm) =0.88 (t, 6H), 1.24 (m, 75H), 1.99 (m, 4H), 3.22 (q, 2H), 7.26 (d, 1H), 7.42 (d, 1H).

### Synthesis Example 4

### (Synthesis of compound 6)

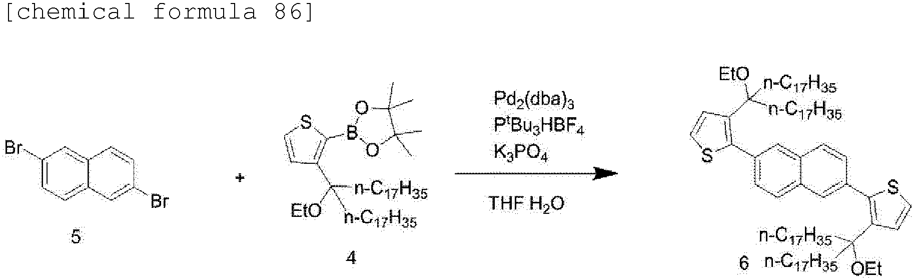

A nitrogen gas atmosphere was prepared in a reaction vessel equipped with a reflux condenser, then, a compound 5 (4.80 g, 16.8 mmol) and dry THF (280 mL) were added, and the mixture was deaerated for 30 minutes by bubbling with an argon gas. Thereafter, to this were added tris(dibenzylideneacetone)dipalladium(0) (769 mg, 0.839 mmol), tri-tert-butylphosphonium tetrafluoroborate (1.02 g, 3.36 mmol) and a 3 M potassium phosphate aqueous solution (84 mL), and the mixture was heated at 80°C. Thereafter, a dry THF (170 mL) solution of the compound 4 (44.7 g, 42.0 mmol) which had been deaerated for 30 minutes by bubbling with an argon gas was dropped into this at 80°C over a period of 5 minutes, and the mixture was heated at the same temperature for 4.5 hours. Thereafter, the reaction product was extracted using hexane (200 mL) . The resultant organic layer was washed with saturated saline, dried over anhydrous magnesium sulfate, and filtrated. The resultant filtrate was concentrated by an evaporator, then, the solvent was distilled off. The resultant residue was purified using silica gel column chromatography using a mixed solvent of hexane and chloroform as a moving bed, to obtain 6.8 g of a compound 6. The yield was 30%. This operation was repeated, to obtain a necessary amount of the compound 6.

¹H-NMR (300 MHz, CDCl₃): δ (ppm) = 0.88 (t, 12H), 0.98 (t, 6H), 1.24 (m, 120H), 1.66 (m, 8H), 3.21 (q, 4H), 7.10 (d, 2H), 7.22 (d, 2H), 7.53 (d, 2H), 7.74 (d, 2H), 7.85 (s, 2H).

### Synthesis Example 5

### (Synthesis of compound 7)

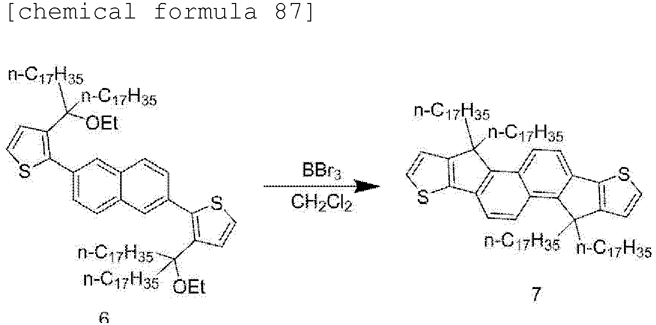

A nitrogen gas atmosphere was prepared in a reaction vessel, then, the compound 6 (7.68 g, 5.78 mmol) and dry methylene chloride (190 mL) were added. Thereafter, to this was added a 1 M boron tribromide methylene chloride solution (23.1 mL, 23.1 mmol) at -78°C, then, the mixture was heated up to room temperature, and stirred at room temperature for 4 hours. Thereafter, to this was added water, and the reaction product was extracted using chloroform. The resultant organic layer was washed with water, dried over anhydrous magnesium sulfate, and filtrated. The resultant filtrate was concentrated by an evaporator, then, the solvent was distilled off. The resultant residue was purified using silica gel column chromatography using hexane as a moving bed, to obtain 4.78 g of a compound 7. The yield was 67%.

¹H-NMR (300 MHz, CD₂Cl₂): δ (ppm) = 0.93 (t, 12H), 1.24 (m, 120H), 2.35 (m, 8H), 7.13 (d, 2H), 7.40 (d, 2H), 7.74 (d, 2H), 8.18 (d, 2H).

### Synthesis Example 6

### (Synthesis of compound 8)

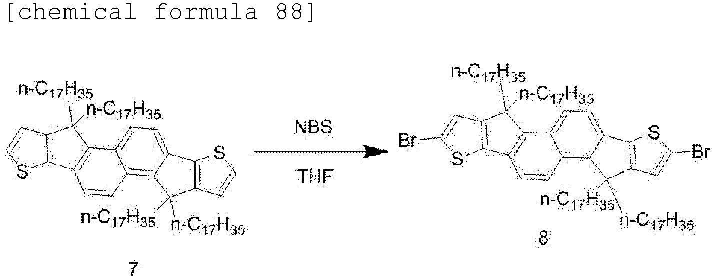

A nitrogen gas atmosphere was prepared in a reaction vessel, then, the compound 7 (4.77 g, 3.78 mmol) and dry THF (375 mL) were added. Thereafter, to this was added N-bromosuccinic imide (1.47 g, 8.26 mmol) at room temperature, and the mixture was stirred at room temperature for 3 hours. Thereafter, to this were added a saturated sodium thiosulfate aqueous solution (10 mL) and water (20 mL), and the mixture was stirred for 5 minutes. Thereafter, the reaction product was extracted using hexane. The resultant organic layer was washed with water, dried over anhydrous magnesium sulfate, and filtrated. The resultant filtrate was concentrated by an evaporator, then, the solvent was distilled off. The resultant residue was purified using silica gel column chromatography using hexane as a moving bed, and recrystallization was performed using hexane, to obtain 4.06 g of a compound 8. The yield was 76%.

¹H-NMR (300 MHz, CDCl₃): δ (ppm) = 0.88 (t, 12H), 1.24 (m, 120H), 2.22 (m, 8H), 7.052 (s, 2H), 7.57 (d, 2H), 7.04 (d, 2H).

### Synthesis Example 7

### (Synthesis of polymer compound A)

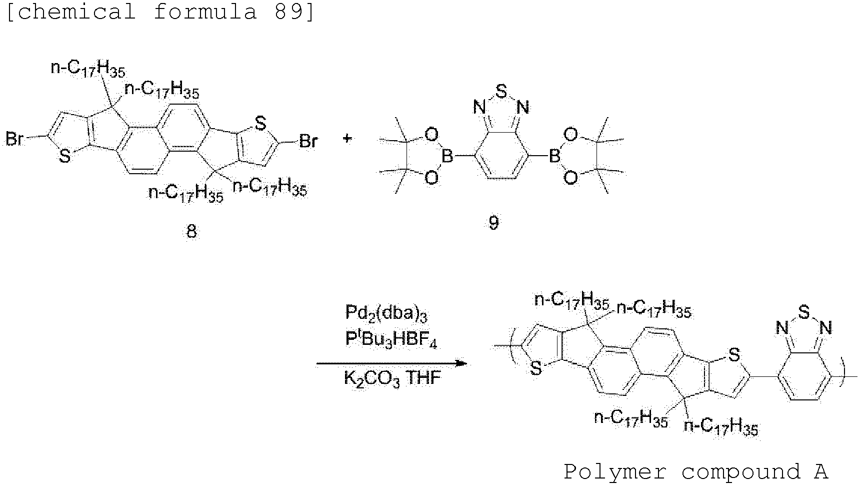

A nitrogen gas atmosphere was prepared in a reaction vessel, then, the compound 8 (0.285 g, 0.200 mmol), a compound 9 (0.078 g, 0.200 mmol), tetrahydrofuran (20 mL), tris(dibenzylideneacetone)dipalladium (3.7 mg) and tri-tert-butylphosphonium tetrafluoroborate (4.6 mg) were added, and the mixture was stirred. Thereafter, to this was added a 2 mol/L potassium carbonate aqueous solution (100 mL), the temperature thereof was raised up to 80°C, then, the mixture was stirred at 80°C for 5 hours. Thereafter, to this was added phenylboronic acid (10.0 mg), and the mixture was stirred at 80°C for 1 hour. Thereafter, to this was added sodium N,N-diethyldithiocarbamate trihydrate (0.1 g), and the mixture was stirred at 80°C for 3 hours. The resultant reaction solution was dropped into water, then, extracted using toluene. The resultant organic layer was washed with an acetic acid aqueous solution and water, then, purified using a silica gel column. The resultant organic layer was dropped into acetone, to obtain a deposit. The resultant deposit was washed in a Soxhlet apparatus using acetone as a solvent, and dried, to obtain a polymer compound A. The amount obtained was 260 mg, and the polymer compound had a polystyrene-equivalent number-average molecular weight of 5.5×10⁴ and a polystyrene-equivalent weight-average molecular weight of 1.5×10⁵.

### Synthesis Example 8

### (Synthesis of polymer compound B)

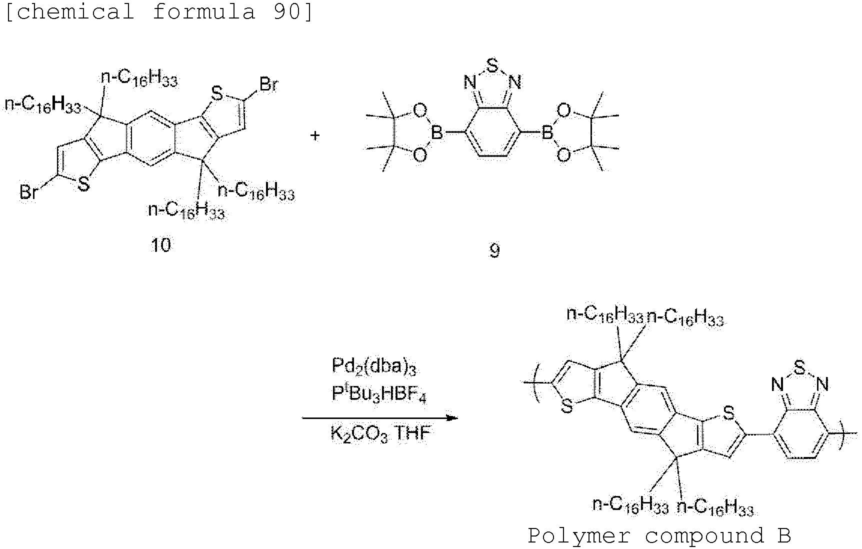

A nitrogen gas atmosphere was prepared in a reaction vessel, then, a compound 9 (0.300 g, 0.227 mmol), a compound 10 (0.0881 g, 0.227 mmol) synthesized according to a method described in "J. Am. Chem. Soc., 2010, 132, 11437-11439", tetrahydrofuran (30 mL), tris(dibenzylideneacetone)dipalladium (4.2 mg) and tri-tert-butylphosphonium tetrafluoroborate (5.3 mg) were added, and the mixture was stirred. Thereafter, to this was added a 2 mol/L potassium carbonate aqueous solution (1.13 mL), the temperature thereof was raised up to 80°C, then, the mixture was stirred at 80°C for 5 hours. Thereafter, to this was added phenylboronic acid (10.0 mg), and the mixture was stirred at 80°C for 1 hour. Thereafter, to this was added sodium N,N-diethyldithiocarbamate trihydrate (0.1 g), and the mixture was stirred at 80°C for 3 hours. The resultant reaction solution was dropped into water, then, extracted using toluene. The resultant organic layer was washed with an acetic acid aqueous solution and water, then, purified using a silica gel column. The resultant organic layer was dropped into acetone, to obtain a deposit. The resultant deposit was washed in a Soxhlet apparatus using acetone as a solvent, to obtain a polymer compound B. The amount obtained was 272 mg, and the polymer compound had a polystyrene-equivalent number-average molecular weight of 3.6×10⁴ and a polystyrene-equivalent weight-average molecular weight of 1.6×10⁵.

### Synthesis Example 9

### (Synthesis of compound C)

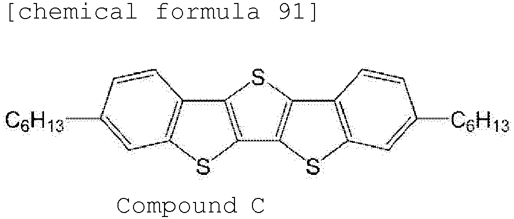

The compound C was synthesized according to a method described in International Publication WO2005/087780.

### Example 1

### (Fabrication and evaluation of organic film transistor 1)

Using a solution containing the polymer compound A and the compound C, an organic film transistor having a structure shown in Fig. 1 was fabricated.

A glass substrate (substrate 1) was ultrasonically cleaned with acetone for 10 minutes, then, irradiated with ozone UV for 20 minutes.

Next, on this substrate 1, gold acting as a source electrode 5 and a drain electrode 6 was formed by a vapor deposition method using a shadow mask. In this operation, the source electrode 5 and the drain electrode 6 had a channel length of 20 µm and a channel width of 2 mm.

Next, the above-described substrate was immersed in a phenylethyltrichlorosilane toluene solution for 2 minutes, thereby silane-treating the surface of the substrate. Thereafter, the above-described substrate was further immersed in a perfluorobenzenethiol isopropyl alcohol solution for 2 minutes, to modify the surface of the gold electrode formed on the substrate.

Next, a xylene solution containing the polymer compound A and the compound C (0.6% by weight, polymer compound A/compound C = 75 parts by mass/25 parts by mass) was prepared, and this xylene solution was filtrated through a membrane filter, to prepare an application solution.

Next, this application solution was spin-coated to form a film having a thickness of 20 nm on the above-described surface-treated substrate 1, the source electrode 5 and the drain electrode 6, and the film was heated on a hot plate at 80°C for 10 minutes under a nitrogen gas atmosphere, to form an organic semiconductor layer 2.

Next, on this organic semiconductor layer 2, an insulation film made of Teflon (registered trademark) was formed to give a thickness of 445 nm by a spin coat method, and the film was heated on a hot plate at 80°C for 10 minutes, to form an insulation layer 3.

Next, on this insulation film 3, aluminum acting as a gate electrode 4 was formed by a vapor deposition method using a shadow mask, to fabricate an organic film transistor 1.

Under conditions in which the source-drain voltage Vsd of the resultant organic film transistor 1 was set at -40 V and the gate voltage Vg thereof was varied from 40 to -40 V, the transistor property was measured.

The organic film transistor 1 had an electric field effect mobility of 1.69 cm²/Vs.

### Example 2

### (Fabrication and evaluation of organic film transistor 2)

An organic film transistor 2 was fabricated in the same manner as in Example 1 excepting that a xylene solution containing the polymer compound B and the compound C (0.6% by weight, polymer compound B/compound C = 75 parts by mass/25 parts by mass) was used instead of the xylene solution containing the polymer compound A and the compound C (0.6% by weight, polymer compound A/compound C = 75 parts by mass/25 parts by mass). Under conditions in which the source-drain voltage Vsd of the resultant organic film transistor 2 was set at -40 V and the gate voltage Vg thereof was varied from 40 to -40 V, the transistor property was measured. The organic film transistor 2 had an electric field effect mobility of 1.53 cm²/Vs.

### Comparative Example 1

### (Fabrication and evaluation of organic film transistor C1)

An organic film transistor C1 was fabricated in the same manner as in Example 1 excepting that a xylene solution containing the polymer compound B (0.6% by weight) was used instead of the xylene solution containing the polymer compound A and the compound C (0.6% by weight, polymer compound A/compound C = 75 parts by mass/25 parts by mass). Under conditions in which the source-drain voltage Vsd of the resultant organic film transistor C1 was set at -40 V and the gate voltage Vg thereof was varied from 40 to -40 V, the transistor property was measured. The organic film transistor C1 had an electric field effect mobility of 0.59 cm²/Vs.

### Synthesis Example 10

### (Synthesis of compound 12)

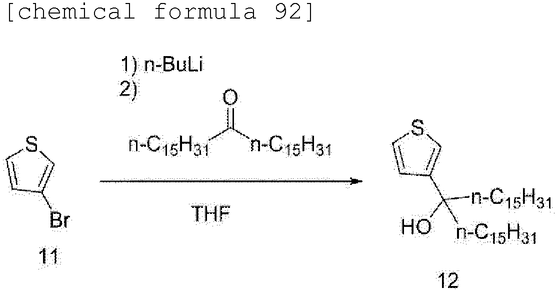

A nitrogen gas atmosphere was prepared in a reaction vessel, then, a compound 11 (16.0 g, 98.1 mmol) and dehydrated diethyl ether (280 mL) were added, and a uniform solution was prepared. While keeping the resultant solution at -68°C, a 1.65 M n-butyllithium hexane solution (65.4 mL, 0.108 mol) was dropped over a period of 10 minutes. Thereafter, the mixture was stirred at -68°C for 5 hours. Thereafter, to this was added 16-hentriacontanone (48.7 g, 0.108 mol), and the mixture was stirred for 10 minutes at -78°C, then, the mixture was stirred for 5 hours at room temperature (25°C). Thereafter, to this was added water (200 mL) to stop the reaction, and a 10 wt% acetic acid aqueous solution was added to make the reaction solution acidic. Thereafter, the reaction product was extracted using hexane. The resultant organic layer was washed with water, then, dried over anhydrous magnesium sulfate, and filtrated. The resultant filtrate was concentrated by an evaporator, then, the solvent was distilled off, to obtain 70 g of a compound 12. The yield was 100%.

¹H-NMR (300 MHz, CDCl₃): δ (ppm) = 0.88 (t, 6H), 1.253 (m, 52H), 1.75 (m, 4H), 6.96 (d, 1H), 7.27 (d, 1H).

### Synthesis Example 11

### (Synthesis of compound 13)

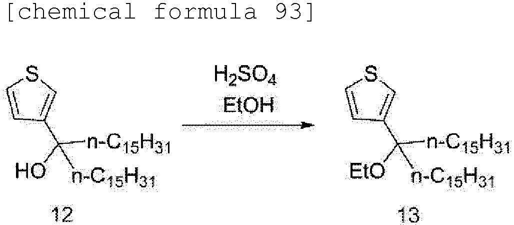

A nitrogen gas atmosphere was prepared in a reaction vessel, then, the compound 12 (53 g, 98 mmol) and dehydrated ethanol (500 mL) were added, and a suspension was prepared. To the resultant suspension was added concentrated sulfuric acid (3.0 mL, 5.5 g, 56 mmol), then, the mixture was stirred at room temperature for 3 hours. Thereafter, to this was added water (200 mL) to stop the reaction, and the reaction product was extracted using hexane. The resultant organic layer was washed with water, dried over anhydrous magnesium sulfate, and filtrated. The resultant filtrate was concentrated by an evaporator, then, the solvent was distilled off. The resultant residue was purified using silica gel column chromatography using hexane as a moving bed, to obtain 20.7 g of a compound 13 as a colorless oil. The yield was 37%.

¹H-NMR (300 MHz, CDCl₃): δ (ppm) = 0.88 (t, 6H), 1.13 (t, 3H), 1.24 (m, 52H), 1.77 (m, 4H), 3.15 (q, 2H), 7.05 (m, 2H), 7.24 (d, 1H).

### Synthesis Example 12

### (Synthesis of compound 14)

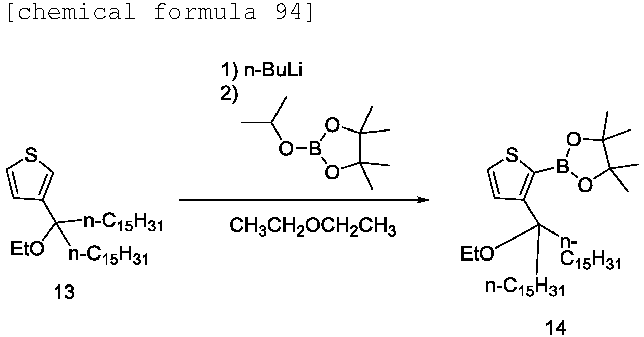

A nitrogen gas atmosphere was prepared in a reaction vessel, then, the compound 13 (2.0 g, 3.6 mmol) and dehydrated diethyl ether (35 mL) were added, and a uniform solution was prepared. While keeping the resultant solution at -68°C, a 1.65 M n-butyllithium hexane solution (2.3 mL, 3.7 mol) was dropped over a period of 10 minutes. Thereafter, the mixture was stirred for 10 minutes at -68°C, then, the mixture was stirred for 1.5 hours at room temperature (25°C). Thereafter, while keeping the resultant solution at -68°C, 2-isopropoxy-4,4,5,5-tetramethyl-1,3,2-dioxaborolane (0.69 g, 3.7 mmol) was added. Thereafter, the mixture was stirred for 10 minutes at -68°C, then, the mixture was stirred for 2 hours at room temperature (25°C). Thereafter, to this was added water (100 mL) to stop the reaction, and the organic layer was extracted using diethyl ether. The resultant organic layer was washed with water, dried over anhydrous magnesium sulfate, and filtrated. The resultant filtrate was concentrated by an evaporator, then, the solvent was distilled off, to obtain 2.45 g of a compound 14. The yield was 100%.

¹H-NMR (300 MHz, CDCl₃): δ (ppm) = 1.34 (s, 12H), 1.99 (m, 4H), 3.22 (q, 2H), 7.264 (d, 1H), 7.422 (d, 1H).

### Synthesis Example 13

### (Synthesis of compound 16)

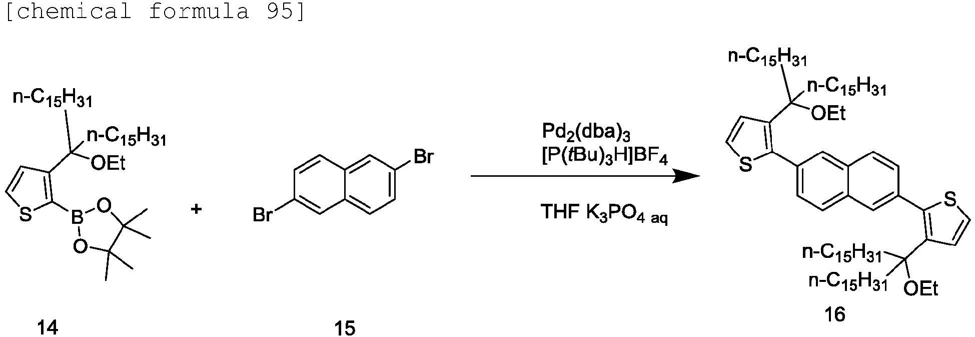

A nitrogen gas atmosphere was prepared in a reaction vessel equipped with a reflux condenser, then, a compound 15 (1.30 g, 4.50 mmol) and dry THF (160 mL) were added, and the mixture was deaerated for 30 minutes by bubbling with argon. Thereafter, to this were added tris(dibenzylideneacetone)dipalladium(0) (210 mg, 0.23 mmol), tri-tert-butylphosphonium tetrafluoroborate (280 mg, 0.90 mmol) and a 3 M potassium phosphate aqueous solution (23 mL), and the mixture was heated at 80°C. Thereafter, a dry THF (76 mL) solution of the compound 14 (12.53 g, 18.2 mmol) deaerated for 30 minutes by bubbling with argon was dropped into this at 80°C over a period of 10 minutes, and the mixture was heated at the same temperature for 6 hours. Thereafter, the reaction product was extracted using hexane (200 mL). The resultant organic layer was washed with saturated saline, dried over anhydrous magnesium sulfate, and filtrated. The resultant filtrate was concentrated by an evaporator, then, the solvent was distilled off. The resultant residue was purified using silica gel column chromatography using a mixed solvent of hexane and chloroform as a moving bed, to obtain 2.9 g of a compound 16. The yield was 50%.

¹H-NMR (300 MHz, CDCl₃): δ (ppm) = 0.88 (t, 12H), 0.98 (t, 6H), 1.24 (m, 104H), 1.66 (m, 8H), 3.21 (q, 4H), 7.10 (d, 2H), 7.22 (d, 2H), 7.53 (d, 2H), 7.74 (d, 2H), 7.85 (s, 2H).

### Synthesis Example 14

### (Synthesis of compound 13)

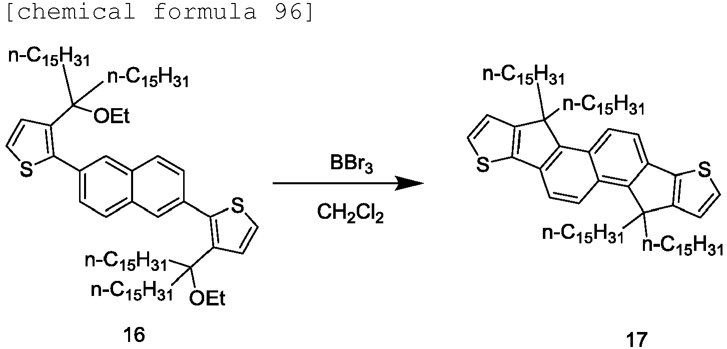

A nitrogen gas atmosphere was prepared in a reaction vessel, then, the compound 16 (3.29 g, 2.63 mmol) and dry methylene chloride (260 mL) were added. Thereafter, to this was added a 1 M boron tribromide methylene chloride solution (10.5 mL, 20.5 mmol) at -78°C, then, the mixture was heated up to room temperature, and stirred at room temperature for 4.5 hours. Thereafter, to this was added water, and the reaction product was extracted using chloroform. The resultant organic layer was washed with water, dried over anhydrous magnesium sulfate, and filtrated. The resultant filtrate was concentrated by an evaporator, then, the solvent was distilled off. The resultant residue was purified using silica gel column chromatography using hexane as a moving bed, then, recrystallization was performed using hexane, to obtain 2.45 g of a compound 17. The yield was 80%.

¹H-NMR (300 MHz, CD₂Cl₂): δ (ppm) = 0.93 (t, 12H), 1.24 (m, 104H), 2.35 (m, 8H), 7.13 (d, 2H), 7.40 (d, 2H), 7.74 (d, 2H), 8.18 (d, 2H).

### Synthesis Example 15

### (Synthesis of compound 18)

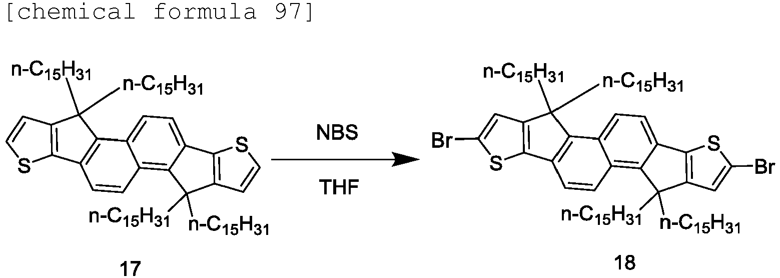

A nitrogen gas atmosphere was prepared in a reaction vessel, then, the compound 13 (2.46 g, 2.12 mmol) and dry THF (210 mL) were added. Thereafter, to this was added N-bromosuccinic imide (0.830 g, 4. 67 mmol) at room temperature, and the mixture was stirred at room temperature for 3 hours. Thereafter, to this were added a saturated sodium thiosulfate aqueous solution (2 mL) and water (100 mL). Thereafter, the reaction product was extracted using hexane. The resultant organic layer was washed with water, dried over anhydrous magnesium sulfate, and filtrated. The resultant filtrate was concentrated by an evaporator, then, the solvent was distilled off. The resultant residue was purified using silica gel column chromatography using hexane as a moving bed, and recrystallization was performed using a mixed solvent of hexane and methanol, to obtain 2.1 g of a compound 18 as an orange solid. The yield was 77%.

¹H-NMR (300 MHz, CDCl₃): δ (ppm) = 0.88 (t, 12H), 1.24 (m, 104H), 2.22 (m, 8H), 7.052 (s, 2H), 7.57 (d, 2H), 7.04 (d, 2H).

### Example 3

### (Synthesis of polymer compound D-1)

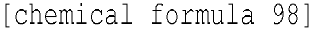

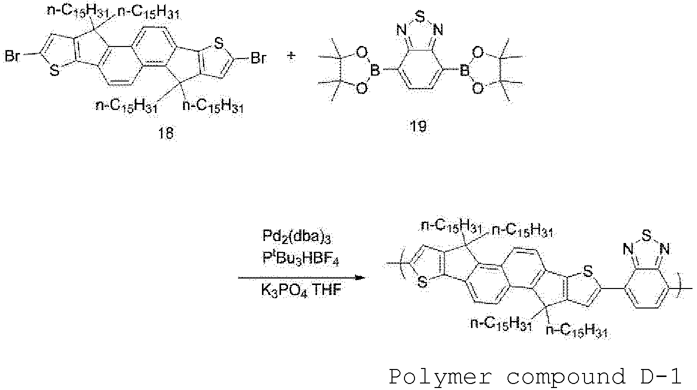

A nitrogen gas atmosphere was prepared in a reaction vessel, then, the compound 18 (266.2 mg, 0.200 mmol), a compound 19 (66.0 mg, 0.169 mmol) and dry THF (20 mL) were added, and the mixture was deaerated for 30 minutes by bubbling with an argon gas. Thereafter, to this were added tris(dibenzylideneacetone)dipalladium(0) (3.7 mg, 4.0 µmol) and tri-tert-butylphosphonium tetrafluoroborate (4.6 mg, 16.0 µmol). Thereafter, to this was added a 3 M potassium phosphate aqueous solution (1.0 mL, 3.0 mmol) which had been deaerated for 30 minutes by bubbling with an argon gas, and the mixture was stirred at 80°C for 3 hours. Thereafter, to this was added a THF solution (1.0 mL) of phenylboronic acid (24.4 mg, 0.200 mmol) which had been deaerated for 30 minutes by bubbling with an argon gas, and the mixture was stirred at 80°C for 1 hour. Thereafter, to this were added sodium N,N-diethyldithiocarbamate trihydrate (1.3 g) and water (11.3 g), and the mixture was stirred at 80°C for 3 hours. The resultant reaction solution was liquid-separated, and the resultant organic layer was washed with water and a 10% by weight acetic acid aqueous solution. The resultant organic layer was dropped into methanol (63 mL), to obtain a deposit. The resultant deposit was purified in a silica gel column using toluene. The resultant toluene solution was dropped into methanol, to obtain a deposit. The resultant deposit was filtrated, then, washed in a Soxhlet apparatus using acetone as a solvent, to obtain 203 mg of a polymer compound D-1. The polymer compound D-1 had a polystyrene-equivalent number-average molecular weight of 6.6×10⁴ and a polystyrene-equivalent weight-average molecular weight of 2.0×10⁵.

### Example 4

### (Synthesis of polymer compound D-2)

A polymer compound D-2 (190 mg) was synthesized in the same manner as in Example 3 excepting that the charging amount of the compound 19 was changed from 66.0 mg (0.169 mmol) to 62.1 mg (0.160 mmol). The polymer compound D-2 had a polystyrene-equivalent number-average molecular weight of 4.2×10 and a polystyrene-equivalent weight-average molecular weight of 1.2×10⁵.

### Example 5

### (Synthesis of polymer compound D-3)

A polymer compound D-3 (192 mg) was synthesized in the same manner as in Example 3 excepting that the charging amount of the compound 19 was changed from 66.0 mg (0.169 mmol) to 60.5 mg (0.156 mmol). The polymer compound D-3 had a polystyrene-equivalent number-average molecular weight of 2.4×10 and a polystyrene-equivalent weight-average molecular weight of 8.2×10⁴.

### Example 6

### (Synthesis of polymer compound D-4)

A polymer compound D-4 (195 mg) was synthesized in the same manner as in Example 3 excepting that the charging amount of the compound 19 was changed from 66.0 mg (0.169 mmol) to 59.0 mg (0.152 mmol). The polymer compound D-4 had a polystyrene-equivalent number-average molecular weight of 1.6×10⁴ and a polystyrene-equivalent weight-average molecular weight of 4.3×10⁴.

### Comparative Example 2

### (Synthesis of polymer compound D-5)

A polymer compound D-5 (190 mg) was synthesized in the same manner as in Example 3 excepting that the charging amount of the compound 19 was changed from 66.0 mg (0.169 mmol) to 58.2 mg (0.151 mmol). The polymer compound D-5 had a polystyrene-equivalent number-average molecular weight of 1.5×10⁴ and a polystyrene-equivalent weight-average molecular weight of 2.9×10⁴.

### Comparative Example 3

### (Synthesis of polymer compound D-6)

A polymer compound D-6 (180 mg) was synthesized in the same manner as in Example 3 excepting that the charging amount of the compound 19 was changed from 66.0 mg (0.169 mmol) to 57.4 mg (0.148 mmol). The polymer compound D-6 had a polystyrene-equivalent number-average molecular weight of 1.0×10⁴ and a polystyrene-equivalent weight-average molecular weight of 1.6×10⁴.

### Example 8

### (Fabrication and evaluation of organic film transistor 3)

Using a solution containing the compound D-1, an organic film transistor having a structure shown in Fig. 1 was fabricated.

A glass substrate (substrate 1) was ultrasonically cleaned for 10 minutes with acetone, then, irradiated with ozone UV for 20 minutes.

Next, on this substrate 1, gold acting as a source electrode 5 and a drain electrode 6 was formed by a vapor deposition method using a shadow mask. In this state, the source electrode 5 and the drain electrode 6 had a channel length of 20 µm and a channel width of 2 mm.

Next, the above-described substrate was immersed in a toluene solution of phenylethyltrichlorosilane for 2 minutes, thereby silane-treating the surface of the substrate. Thereafter, the above-described substrate was further immersed in an isopropyl alcohol solution of perfluorobenzenethiol for 2 minutes, to modify the surface of the gold electrode formed on the substrate.

Next, a tetralin solution (0.5% by weight) containing the polymer compound D-1 was prepared, and this tetralin solution was filtrated through a membrane filter, to prepare an application solution.

Next, this application solution was spin-coated to form a film having thickness of about 30 nm on the above-described surface-treated substrate 1, the source electrode 5 and the drain electrode 6, and the film was heated on a hot plate at 80°C for 10 minutes under a nitrogen gas atmosphere, to form an organic semiconductor layer 2.

Next, on this organic semiconductor layer 2, an insulation film made of Teflon (registered trademark) was formed to give a thickness of about 500 nm by a spin coat method, and the film was heated on a hot plate at 80°C for 10 minutes, to form an insulation layer 3.

Next, on this insulation film 3, aluminum acting as a gate electrode 4 was formed by a vapor deposition method using a shadow mask, to fabricate an organic film transistor 3.

Under conditions in which the source-drain voltage Vsd of the resultant organic film transistor 3 was set at -40 V and the gate voltage Vg thereof was varied from 40 to -40 V, the transistor property was measured.

The organic film transistor 3 had an electric field effect mobility of 1.43 cm²/Vs. The results are shown in Table 1.

### Example 9

### (Fabrication and evaluation of organic film transistor 4)

An organic film transistor 4 was fabricated in the same manner as in Example 8 excepting that the polymer compound D-2 was used instead of the polymer compound D-1 in Example 8.

Under conditions in which the source-drain voltage Vsd of the resultant organic film transistor 3 was set at -40 V and the gate voltage Vg thereof was varied from 40 to -40 V, the transistor property was measured.

The organic film transistor 4 had an electric field effect mobility of 1.20 cm²/Vs. The results are shown in Table 1.

### Example 10

### (Fabrication and evaluation of organic film transistor 5)

An organic film transistor 5 was fabricated in the same manner as in Example 8 excepting that the polymer compound D-3 was used instead of the polymer compound D-1 in Example 8.

Under conditions in which the source-drain voltage Vsd of the resultant organic film transistor 5 was set at -40 V and the gate voltage Vg thereof was varied from 40 to -40 V, the transistor property was measured.

The organic film transistor 4 had an electric field effect mobility of 1.12 cm²/Vs. The results are shown in Table 1.

### Example 11

### (Fabrication and evaluation of organic film transistor 6)

An organic film transistor 6 was fabricated in the same manner as in Example 8 excepting that the polymer compound D-4 was used instead of the polymer compound D-1 in Example 8.

Under conditions in which the source-drain voltage Vsd of the resultant organic film transistor 6 was set at -40 V and the gate voltage Vg thereof was varied from 40 to -40 V, the transistor property was measured.

The organic film transistor 6 had an electric field effect mobility of 1.12 cm²/Vs. The results are shown in Table 1.

### Comparative Example 4

### (Fabrication and evaluation of organic film transistor 7)

An organic film transistor 7 was fabricated in the same manner as in Example 8 excepting that the polymer compound D-5 was used instead of the polymer compound D-1 in Example 8.

Under conditions in which the source-drain voltage Vsd of the resultant organic film transistor 7 was set at -40 V and the gate voltage Vg thereof was varied from 40 to -40 V, the transistor property was measured.

The organic film transistor 7 had an electric field effect mobility of 0.56 cm²/Vs. The results are shown in Table 1.

### Comparative Example 5

### (Fabrication and evaluation of organic film transistor 8)

An organic film transistor 8 was fabricated in the same manner as in Example 8 excepting that the polymer compound D-6 was used instead of the polymer compound D-1 in Example 8.

Under conditions in which the source-drain voltage Vsd of the resultant organic film transistor 8 was set at -40 V and the gate voltage Vg thereof was varied from 40 to -40 V, the transistor property was measured.

The organic film transistor 8 had an electric field effect mobility of 0.30 cm²/Vs. The results are shown in Table 1.

**[Table 1]**

| | polymer compound used in organic film transistor | weight-average molecular weight | mobility cm²/Vs |
|---|---|---|---|
| Example 8 | polymer compound D-1 | 2.0×10⁵ | 1.43 |
| Example 9 | polymer compound D-2 | 1.2×10⁵ | 1.20 |
| Example 10 | polymer compound D-3 | 8.2×10⁴ | 1.50 |
| Example 11 | polymer compound D-4 | 4.3×10⁴ | 1.12 |
| Comparative Example 1 | polymer compound B | 1.6×10⁵ | 0.59 |
| Comparative Example 4 | polymer compound D-5 | 2.9×10⁴ | 0.56 |
| Comparative Example 5 | polymer compound D-6 | 1.5×10⁴ | 0.30 |

### Synthesis Example 16

### (Synthesis of compound E)

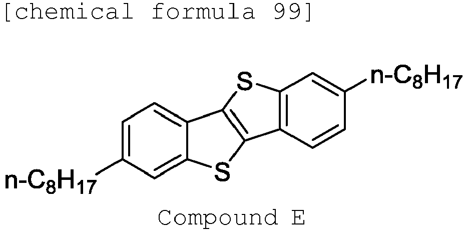

The compound E was synthesized according to a method described in "J. Am. Chem. Soc., 2007, 129, 15732-15733".

### Example 12

### (Synthesis of polymer compound D-7)

A polymer compound D-7 (240 mg) was synthesized in the same manner as in Example 3 excepting that the charging amount of the compound 19 was changed from 66.0 mg (0.169 mmol) to 64.4 mg (0.166 mmol). The polymer compound D-7 had a polystyrene-equivalent number-average molecular weight of 8.4×10 and a polystyrene-equivalent weight-average molecular weight of 1.8×10⁵.

### Example 13

### (Fabrication and evaluation of organic film transistor 9)

An organic film transistor 9 was fabricated in the same manner as in Example 1 excepting that a xylene solution containing the polymer compound D-7 and the compound E (2.0% by weight, polymer compound D-7/compound E = 75 parts by mass/25 parts by mass) was used instead of the xylene solution containing the polymer compound A and the compound C (0.6% by weight, polymer compound A/compound C = 75 parts by mass/25 parts by mass). Under conditions in which the source-drain voltage Vsd of the resultant organic film transistor 9 was set at -40 V and the gate voltage Vg thereof was varied from 40 to -40 V, the transistor property was measured. The organic film transistor 9 had an electric field effect mobility of 3.57 cm²/Vs.

### Industrial Applicability

According to the present invention, a composition and a polymer compound which are useful for production of an organic film transistor excellent in electric field effect mobility can be provided. Further, according to the present invention, an organic semiconductor device containing the composition or the polymer compound can be provided.

### Explanation of reference numerals

1 ... substrate, 2 ... organic semiconductor layer, 3 ... insulation layer, 4 ... gate electrode, 5 ... source electrode, 6 ... drain electrode, 100 ... organic film transistor, 110 ... organic film transistor, 120 ... organic film transistor, 130 ... organic film transistor, 140 ... organic film transistor, 150 ... organic film transistor, 160 ... organic film transistor

## Claims

1. A composition comprising a polymer compound containing a structural unit represented by the formula (1) and a compound represented by the formula (2): 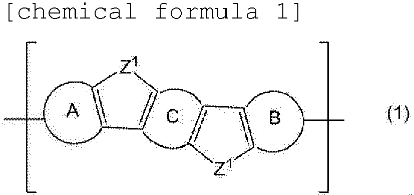 [wherein
Ring A and Ring B each independently represent a heterocyclic ring, and this heterocyclic ring may have a substituent.
Ring C represents an aromatic hydrocarbon ring or a heterocyclic ring, and these rings may have a substituent.
Z¹ represents a group represented by the formula (Z-1), a group represented by the formula (Z-2), a group represented by the formula (Z-3), a group represented by the formula (Z-4) or a group represented by the formula (Z-5). A plurality of Z¹ may be mutually the same or different.] 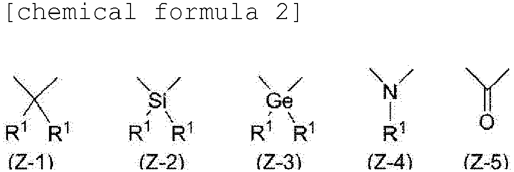
[wherein R¹ represents an alkyl group, a cycloalkyl group, an alkoxy group, a cycloalkoxy group, an alkylthio group, a cycloalkylthio group, an aryl group or a monovalent heterocyclic ring group, and these groups may have a substituent. When there are a plurality of R¹, they may be the same or different.] 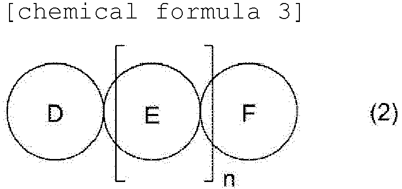 [wherein
n represents an integer of 1 or more.
Ring D and Ring F each independently represent a benzene ring, a 5-membered heterocyclic ring or a 6-membered heterocyclic ring, and these rings may have a substituent.
Ring E represents a benzene ring, a cyclopentadiene ring, a 5-membered heterocyclic ring or a 6-membered heterocyclic ring, and these rings may have a substituent. When there are a plurality of Rings E, they may be the same or different.
Here, Ring D and Ring E are mutually condensed to form a condensed ring, Ring E and Ring F are mutually condensed to form a condensed ring, and when there are a plurality of Rings E, adjacent Rings E are mutually condensed to form a condensed ring.].

2. The composition according to Claim 1, wherein the structural unit represented by the formula (1) is a structural unit represented by the formula (1-1), a structural unit represented by the formula (1-2) or a structural unit represented by the formula (1-3): 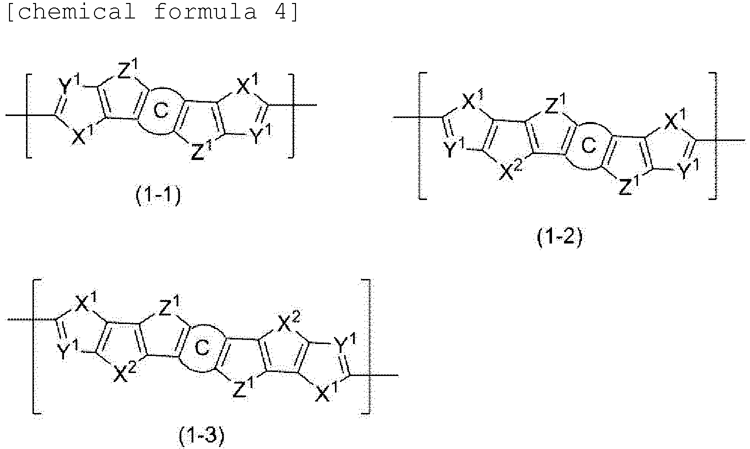 [wherein
Ring C and Z¹ represent the same meaning as described above.
X¹ and X² each independently represent an oxygen atom, a sulfur atom or a selenium atom. A plurality of X¹ may be mutually the same or different. When there are a plurality of X², they may be the same or different.
Y¹ represents a nitrogen atom or a group represented by -CR²=. R² represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent. A plurality of Y¹ may be mutually the same or different.].

3. The composition according to Claim 1 or 2, wherein Ring C is a benzene ring which may have a substituent or a naphthalene ring which may have a substituent.

4. The composition according to Claim 2 or 3, wherein X¹ and X² are a sulfur atom.

5. The composition according to any one of Claims 2 to 4, wherein Y¹ is a group represented by -CH=.

6. The composition according to any one of Claims 1 to 5, wherein Z¹ is a group represented by the formula (Z-1).

7. The composition according to any one of Claims 1 to 6, further comprising a structural unit represented by the formula (3) (different from the structural unit represented by the formula (1)): 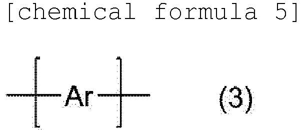 [wherein Ar represents an arylene group or a divalent heterocyclic ring group, and these groups may have a substituent.].

8. The composition according to any one of Claims 1 to 7, wherein the compound represented by the formula (2) is a compound represented by the formula (2-1), a compound represented by the formula (2-2), a compound represented by the formula (2-3), a compound represented by the formula (2-4), a compound represented by the formula (2-5), a compound represented by the formula (2-6), a compound represented by the formula (2-7), a compound represented by the formula (2-8), a compound represented by the formula (2-9), a compound represented by the formula (2-10), a compound represented by the formula (2-11), a compound represented by the formula (2-12), a compound represented by the formula (2-13) or a compound represented by the formula (2-14): 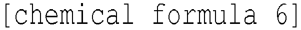 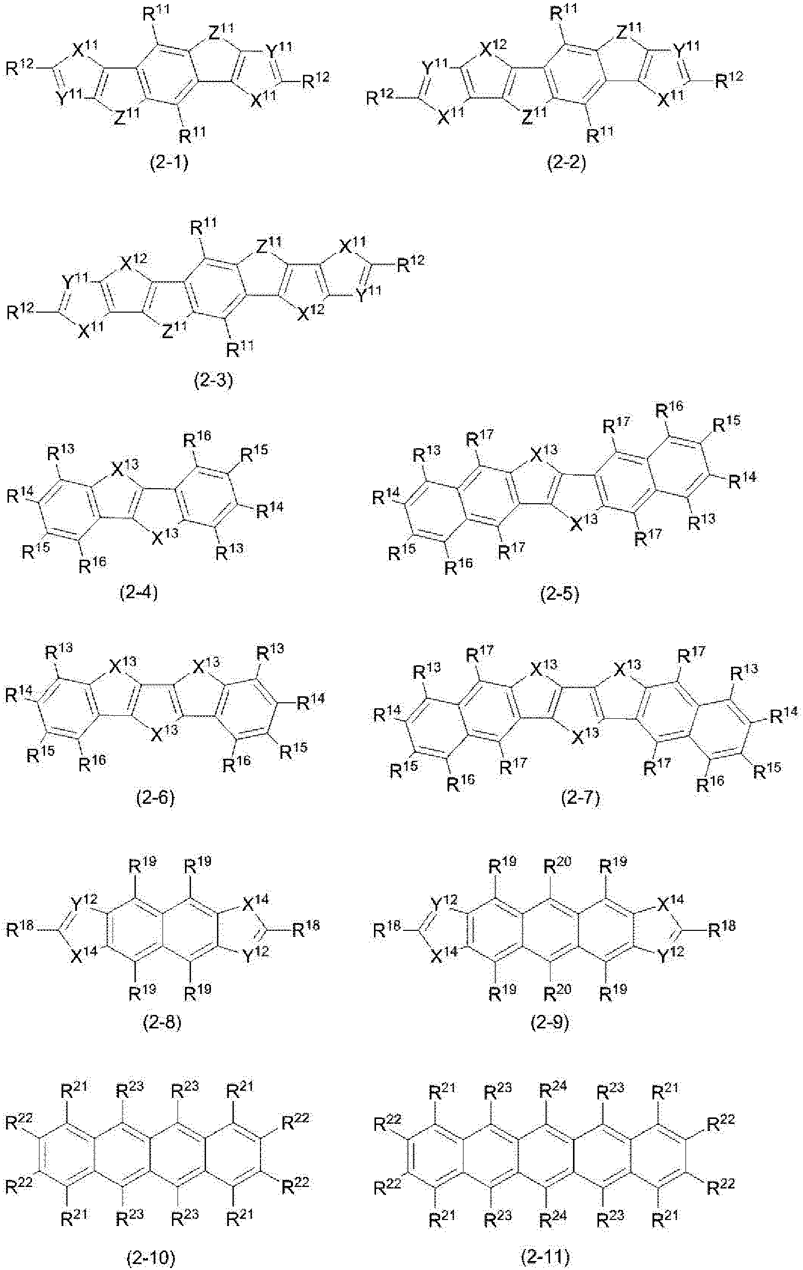 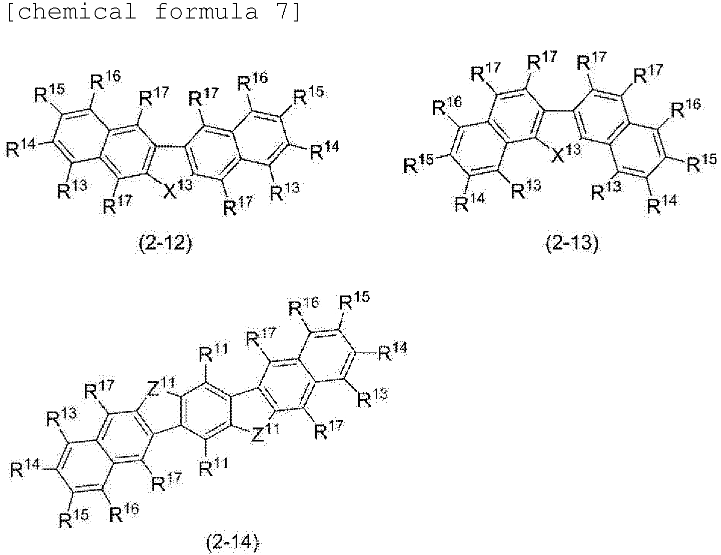 [wherein
Z¹¹ represents a group represented by the formula (Z-1'), a group represented by the formula (Z-2'), a group represented by the formula (Z-3'), a group represented by the formula (Z-4') or a group represented by the formula (Z-5'). A plurality of Z¹¹ may be mutually the same or different.
X¹¹, X¹², X¹³ and X¹⁴ each independently represent an oxygen atom, a sulfur atom or a selenium atom. A plurality of X¹¹, X¹³ and X¹⁴ each may be mutually the same or different. When there are a plurality of X¹², they may be the same or different.
Y¹¹ and Y¹² each independently represent a nitrogen atom or a group represented by -CR²'=. R²' represents a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent. A plurality of Y¹¹ and Y¹² each may be mutually the same or different.
R¹¹, R¹², R¹³ R¹⁴, R¹⁵, R¹⁶, R¹⁷, R¹⁸, R¹⁹, R²⁰, R²¹, R²², R²³ and R²⁴ each independently represent a hydrogen atom, an alkyl group, a cycloalkyl group, an alkoxy group, a cycloalkoxy group, an alkylthio group, a cycloalkylthio group, an aryl group, an alkynyl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group, the alkynyl group and the monovalent heterocyclic ring group each may have a substituent. A plurality of R¹¹, R¹², R¹³, R¹⁴, R¹⁵, R¹⁶, R¹⁷, R¹⁸, R¹⁹, R²⁰, R²¹, R²², R²³ and R²⁴ each may be mutually the same or different.] 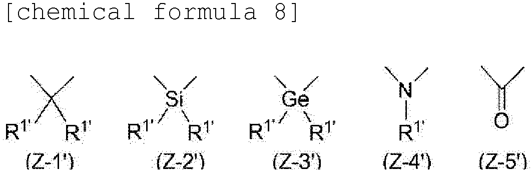
[wherein R¹' represents an alkyl group, a cycloalkyl group, an alkoxy group, a cycloalkoxy group, an alkylthio group, a cycloalkylthio group, an aryl group or a monovalent heterocyclic ring group, and these groups may have a substituent. When there are a plurality of R¹', they may be the same or different.].

9. The composition according to Claim 8, wherein the compound represented by the formula (2) is a compound represented by the formula (2-4), a compound represented by the formula (2-5), a compound represented by the formula (2-6) or a compound represented by the formula (2-7).

10. The composition according to Claim 8 or 9, wherein X¹¹, X¹², X¹³ and X¹⁴ are a sulfur atom.

11. The composition according to any one of Claims 8 to 10, wherein Y¹¹ and Y¹² are a group represented by -CH=.

12. The composition according to any one of Claims 8 to 11, wherein Z¹¹ is a group represented by the formula (Z-1').

13. The composition according to any one of Claims 1 to 12, wherein the content of the compound represented by the formula (2) is 5 to 50 parts by mass with respect to 100 parts by mass of the sum of the polymer compound containing a structural unit represented by the formula (1) and the compound represented by the formula (2).

14. A polymer compound comprising a structural unit represented by the formula (4) and having a polystyrene-equivalent weight-average molecular weight of 3.0×10⁴ or more: 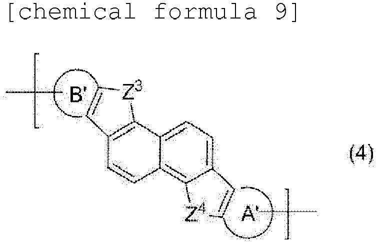 [wherein
Ring A' and Ring B' each independently represent a heterocyclic ring, and the heterocyclic ring may have a substituent.
Z³ and Z⁴ each independently represent a group represented by the formula (Z-1"), a group represented by the formula (Z-2"), a group represented by the formula (Z-3"), a group represented by the formula (Z-4") or a group represented by the formula (Z-5").] 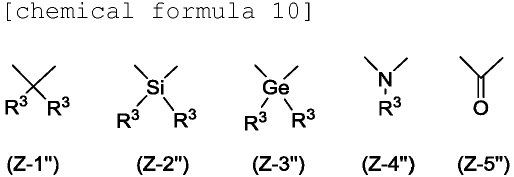
[wherein R³ represents an alkyl group which may have a substituent. When there are a plurality of R³, they may be the same or different.].

15. The polymer compound according to Claim 14, wherein the structural unit represented by the formula (4) is a structural unit represented by the formula (5): 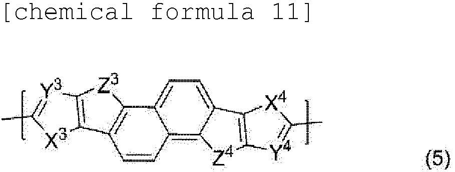 [wherein
Z³ and Z⁴ represent the same meaning as described above.
X³ and X⁴ each independently represent an oxygen atom, a sulfur atom or a selenium atom.
Y³ represents a nitrogen atom or a group represented by -CR⁵=. Y⁴ represents a nitrogen atom or a group represented by -CR⁶=. R⁵ and R⁶ each independently represent a hydrogen atom, an alkyl group, a cycloalkyl group, an alkoxy group, a cycloalkoxy group, an alkylthio group, a cycloalkylthio group, an aryl group, a monovalent heterocyclic ring group or a halogen atom. Of these groups, the alkyl group, the cycloalkyl group, the alkoxy group, the cycloalkoxy group, the alkylthio group, the cycloalkylthio group, the aryl group and the monovalent heterocyclic ring group each may have a substituent.].

16. The polymer compound according to Claim 15, wherein X³ and X⁴ are a sulfur atom.

17. The polymer compound according to Claim 15 or 16, wherein Y³ and Y⁴ are a group represented by -CH=.

18. The polymer compound according to any one of Claims 14 to 17, wherein Z³ and Z⁴ are a group represented by the formula (Z-1").

19. The polymer compound according to any one of Claims 14 to 18, further comprising a structural unit represented by the formula (6) (different from the structural unit represented by the formula (4)): 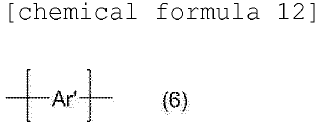 [wherein Ar' represents an arylene group or a divalent heterocyclic ring group, and these groups may have a substituent.].

20. The polymer compound according to Claim 19, wherein the polymer compound is an alternating copolymer composed of a structural unit represented by the formula (4) and a structural unit represented by the formula (6).

21. An organic semiconductor device having a first electrode and a second electrode and having an active layer between the first electrode and the second electrode, wherein the active layer contains the composition according to any one of Claims 1 to 13 or the polymer compound according to any one of Claims 14 to 20.

22. The organic semiconductor device according to Claim 21, wherein the organic semiconductor device is any one of an organic film transistor, a photoelectric conversion device, an organic electroluminescent device, an organic electric field effect transistor sensor and an organic conductivity modulation type sensor.

23. The organic semiconductor device according to Claim 22, wherein the organic semiconductor device is an organic film transistor.
